(19) **Europäisches Patentamt / European Patent Office / Office européen des brevets**

(11) **EP 1 860 451 B1**

(12) ## EUROPEAN PATENT SPECIFICATION

(45) Date of publication and mention
of the grant of the patent:
**27.06.2012 Bulletin 2012/26**

(21) Application number: **06729388.6**

(22) Date of filing: **17.03.2006**

(51) Int Cl.:
*G01R 33/09* *(2006.01)*      *H01L 43/12* *(2006.01)*

(86) International application number:
**PCT/JP2006/305399**

(87) International publication number:
**WO 2006/098431 (21.09.2006 Gazette 2006/38)**

(54) **3-AXIS MAGNETIC SENSOR AND MANUFACTURING METHOD THEREOF**

DREIACHSEN-MAGNETSENSOR UND HERSTELLUNGSVERFAHREN DAFÜR

CAPTEUR MAGNÉTIQUE À 3 AXES ET PROCÉDÉ DE FABRICATION DE CELUI-CI

(84) Designated Contracting States:
**AT BE BG CH CY CZ DE DK EE ES FI FR GB GR HU IE IS IT LI LT LU LV MC NL PL PT RO SE SI SK TR**

(30) Priority: **17.03.2005 JP 2005077010**
**28.03.2005 JP 2005090581**
**28.03.2005 JP 2005091256**
**09.02.2006 JP 2006032124**
**09.02.2006 JP 2006032125**

(43) Date of publication of application:
**28.11.2007 Bulletin 2007/48**

(73) Proprietor: **YAMAHA CORPORATION**
**Hamamatsu-shi**
**Shizuoka-ken (JP)**

(72) Inventors:
• **SATO, Hideki**
**Hamamatsu-shi, Shizuoka, 430-8650 (JP)**

• **OMURA, Masayoshi**
**Hamamatsu-shi, Shizuoka, 430-8650 (JP)**
• **NAITO, Hiroshi**
**akata, Yuusui-cho, Aira-gun, Kagoshima, (JP)**
• **OOHASHI, Toshiyuki**
**Hamamatsu-shi, Shizuoka, 430-8650 (JP)**
• **WAKUI, Yukio**
**Hamamatsu-shi, Shizuoka, 430-8650 (JP)**
• **OSUGA, Chihiro**
**Hamamatsu-shi, Shizuoka, 430-8650 (JP)**

(74) Representative: **Wagner, Karl H.**
**Wagner & Geyer Partnerschaft**
**Patent- und Rechtsanwälte**
**Gewürzmühlstrasse 5**
**80538 München (DE)**

(56) References cited:
**JP-A- 11 305 055      JP-A- 2004 006 752**
**JP-A- 2004 006 752      JP-A- 2004 012 156**
**JP-A- 2004 193 540      US-A1- 2006 176 142**

**Description**

TECHNICAL FIELD

The present invention relates to a three-axis magnetic sensor provided with an X-axis sensor to which a plurality of magnetoresistive effect elements are bridge-connected, a Y-axis sensor to which a plurality of magnetoresistive effect elements are bridge-connected and a Z-axis sensor to which a plurality of magnetoresistive effect elements are bridge-connected within one substrate, and also relates to a method for manufacturing the three-axis magnetic sensor.

BACKGROUND ART

Giant magnetoresistive elements (GMR elements), tunneling magnetoresistive elements (TMR elements) and the like are known as elements usable in a magnetic sensor. These magnetoresistive effect elements are provided with a pinned layer in which the magnetization direction is pinned (bonded) in a predetermined direction and a free layer in which the magnetization direction changes according to an external magnetic field, indicating as an output a resistance value according to the relative relationship between the magnetization direction of the pinned layer and that of the free layer. Magnetic sensors in which the above-described magnetoresistive effect elements are used have been disclosed, for example, in JP 3498737 B and JP 2002-299728 A.

In the magnetic sensors disclosed in JP 3498737 B and JP 2002-299728 A. and magnetoresistive effect elements are arranged to be orthogonal to each other in such a way that a change in magnetic fields of two orthogonal directions (X-axis direction and Y-axis direction) can be respectively detected, and bridge-connected respectively as a group of elements made up of several elements, thereby obtaining outputs of individual elements (change in resistance value) to detect an external magnetic field on a two-dimensional flat surface.

Incidentally, there is a case where in place of a two-dimensional flat surface, a spatial orientation, namely, a three-dimensional orientation is required. In this case, it is necessary to obtain the direction of magnetism in a three-dimensional manner (X-axis direction, Y-axis direction and Z-axis direction) with a high accuracy.

However, since it is impossible to fabricate a three-dimensional magnetic sensor capable of obtaining the direction in a three-dimensional manner on the same substrate, no thin-type three-dimensional magnetic sensor has so far been available.

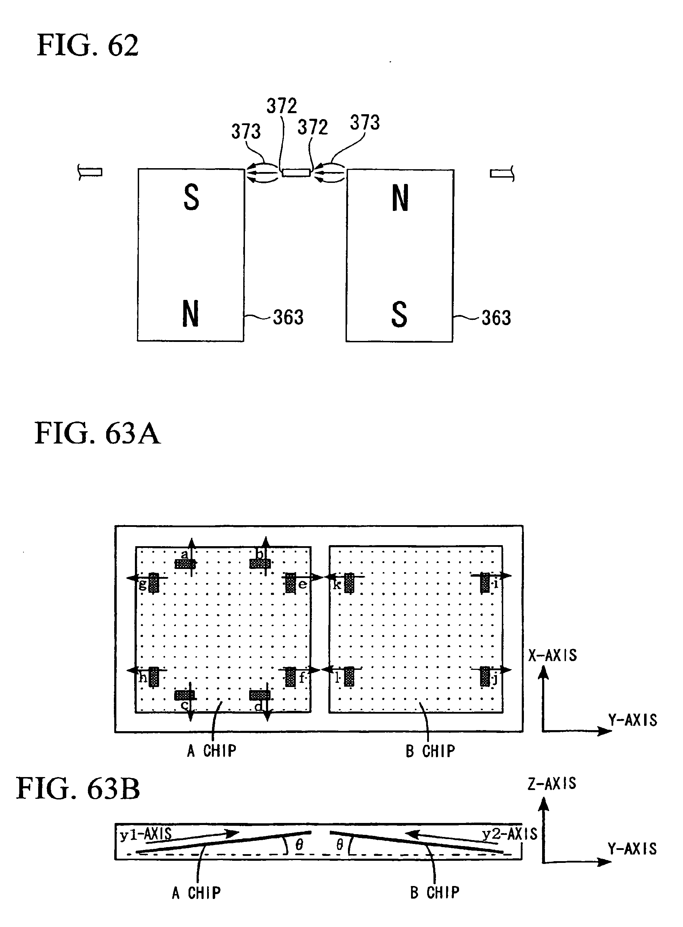

There has been, therefore, proposed a three-axis magnetic sensor (three-dimensional magnetic sensor) in which two chips are tilted and mounted. In the three-axis magnetic sensor, as given in Fig. 63A illustrating the top surface of the sensor, two chips made up of A chip and B chip which are in a square shape, when viewed from above, are mounted inside a package. Then, these two chips are, as given in Fig. 63B illustrating the side surface, arranged so as to be tilted by an angle of θ, X-axis sensors (a to d) and y1-axis sensors (e to h) are fabricated on the A chip, and y2-axis sensors (i to 1) are fabricated on the B chip. These sensors are constituted respectively with four GMR elements (a to d, e to h, and i to 1), and these GMR elements are arranged along the sides of the chips.

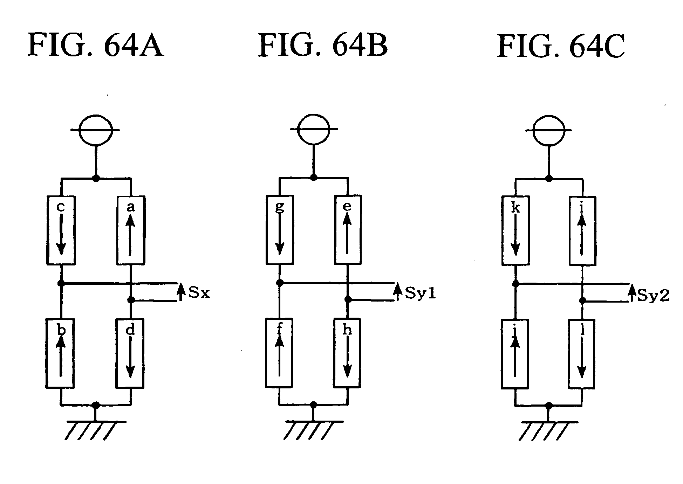

Here, as illustrated in Fig. 64A, the GMR elements, a to d, are bridge-connected to constitute the X-axis sensors. Further, as illustrated in Fig. 64B, the GMR elements, e to h, are bridge-connected to constitute the y1-axis sensors. Still further, as illustrated in Fig. 64C, the GMR elements, i to 1 are bridge-connected to constitute the y2-axis sensors. Then, the GMR elements, a to d, constituting the X-axis sensor are designed to have the sensitivity direction in the X-axis direction, the GMR elements, e to h, constituting the y1-axis sensor are designed to have the sensitivity direction in the y1-axis direction, and the GMR elements, i to 1, constituting the y2-axis sensor are designed to have the sensitivity direction in the y2-axis direction.

Thereby, when a magnetic field is applied to the GMR elements constituting each of the sensors in the direction shown by the arrows in Fig. 63A, the resistance value will decrease proportionally with the magnetic field intensity thereof. In contrast, when a magnetic field is applied in an opposite direction to that shown by the arrows in Fig. 63A, the resistance value will increase proportionally with the magnetic field intensity thereof. Here, as illustrated in Fig. 64A, Fig. 64B and Fig. 64C, each of the GMR elements is bridge-connected to constitute individual sensors. When a predetermined voltage (for example, 3V) is applied between a power source and a ground, Sx is output from the X-axis sensor, Sy1 is output from the y1-axis sensor and Sy2 is output from the y2-axis sensor.

Then, on the basis of the thus obtained outputs, Hx, a component of a magnetic field in the X-axis direction can be obtained by the following formula (1). Similarly, Hy, a component of a magnetic field in the Y-axis direction can be obtained by the following formula (2), and Hz, a component of a magnetic field in the Z-axis direction can be obtained by the following formula (3).

$$Hx = 2kx \times Sx \ ...(1)$$

$$Hy = ky \ (Sy1 - Sy2) \ /cos\theta \ ...(2)$$

$$Hz = kz \ (Sy1 + Sy2)/sin\theta \ ...(3)$$

Wherein, kx, ky and kx are constants of proportionality and the relationship of kx = ky = kz can be obtained, when each of the sensors is equal in sensitivity.

However, two chips made up of A chip and B chip must be mounted inside the package in the above-described three-axis magnetic sensor, thereby complicating the manufacture of this type of sensor and requiring additional work, which is a problem. There is another problem in that the sensor needs a special package, thereby increasing the price and making it difficult to attain miniaturization.

On the other hand, the applicant of the present invention has already proposed a magnetic sensor in JP 2004-006752A in which three or more magnetoresistive elements are arranged on one sheet of a substrate and the magnitude of a magnetic field in a triaxial direction can be determined.
JP 2004-006752 A was used as a basis for the preamble of the independent claims.

DISCLOSURE OF INVENTION

In the above-described prior invention, a groove is formed on a silicon substrate, magnetoresistive elements for detecting the Z-axis are arranged on a tilted surface of the groove, and magnetoresistive elements for detecting the X-axis and magnetoresistive elements for detecting the Y-axis are arranged on a flat surface of the substrate, thereby making it possible to miniaturize the sensor. However, since a plurality of magnetoresistive elements must be arranged and bridge-connected, it is more likely to develop an offset. Further, when Z-axis sensors are only given the same film constitution and a similar treatment of regularization by using conventional permanent magnet pieces, it is impossible to provide Z-axis sensors having desired characteristics, which is a problem.

Then, the present invention has been made for solving the above problems, and an object thereof is to provide a three-axis magnetic sensor with such a constitution as to be simply and easily fabricated on one chip (one substrate).

In order to attain the above object, the present invention provides a three-axis magnetic sensor as set forth in claim 1 and a method for manufacturing a three-axis magnetic sensor as set forth in claim 10. Preferred embodiments of the present invention may be gathered from the dependent claims.
The present disclosure also includes a three-axis magnetic sensor of a first aspect provided with a plurality of magnetoresistive effect elements in which the sensitivity directions intersect with each other inside one substrate, wherein at least one of the magnetoresistive effect elements is formed on a flat surface of the substrate, with the magnetization direction of a pinned layer being inside the flat surface, and at least another magnetoresistive effect element is formed on a tilted surface of the substrate, with the magnetization direction of the pinned layer being inside the surface along the tilted surface.

The three-axis magnetic sensor of the first aspect conducts heat treatment for regularization by utilizing a magnetic field different in direction among magnetic fields generated by the same permanent magnet pieces (group). Therefore, a magnetoresistive effect element having the same constitution at a different position on one substrate or a magnetoresistive effect element having the same constitution formed on a different surface on one substrate can be made identical in sensitivity to prevent variance in sensitivity resulting from angle variation, which is unavoidable in an assembly process.

Further, the present disclosure also includes a three-axis magnetic sensor of a second aspect provided inside one substrate with an X-axis sensor in which a plurality of magnetoresistive effect elements are bridge-connected, a Y-axis sensor in which a plurality of magnetoresistive effect elements are bridge-connected and a Z-axis sensor in which a plurality of magnetoresistive effect elements are bridge-connected. Then, the magnetoresistive effect elements are formed by using one magnetoresistive effect element bar or a plurality of magnetoresistive effect element bars connected in series, magnetoresistive effect elements of the X-axis sensor and those of the Y-axis sensor are formed on a flat surface parallel to the flat surface of the substrate, the sensitivity direction of magnetization is a direction vertical to the longitudinal direction of each of the magnetoresistive effect element bars, magnetoresistive effect elements of the X-axis sensor and those of the Y-axis sensor are formed in such a way that the magnetization directions are orthogonal to each other, magnetoresistive effect elements of the Z-axis sensor are formed on a tilted surface provided on the substrate in such a way that the magnetization direction is inside the tilted surface, and the sensitivity direction of magnetization is formed so as to intersect with the longitudinal direction of the magnetoresistive effect element bar concerned.

Thereby, since magnetoresistive effect elements of the X-axis sensor, the Y-axis sensor and the Z-axis sensor are formed in such a way that the magnetization directions intersect each other in a three-dimensional direction, it is possible to accurately determine three-dimensional magnetic fields of the X-axis, Y-axis and Z-axis. Then, the X-axis sensor, the Y-axis sensor and the Z-axis sensor are provided inside one substrate, thereby preventing generation of an angle variation which is found in a magnetic sensor formed by assembling a plurality of sensors on different substrates and also preventing these sensors from being larger in dimension so as to provide a small-sized three-axis magnetic sensor. Here, the Z-axis sensor is only formed on a tilted surface of each projection so as to project from the flat surface of the substrate, thereby making it possible to fabricate simply and easily the Z-axis sensor inside one substrate.

Here, if a magnetoresistive effect element is provided with a plurality of magnetoresistive effect element bars arranged in parallel and adjacent magnetoresistive effect element bars are connected in series by bias magnet films, a bias magnetic field can be easily imparted to a free layer of each of the magnetoresistive effect element bars, which are to be described later.

Here, if each of the magnetoresistive effect element bars constituting magnetoresistive effect elements of the Z-axis sensor is formed on a tilted surface formed so as to relatively face at the same angle to the Z-axis vertical to a flat surface of a substrate, the longitudinal direction of the magnetoresistive effect element bar concerned is made coincident with either the direction of the long side (X-axis) of the substrate or the direction of the short side (Y-axis). At the same time, magnetoresistive effect elements constituted with magnetoresistive effect element bars individually formed on each of the tilted surfaces are adjacent to each other and arranged in parallel, an X-axis component and a Y-axis component, which are sensitive to a magnetic field, are cancelled inside each of the magnetoresistive effect elements, thereby allowing only a Z-axis component, which is sensitive to a magnetic field, to appear.

Further, each of the magnetoresistive effect element bars constituting magnetoresistive effect elements of the Z-axis sensor is formed on a tilted surface formed so as to relatively face to the Z-axis vertical to a flat surface of a substrate, the longitudinal direction of the magnetoresistive effect element bar concerned is made coincident with either the direction of the long side (X-axis) of the substrate or the direction of the short side (Y-axis). At the same time, magnetoresistive effect elements constituted with magnetoresistive effect element bars individually formed on each of the tilted surfaces are adjacent to each other and arranged in parallel to attain a full bridge-connection, an X-axis component and a Y-axis component, which are sensitive to a magnetic field, are cancelled, thereby allowing only a Z-axis component, which is sensitive to a magnetic field, to appear.

In the above-constituted three-axis magnetic sensor of the second aspect, it is preferable in miniaturizing the sensor that a substrate be formed in a rectangular shape, when viewed from above, and the aspect ratio be either 1 : 2 or 1 : 1.5. Here, if two magnetoresistive effect elements constituted with magnetoresistive effect element bars are adjacent to each other and arranged in parallel and also these two magnetoresistive effect elements are full-bridge-connected to two non-magnetic resistors formed at a position which is point-symmetrical from the center of the substrate, when viewed from above, the sensor can be made smaller.

The above-described three-axis magnetic sensor of the second aspect may be manufactured in a step of forming magnetoresistive effect elements in which a plurality of magnetoresistive effect elements that will act as X-axis sensors, a plurality of magnetoresistive effect elements that will act as Y-axis sensors and a plurality of magnetoresistive effect elements that will act as Z-axis sensors are formed on a substrate and a step of heat treating for regularization in which heating is conducted, while a magnetic field is imparted to each of the magnetoresistive effect elements formed on the substrate, thereby simultaneously subjecting each of the magnetoresistive effect elements to the heat treatment for regularization. Here, in the step of heat treating for regularization, it is preferable that the heat treatment for regularization be conducted by heating, while a magnetic field be imparted at 45 degrees from a direction vertical to a tilted surface on which is formed each of the magnetoresistive effect element bars constituting a plurality of magnetoresistive effect elements which will act as Z-axis sensors.

Further, the present disclosure also includes a three-axis magnetic sensor of a third aspect provided inside one substrate with an X-axis sensor to which a plurality of giant magnetoresistive effect elements are bridge-connected, a Y-axis sensor to which a plurality of giant magnetoresistive effect elements are bridge-connected and a Z-axis sensor to which a plurality of giant magnetoresistive effect elements are bridge-connected. Then, the giant magnetoresistive effect element is formed with at least one giant magnetoresistive effect element bar, giant magnetoresistive effect elements of the X-axis sensor are formed on a flat surface parallel to the surface of a substrate, the longitudinal direction of the giant magnetoresistive effect element bars is in the Y-axis direction, the magnetization direction of a pinned layer of the giant magnetoresistive effect element bar concerned is at a predetermined angle (preferably 45 degrees) with respect to the X-axis, the sensitivity direction is a direction vertical to the longitudinal direction of the giant magnetoresistive effect element bar concerned, giant magnetoresistive effect elements of the Y-axis sensor are formed on a flat surface parallel to the surface of the substrate, the longitudinal direction of the giant magnetoresistive effect element bars is in the X-axis direction, the magnetization direction of the pinned layer of the giant magnetoresistive effect element bar concerned is at a predetermined angle (preferably 45 degrees) with respect to the Y-axis, the sensitivity direction thereof is a direction vertical to the longitudinal direction of each of the giant magnetoresistive effect element bars, giant magnetoresistive effect elements of the Z-axis sensor are formed on a tilted surface provided on the substrate, so that the magnetization direction is formed so as to be inside the tilted surface, and the sensitivity direction is formed so as to intersect with the longitudinal direction of the giant magnetoresistive effect element bar concerned.

Thereby, since giant magnetoresistive effect elements of an X-axis sensor, a Y-axis sensor and a Z-axis sensor are formed in such a way that the magnetization directions intersect each other in a three-dimensional direction, it is possible to accurately determine three-dimensional magnetic fields of the X-axis, the Y-axis and the Z-axis. Then, the X-axis sensor, the Y-axis sensor and the Z-axis sensor are provided inside one substrate, thereby preventing generation of the angle variation which is found in a magnetic sensor formed by assembling a plurality of different sensors and also preventing these sensors from being larger in dimension so as to provide a small-sized three-axis magnetic sensor. Here, the Z-axis sensor is only formed on a tilted surface provided on the substrate, thereby making it possible to fabricate simply and easily the Z-axis sensor inside one substrate. Here, if the giant magnetoresistive effect element is provided with a plurality of giant magnetoresistive effect element bars arranged in parallel and adjacent giant magnetoresistive effect element bars connected in series by bias magnet films, a bias magnetic field can be easily imparted to a free layer of each of the giant magnetoresistive effect element bars to be described later.

Here, each of the giant magnetoresistive effect element bars constituting giant magnetoresistive effect elements of the Z-axis sensor is formed on a tilted surface formed so as to relatively face at the same angle to the Z-axis vertical to a flat surface of the substrate. If the longitudinal direction of the giant magnetoresistive effect element bar concerned is at 45 degrees with respect to the X-axis or the Y-axis direction of the substrate and giant magnetoresistive effect elements constituted with giant magnetoresistive effect element bars individually formed on each of the tilted surfaces are adjacent to each other and arranged in parallel, an X-axis component and a Y-axis component, which are sensitive to a magnetic field, are cancelled inside each of the giant magnetoresistive effect elements, thereby allowing only the Z-axis component, which is sensitive to a magnetic field, to appear. In the above-constituted three-axis magnetic sensor, it is preferable in miniaturizing the sensor that the substrate be formed in a rectangular shape, when viewed from above, and the aspect ratio be either 1 : 2 or 1 : 1.5 or a square shape.

The above-described three-axis magnetic sensor of the third aspect may be manufactured in a step of forming giant magnetoresistive effect elements in which a plurality of giant magnetoresistive effect elements that will act as X-axis sensors, a plurality of giant magnetoresistive effect elements that will act as Y-axis sensors and a plurality of giant magnetoresistive effect elements that will act as Z-axis sensors are formed on a substrate and in a step of heat treating for regularization in which heating is conducted, while a magnetic field mutually different in direction is imparted to two magnetoresistive effect elements among a bridge-connected group of magnetoresistive effect elements formed on the substrate, thereby simultaneously subjecting each of the magnetoresistive effect elements to the heat treatment for regularization. Here, it is preferable in the step of heat treating for regularization that a bar magnet array in which a plurality of bar magnets are arranged in parallel so as to be alternately different in polarity of bar magnets adjacent on the substrate having individual giant magnetoresistive effect elements be arranged in such a way that the bar magnets are placed to give an angle of 45 degrees with respect to the substrate concerned, and then heating be conducted to realize the heat treatment for regularization.

Further, the present disclosure also includes a three-axis magnetic sensor of a fourth aspect provided inside one substrate with an X-axis sensor to which a plurality of giant magnetoresistive effect elements are bridge-connected, a Y1-axis sensor to which a plurality of giant magnetoresistive effect elements are bridge-connected and a Y2-axis sensor to which a plurality of giant magnetoresistive effect elements are bridge-connected. Then, the giant magnetoresistive effect element is constituted with a plurality of giant magnetoresistive effect element bars connected in series, giant magnetoresistive effect elements of the X-axis sensor are formed on a flat surface parallel to the surface of a substrate, the magnetization direction and the sensitivity direction of a pinned layer are formed so as to be vertical to the longitudinal direction of each of the giant magnetoresistive effect element bars, the Y1-axis sensor is formed on a first tilted surface which is tilted by a predetermined angle with respect to the flat surface of the substrate, the magnetization direction and the sensitivity direction are of the pinned layer formed so as to be vertical to the longitudinal direction of each of the giant magnetoresistive effect element bars and along the first tilted surface, the Y2-axis sensor is formed on a second tilted surface tilted at the same angle with the first tilted surface and in the direction opposite the first tilted surface, and the magnetization direction of the pinned layer and the sensitivity direction are formed so as to be vertical to the longitudinal direction of each of the giant magnetoresistive effect element bars and along the second tilted surface.

Since giant magnetoresistive effect elements of an X-axis sensor, a Y1-axis sensor and a Y2-axis sensor are formed in such a way that the sensitivity directions intersect with each other in a three-dimensional direction, it is possible to accurately determine the three-dimensional magnetic fields of the X-axis, the Y-axis and the Z-axis. Then, the X-axis sensor, the Y1-axis sensor and the Y2-axis sensor are provided inside one substrate, thereby preventing generation of an angle variation, which is found in a magnetic sensor formed by assembling individual sensors and also preventing these sensors from being larger in dimension to provide a small-sized three-axis magnetic sensor. Here, the Y1-axis sensor and the Y2-axis sensor are only formed on a tilted surface provided on a substrate, thereby making it possible to fabricate simply and easily the Y1-axis sensor and the Y2-axis sensor inside one substrate.

Here, if the giant magnetoresistive effect element is provided with a plurality of giant magnetoresistive effect element bars arranged in parallel and adjacent giant magnetoresistive effect element bars connected in series by bias magnet films, a bias magnetic field can be easily imparted to a free layer of each of the giant magnetoresistive effect element bars to be described later. It is preferable that the first tilted surface and the second tilted surface be formed, back to back, on a projection provided on a substrate. Alternatively, it is preferable that a first tilted surface and a second tilted surface be formed at a groove provided on the substrate so as to relatively face . Further, the first tilted surface may be formed by a first projection or a groove, and the second tilted surface may be formed by a second projection or a groove different from the first projection or the groove.

The above-described three-axis magnetic sensor of the fourth aspect may be manufactured in a step of forming giant magnetoresistive effect elements in which a plurality of giant magnetoresistive effect elements that will act as X-axis sensors, a plurality of giant magnetoresistive effect elements that will act as Y1-axis sensors and a plurality of giant magnetoresistive effect elements that will act as Y2-axis sensors are formed on a substrate and a step of heat treating for regularization in which heating is conducted, while a magnetic field is imparted to each of the giant magnetoresistive effect elements formed on a substrate, thereby simultaneously subjecting each of the giant magnetoresistive effect elements to heat treatment for regularization.

Still further, in order to solve the above-described problem, the present disclosure provides a magnetic sensor of a fifth aspect and a method for manufacturing the magnetic sensor, which are as follows.

More specifically, a magnetic sensor of the fifth aspect is provided in which magnetoresistive effect elements of X, Y and Z axes are respectively formed at least in one pair on a substrate, and the magnetoresistive effect elements of the X, Y and Z axes are formed in such a way that the magnetization directions intersect with each other in a three-dimensional direction, in which the magnetoresistive effect elements of the X-axis and the Y-axis are formed at four sides of a cell of a substrate, and the magnetoresistive effect elements of the Z-axis are formed at four corners of the cell. A magnetized state in the magnetoresistive effect elements of the Z-axis is similar to that of in the magnetoresistive effect elements of the X-axis and the Y-axis.

In the magnetic sensor of the fifth aspect, the magnetoresistive effect elements of the X-axis and the Y-axis are formed at four sides of the cell of the substrate, the magnetoresistive effect elements of the Z-axis are formed at four corners of the cell, a magnetized state in the magnetoresistive effect elements of the Z-axis is made similar to that of in the magnetoresistive effect elements of the X-axis and the Y-axis, thereby making it possible to equalize the sensitivity of each of the magnetoresistive effect element bars in the magnetoresistive effect elements of the X-axis and the Y-axis with the sensitivity of the magnetoresistive effect element of the Z-axis and also to determine at high accuracy the direction of a magnetic field in the three-dimensional directions (X-axis direction, Y-axis direction and Z-axis direction).

In the magnetic sensor of the fifth aspect, one pair or plural pairs of tilted surfaces are formed at the four corners so as to be parallel in the travel direction, one pair or plural pairs of grooves are formed in parallel on one pair or plural pairs of the tilted surfaces concerned, and the magnetoresistive effect elements of the Z-axis are formed on inner surfaces of one pair or plural pairs of the grooves.

In the above magnetic sensor, the sensitivity direction of magnetoresistive effect elements of the X-axis and the Y-axis is toward the substrate surface inside, and the sensitivity direction of magnetoresistive effect elements of the Z-axis is in a direction intersecting with the substrate surface.

The magnetic sensor of the fifth aspect is manufactured by a method for manufacturing a magnetic sensor in which magnetoresistive effect elements of X, Y and Z axes are respectively formed at least in one pair on a substrate, and the magnetoresistive effect elements of the X, Y and Z axes are formed in such a way that the magnetization directions intersect with each other in a three-dimensional direction, the method including a step of forming magnetoresistive effect elements of the X-axis and the Y-axis and a permanent magnet film connected thereto at four sides of a cell of a substrate and forming magnetoresistive effect elements of the Z-axis and a permanent magnet film connected thereto at four corners of the cell, a step of magnetizing the permanent magnet film connected to the magnetoresistive effect elements of the Z-axis by using a magnet array having a plurality of permanent magnet pieces arranged so as to be different in polarity for each of the adjacent permanent magnet pieces to align the four corners of the cell of the substrate with the adjacent permanent magnet pieces of the magnet array, and a step of magnetizing the permanent magnet film connected to the magnetoresistive effect elements of the X-axis and the Y-axis by moving the substrate to align the substrate with the permanent magnet pieces of the magnet array.

In the method for manufacturing the magnetic sensor, after the step of magnetizing the permanent magnet film connected to the magnetoresistive effect elements of the Z-axis by using a magnet array having a plurality of permanent magnet pieces arranged so as to be different in polarity for each of the adjacent permanent magnet pieces to align the four corners of the cell of the substrate with the adjacent permanent magnet pieces of the magnet array, the step of magnetizing the permanent magnet film connected to the magnetoresistive effect elements of the X-axis and the Y-axis by moving the substrate to align the substrate with the permanent magnet pieces of the magnet array is conducted, thereby the magnetoresistive effect elements of the Z-axis will not undergo any change in the polarization state even in magnetizing the magnetoresistive effect elements of the X-axis and the Y-axis. Thereby, there will be no difference in sensitivity between the magnetoresistive effect elements of the X-axis and the Y-axis and the magnetoresistive effect elements of the Z-axis, providing easily and inexpensively a magnetic sensor capable of accurately determining the direction of a magnetic field in three-dimensional directions (X-axis direction, Y-axis direction and Z-axis direction).

In the method for manufacturing the magnetic sensor of the fifth aspect, a soft magnetic plate having a slit at a position between the adjacent permanent magnet pieces may be used in a step for magnetizing a layer including individual pinned layers of the magnetoresistive effect elements of the X-axis and the Y-axis.

Further, in the method for manufacturing the magnetic sensor of the fifth aspect, a soft magnetic plate having slits in the vicinity of four sides of a permanent magnet piece may be used in a step for magnetizing layers including the respective pinned layers of the magnetoresistive effect elements of the X-axis and the Y-axis.

Still further, in the method for manufacturing the magnetic sensor of the fifth aspect, the magnetoresistive effect elements of the Z-axis are formed on one or plural pairs of tilted surfaces mutually parallel in the travel direction, the magnetoresistive effect elements of the Z-axis may be magnetized by a magnetic field intersecting with the substrate of the permanent magnet pieces, and the magnetoresistive effect elements of the X-axis and the Y-axis may be magnetized by using a magnetic field parallel to the substrate of the permanent magnet piece.

BRIEF DESCRIPTION OF THE DRAWINGS

Fig. 1A is a plan view schematically illustrating a three-axis magnetic sensor of a first embodiment in the present invention;

Fig. 1B is a sectional view taken along line A-A in Fig. 1A schematically illustrating the three-axis magnetic sensor of the first embodiment in the present invention;

Fig. 2A is a plan view schematically illustrating a brief constitution of the magnetoresistive effect element used in the three-axis magnetic sensor of the present invention and a state in which a plurality of magnetoresistive effect element (GMR) bars are connected to constitute one magnetoresistive effect element;

Fig. 2B is a sectional view schematically illustrating a brief constitution of the magnetoresistive effect element used in the three-axis magnetic sensor of the present invention and a cross section taken along line A-A in Fig. 2A;

Fig. 2C is a view schematically illustrating a brief constitution of the magnetoresistive effect element used in the three-axis magnetic sensor of the present invention and an inner lamination state given in Fig. 2B;

Fig. 3A is a view schematically illustrating the pinning direction and the sensitivity direction of the three-axis magnetic sensor in the first embodiment given in Fig. 1A and also a plan view schematically illustrating an entire flat surface;

Fig. 3B is a view schematically illustrating the pinning direction and the sensitivity direction of the three-axis magnetic sensor in the first embodiment given in Fig. 1A and also a perspective view schematically illustrating an enlarged A part in Fig. 3A;

Fig. 3C is a view schematically illustrating the pinning direction and the sensitivity direction of the three-axis magnetic sensor of the first embodiment given in Fig. 1A and a perspective view schematically illustrating an enlarged B part in Fig. 3 A;

Fig. 4A is a block diagram illustrating a bridge connection in the first embodiment and a block diagram illustrating the bridge connection of the X-axis sensor;

Fig. 4B is a block diagram illustrating the bridge connection of the first embodiment and a block diagram illustrating the bridge connection of the Y-axis sensor;

Fig. 4C is a block diagram illustrating the bridge connection of the first embodiment and a block diagram illustrating the bridge connection of the Z-axis sensor;

Fig. 5A is a sectional view schematically illustrating a process of manufacturing a via portion of the three-axis magnetic sensor of the embodiment in the present invention;

Fig. 5B is a sectional view schematically illustrating a process of manufacturing a pad portion of the three-axis magnetic sensor of the embodiment in the present invention;

Fig. 5C is a sectional view schematically illustrating a process of manufacturing a GMR portion of the three-axis magnetic sensor in the present invention;

Fig. 6A is a sectional view schematically illustrating a process of manufacturing a via portion of the three-axis magnetic sensor of the embodiment in the present invention;

Fig. 6B is a sectional view schematically illustrating a process of manufacturing a pad portion of the three-axis magnetic sensor of the embodiment in the present invention;

Fig. 6C is a sectional view schematically illustrating a process of manufacturing a GMR portion of the three-axis magnetic sensor of the embodiment in the present invention;

Fig. 7A is a sectional view schematically illustrating a process of manufacturing a via portion of the three-axis magnetic sensor of the embodiment in the present invention;

Fig. 7B is a sectional view schematically illustrating a process of manufacturing a pad portion of the three-axis magnetic sensor of the embodiment in the present invention;

Fig. 7C is a sectional view schematically illustrating a process of manufacturing a GMR portion of the three-axis magnetic sensor of the embodiment in the present invention;

Fig. 8A is a sectional view schematically illustrating a process of manufacturing a via portion of the three-axis magnetic sensor of the embodiment in the present invention;

Fig. 8B is a sectional view schematically illustrating a process of manufacturing a pad portion of the three-axis magnetic sensor of the embodiment in the present invention;

Fig. 8C is a sectional view schematically illustrating a process of manufacturing a GMR portion of the three-axis magnetic sensor of the embodiment in the present invention;

Fig. 9A is a sectional view schematically illustrating a process of manufacturing a via portion of the three-axis magnetic sensor of the embodiment in the present invention;

Fig. 9B is a sectional view schematically illustrating a process of manufacturing a pad portion of the three-axis magnetic sensor of the embodiment in the present invention;

Fig. 9C is a sectional view schematically illustrating a process of manufacturing a GMR portion of the three-axis magnetic sensor of the embodiment in the present invention;

Fig. 10A is a sectional view schematically illustrating a process of manufacturing a via portion of the three-axis magnetic sensor of the embodiment in the present invention;

Fig. 10B is a sectional view schematically illustrating a process of manufacturing a pad portion of the three-axis magnetic sensor of the embodiment in the present invention;

Fig. 10C is a sectional view schematically illustrating a process of manufacturing a GMR portion of the three-axis magnetic sensor of the embodiment in the present invention;

Fig. 11A is a sectional view schematically illustrating a process of manufacturing a via portion of the three-axis magnetic sensor of the embodiment in the present invention;

Fig. 11B is a sectional view schematically illustrating a process of manufacturing a pad portion of the three-axis magnetic sensor of the embodiment in the present invention;

Fig. 11C is a sectional view schematically illustrating a process of manufacturing a GMR portion of the three-axis magnetic sensor of the embodiment in the present invention;

Fig. 12A is a sectional view schematically illustrating a process of manufacturing a via portion of the three-axis magnetic sensor of the embodiment in the present invention;

Fig. 12B is a sectional view schematically illustrating a process of manufacturing a pad portion of the three-axis magnetic sensor of the embodiment in the present invention;

Fig. 12C is a sectional view schematically illustrating a process of manufacturing a GMR portion of the three-axis magnetic sensor of the embodiment in the present invention;

Fig. 13A is a sectional view schematically illustrating a process of manufacturing a via portion of the three-axis magnetic sensor of the embodiment in the present invention;

Fig. 13B is a sectional view schematically illustrating a process of manufacturing a pad portion of the three-axis magnetic sensor of the embodiment in the present invention;

Fig. 13C is a sectional view schematically illustrating a process of manufacturing a GMR portion of the three-axis magnetic sensor of the embodiment in the present invention;

Fig. 14A is a sectional view schematically illustrating a process of manufacturing a via portion of the three-axis magnetic sensor of the embodiment in the present invention;

Fig. 14B is a sectional view schematically illustrating a process of manufacturing a pad portion of the three-axis magnetic sensor of the embodiment in the present invention;

Fig. 14C is a sectional view schematically illustrating a process of manufacturing a GMR portion of the three-axis magnetic sensor of the embodiment in the present invention;

Fig. 15A is a plan view schematically illustrating a state of the heat treatment for regularization (pinning treatment) in the first embodiment of the present invention;

Fig. 15B is a sectional view schematically illustrating a state of the heat treatment for regularization (pinning treatment) in the first embodiment of the present invention and a cross section taken along A-A in Fig. 15A;

Fig. 15C is a sectional view schematically illustrating a state of the heat treatment for regularization (pinning treatment) in the first embodiment of the present invention and a cross section taken along B-B in Fig. 15A;

Fig. 16A is a schematic constitution view schematically illustrating a first exemplified variation of the three-axis magnetic sensor of the first embodiment in the present invention;

Fig. 16B is a schematic constitution view schematically illustrating a second exemplified variation of the three-axis magnetic sensor of the first embodiment in the present invention;

Fig. 16C is a schematic constitution view schematically illustrating a third exemplified variation of the three-axis magnetic sensor of the first embodiment in the present invention;

Fig. 16D is a schematic constitution view schematically illustrating a fourth exemplified variation of the three-axis magnetic sensor of the first embodiment in the present invention;

Fig. 17A is a plan view illustrating the three-axis magnetic sensor of a second embodiment in the present invention;

Fig. 17B is a sectional view illustrating the three-axis magnetic sensor of the second embodiment in the present invention and a cross section taken along line A-A in Fig. 17A;

Fig. 18A is a plan view schematically illustrating the pinning direction and the sensitivity direction of the three-axis magnetic sensor of the second embodiment given in Fig. 17A and an entire flat surface.

Fig. 18B is a perspective view schematically illustrating the pinning direction and the sensitivity direction of the three-axis magnetic sensor of the second embodiment given in Fig. 17A and an enlarged A part in Fig. 18A;

Fig. 18C is a perspective view schematically illustrating the pinning direction and the sensitivity direction of the three-axis magnetic sensor of the second embodiment given in Fig. 17A and an enlarged B part in Fig. 18A;

Fig. 19A is a block diagram illustrating a bridge connection of the X-axis sensor of the second embodiment in the present invention;

Fig. 19B is a block diagram illustrating a bridge connection of the Y-axis sensor of the second embodiment in the present invention;

Fig. 19C is a block diagram illustrating a bridge connection of the Z-axis sensor of the second embodiment in the present invention;

Fig. 20A is a plan view schematically illustrating a state of the heat treatment for regularization (pinning treatment) in the second embodiment of the present invention;

Fig. 20B is a sectional view schematically illustrating a state of the heat treatment for regularization (pinning treatment) in the second embodiment of the present invention and a cross section taken along line A-A in Fig. 20A;

Fig. 20C is a sectional view schematically illustrating a state of the heat treatment for regularization (pinning treatment) in the second embodiment of the present invention and a cross section taken along line B-B in Fig. 20A;

Fig. 21A is a plan view illustrating a three-axis magnetic sensor of a third embodiment in the present invention;

Fig. 21B is a sectional view illustrating the three-axis magnetic sensor of the third embodiment in the present invention and a cross section taken along line A-A in Fig. 21A;

Fig. 22A is a plan view schematically illustrating the pinning direction and the sensitivity direction of the three-axis magnetic sensor of the third embodiment given in Fig. 21A and an entire flat surface;

Fig. 22B is a perspective view schematically illustrating the pinning direction and the sensitivity direction of the three-axis magnetic sensor of the third embodiment given in Fig. 21A and the enlarged A part in Fig. 22A;

Fig. 23A is a block diagram illustrating a bridge connection of the X-axis sensor of the third embodiment;

Fig. 23B is a block diagram illustrating a bridge connection of the Y-axis sensor of the third embodiment;

Fig. 23C is a block diagram illustrating a bridge connection of the Z-axis sensor of the third embodiment;

Fig. 24A is a plan view schematically illustrating a state of the heat treatment for regularization (pinning treatment) of the third embodiment;

Fig. 24B is a sectional view schematically illustrating a state of the heat treatment for regularization (pinning treatment) in the third embodiment and a cross section taken along line A-A in Fig. 24A;

Fig. 25 is a plan view illustrating a three-axis magnetic sensor of a fourth embodiment in the present invention;

Fig. 26A is a plan view schematically illustrating a three-axis magnetic sensor of a fifth embodiment in the present invention;

Fig. 26B is a sectional view schematically illustrating the three-axis magnetic sensor of the fifth embodiment in the present invention and a cross section taken along line A-A in Fig. 26A;

Fig. 27A is a view schematically illustrating a brief constitution of the giant magnetoresistive effect element used in the three-axis magnetic sensor of the fifth embodiment in the present invention and a plan view illustrating that a plurality of giant magnetoresistive effect element(GMR) bars are connected to form one giant magnetoresistive effect element;

Fig. 27B is a view schematically illustrating a brief constitution of the giant magnetoresistive effect element used in the three-axis magnetic sensor of the fifth embodiment in the present invention and a sectional view schematically illustrating a cross section taken along line B-B' in Fig. 27A;

Fig. 27C is a view schematically illustrating a brief constitution of the giant magnetoresistive effect element used in the three-axis magnetic sensor of the fifth embodiment in the present invention and a view schematically illustrating an inner lamination state in Fig. 27B;

Fig. 28A is a view schematically illustrating the pinning direction and the sensitivity direction of the three-axis magnetic sensor given in Fig. 26A and a plan view schematically illustrating an entire flat surface;

Fig. 28B is a view schematically illustrating the pinning direction and the sensitivity direction of the three-axis magnetic sensor given in Fig. 26A and a perspective view schematically illustrating an enlarged C part in Fig. 28A;

Fig. 28C is a view schematically illustrating the pinning direction and the sensitivity direction of the three-axis magnetic sensor given in Fig. 26A and a perspective view schematically illustrating an enlarged D part in Fig. 28A;

Fig. 29A is a block diagram illustrating a bridge connection of the X-axis sensor in the three-axis magnetic sensor of the fifth embodiment;

Fig. 29B is a block diagram illustrating a bridge connection of the Y-axis sensor in the three-axis magnetic sensor of the fifth embodiment;

Fig. 29C is a block diagram illustrating a bridge connection of the Z-axis sensor in the three-axis magnetic sensor of the fifth embodiment;

Fig. 30A is a view illustrating the heat treatment for regularization (pinning treatment) in the three-axis magnetic sensor of the fifth embodiment and a perspective view schematically illustrating a bar magnet array used in the heat treatment for regularization (pinning treatment);

Fig. 30B is a view illustrating the heat treatment for regularization (pinning treatment) in the three-axis magnetic sensor of the fifth embodiment and a plan view schematically illustrating a state of the heat treatment for regularization (pinning treatment);

Fig. 31A is a plan view illustrating a three-axis magnetic sensor of a sixth embodiment in the present invention;

Fig. 31B is a sectional view illustrating the three-axis magnetic sensor of the sixth embodiment in the present invention and a cross section taken along line E-E' in Fig. 31A;

Fig. 32A is a view schematically illustrating the pinning direction and the sensitivity direction of the three-axis magnetic sensor of the sixth embodiment in Fig. 31A and a plan view schematically illustrating an entire flat surface;

Fig. 32B is a view schematically illustrating the pinning direction and the sensitivity direction of the three-axis magnetic sensor of the sixth embodiment in Fig. 31A and a perspective view schematically illustrating an enlarged F part in Fig. 32A;

Fig. 32C is a view schematically illustrating the pinning direction and the sensitivity direction of the three-axis magnetic sensor of the sixth embodiment in Fig. 31A and a perspective view schematically illustrating an enlarged G part in Fig. 32A;

Fig. 33A is a block diagram illustrating a bridge connection of the X-axis sensor in the three-axis magnetic sensor of the sixth embodiment;

Fig. 33B is a block diagram illustrating a bridge connection of the Y-axis sensor in the three-axis magnetic sensor of the sixth embodiment;

Fig. 33C is a block diagram illustrating a bridge connection of the Z-axis sensor in the three-axis magnetic sensor of the sixth embodiment;

Fig. 34A is a view illustrating the heat treatment for regularization (pinning treatment) in the three-axis magnetic sensor of the sixth embodiment and a perspective view schematically illustrating a bar magnet array used in the heat treatment for regularization (pinning treatment);

Fig. 34B is a view illustrating the heat treatment for regularization (pinning treatment) in the three-axis magnetic sensor of the sixth embodiment and a plan view schematically illustrating a state of the heat treatment for regularization (pinning treatment);

Fig. 35A is a plan view illustrating the three-axis magnetic sensor of a seventh embodiment in the present invention;

Fig. 35B is a sectional view schematically illustrating the three-axis magnetic sensor of the seventh embodiment in the present invention and a cross section taken along line A-A' in Fig. 35A;

Fig. 36A is a view schematically illustrating a brief constitution of the giant magnetoresistive effect element used in the three-axis magnetic sensor of the seventh embodiment in the present invention and a plan view illustrating that a plurality of giant magnetoresistive effect element (GMR) bars are connected to form giant magnetoresistive effect elements for one X-axis sensor;

Fig. 36B is a view schematically illustrating a brief constitution of the giant magnetoresistive effect element used in the three-axis magnetic sensor of the seventh embodiment in the present invention and a sectional view illustrating a cross section taken along line A-B' in Fig. 36A;

Fig. 36C is a view schematically illustrating a brief constitution of the giant magnetoresistive effect element used in the three-axis magnetic sensor of a seventh embodiment in the present invention and a view schematically illustrating an inner lamination state in Fig. 36B;

Fig. 37A is a plan view illustrating a state in which a plurality of giant magnetoresistive effect element (GMR) bars of the seventh embodiment in the present invention are connected to form giant magnetoresistive effect elements for one Y1-axis sensor and giant magnetoresistive effect elements for one Y2-axis sensor;

Fig. 37B is a perspective view schematically illustrating a state of the C part in Fig. 37A when viewed obliquely from above;

Fig. 38A is a view schematically illustrating the pinning direction and the sensitivity direction of the three-axis magnetic sensor given in Fig. 35A and a plan view schematically illustrating an entire flat surface;

Fig. 38B is a view schematically illustrating the pinning direction and the sensitivity direction of the three-axis magnetic sensor given in Fig. 35A and a perspective view schematically illustrating an enlarged D part in Fig. 38A;

Fig. 38C is a view schematically illustrating the pinning direction and the sensitivity direction of the three-axis magnetic sensor given in Fig. 35A and a perspective view schematically illustrating an enlarged E part in Fig. 38A;

Fig. 39A is a block diagram illustrating a bridge connection of the X-axis sensor in the seventh embodiment;

Fig. 39B is a block diagram illustrating a bridge connection of the Y1-axis sensor in the seventh embodiment;

Fig. 39C is a block diagram illustrating a bridge connection of the Y2-axis sensor in the seventh embodiment;

Fig. 40 is a plan view schematically illustrating a state of the heat treatment for regularization (pinning treatment) in the seventh embodiment;

Fig. 41 is a view explaining the heat treatment for regularization (pinning treatment) in the seventh embodiment;

Fig. 42 is a plan view illustrating a brief constitution of the three-axis magnetic sensor in a first exemplified variation of the seventh embodiment of the present invention;

Fig. 43 is a plan view illustrating a brief constitution of the three-axis magnetic sensor in a second exemplified variation of the seventh embodiment of the present invention;

Fig. 44 is a plan view illustrating a brief constitution of the three-axis magnetic sensor in a third exemplified variation of the seventh embodiment of the present invention;

Fig. 45 is a plan view illustrating a brief constitution of the three-axis magnetic sensor in a fourth exemplified variation of the seventh embodiment of the present invention;

Fig. 46 is a plan view illustrating a brief constitution of the three-axis magnetic sensor in an eighth embodiment of the present invention;

Fig. 47A is a view illustrating an enlarged A part and an enlarged B part of the eight embodiment in Fig. 46 and a sectional view illustrating an enlarged cross section taken along line H-H' of the F part;

Fig. 47B is a view illustrating an enlarged A part and an enlarged B part of the eight embodiment in Fig. 46 and a plan view illustrating an enlarged F part;

Fig. 47C is a view illustrating an enlarged Apart and an enlarged B part of the eight embodiment in Fig. 46 and a sectional view illustrating an enlarged cross section taken along line H-H' of the G part;

Fig. 47D is a view illustrating an enlarged A part and an enlarged B part of the eight embodiment in Fig. 46 and a plan view illustrating an enlarged G part;

Fig. 48 is a plan view illustrating a three-axis magnetic sensor of a ninth embodiment in the present invention;

Fig. 49 is a plan view illustrating an X-axis GMR element used in the ninth embodiment of the present invention;

Fig. 50 is a plan view illustrating a Z-axis GMR element used in the ninth embodiment of the present invention;

Fig. 51 is a sectional view taken along line A-A in Fig. 50;

Fig. 52 is a block diagram illustrating a connection of the X-axis magnetic sensor in the ninth embodiment of the present invention;

Fig. 53 is a block diagram illustrating a connection of the Y-axis magnetic sensor in the ninth embodiment of the present invention;

Fig. 54 is a block diagram illustrating a connection of the Z-axis magnetic sensor in the ninth embodiment of the present invention;

Fig. 55 is a plan view illustrating an array arrangement on heat treatment for regulation in the ninth embodiment of the present invention;

Fig. 56 is a sectional view taken along line B-B' in Fig. 55;

Fig. 57 is a plan view illustrating an array arrangement on polarization of the Z-axis GMR element of the ninth embodiment in the present invention;

Fig. 58 is a plan view illustrating a yoke used in a polarization process of the X-axis GMR element and the Y-axis GMR element of the ninth embodiment in the present invention;

Fig. 59 is a schematic view illustrating a state of a magnetic field in the yoke of the ninth embodiment in the present invention;

Fig. 60 is a plan view illustrating a polarization process of the X-axis GMR element and the Y-axis GMR element of the ninth embodiment in the present invention;

Fig. 61 is a plan view illustrating a yoke used in the polarization process in a tenth embodiment of the present invention;

Fig. 62 is a schematic view illustrating a state of a magnetic field in a yoke of the tenth embodiment in the present invention;

Fig. 63A is a plan view schematically illustrating a conventional magnetic sensor;

Fig. 63B is a side view schematically illustrating the conventional magnetic sensor;

Fig. 64A is a view illustrating a bridge-connection of the conventional magnetic sensor;

Fig. 64B is a view illustrating a bridge-connection of the conventional magnetic sensor; and

Fig. 64C is a view illustrating a bridge-connection of the conventional magnetic sensor.

## BEST MODE FOR CARRYING OUT THE INVENTION

Hereinafter, an explanation will be made of features of the present invention as a three-axis magnetic sensor of a first embodiment to a tenth embodiment by referring to the drawings. However, the present invention is not restricted by these embodiments and appropriate modifications can be carried out, within a scope not departing from the spirit of the present invention.

(First embodiment)

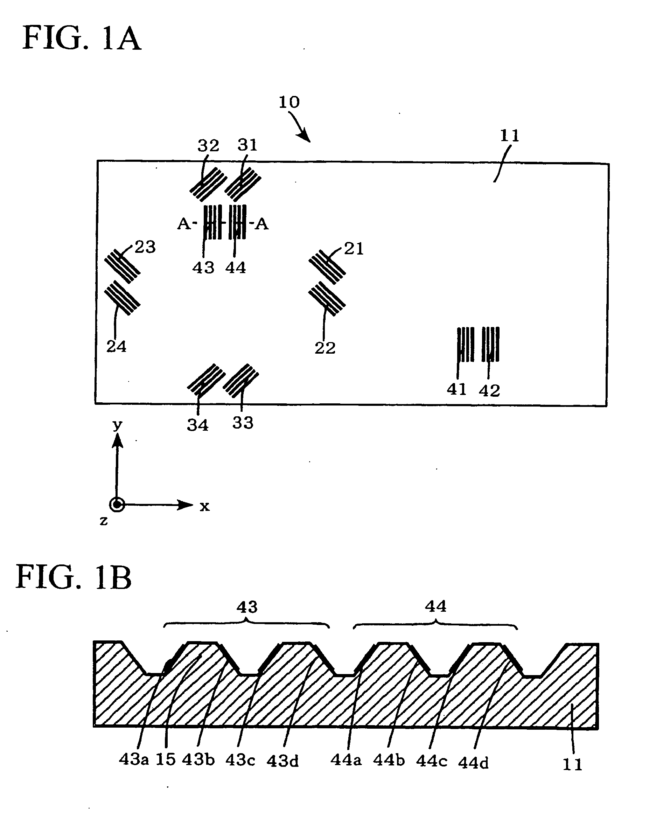

First, an explanation will be made of a three-axis magnetic sensor of a first embodiment as follows by referring to Fig. 1A to Fig. 15C.

As illustrated in Fig. 1A and 1B, a three-axis magnetic sensor 10 of the first embodiment is provided with a substrate 11 made up of quartz or silicon, which is in a rectangular shape, with the sides along the X-axis and Y-axis orthogonal to each other, when viewed from above, (here, it is shaped so that the ratio of the short side (longitudinal) to the long side (transverse) (aspect ratio) is 1 : 2 and the side along the X-axis is a long side and the side along the Y-axis is a short side) and has a small thickness in the direction of the Z-axis orthogonal to the X-axis and the Y-axis. Then, a total of 12 GMR elements respectively made up of four elements of X-axis GMR elements 21 to 24, Y-axis GMR elements 31 to 34 and Z-axis GMR elements 41 to 44, a total of 12 pads (not illustrated) and connecting wires (not illustrated) connecting each of the pads with each of the elements are fabricated on the substrate 11. An LSI and a wiring layer are also fabricated into the substrate 11. A substrate into which the LSI is fabricated is used to provide a magnetic sensor based on a digital output, while a substrate into which only the wiring layer is fabricated is used to provide a magnetic sensor based on an analog output.

Here, the X-axis GMR elements are constituted with a first X-axis GMR element 21, a second X-axis GMR element 22, a third X-axis GMR element 23 and a fourth X-axis GMR element 24. Then, the first X-axis GMR element 21 is arranged at approximately the center (hereinafter, referred to as the X-axis central portion) between the left end portion of the substrate 11 in the direction of the X-axis (here, on the basis of the left end portion in Fig. 1A as a reference point of the X-axis, a right direction of the drawing from the reference point is regarded as a positive direction of the X-axis, the opposite direction is regarded as a negative direction of the X-axis, and the same shall apply hereinafter) and the right end portion, or above at approximately the center (hereinafter, referred to as the Y-axis central portion) between the lower end portion in the direction of the Y-axis (here, on the basis of the lower end portion in Fig. 1A as a reference point of the Y-axis, an upper direction of the drawing from the reference point is regarded as a positive direction of the Y-axis, and the opposite direction is regarded as a negative direction of the Y-axis, and the same shall apply hereinafter) and the upper end portion, and the second X-axis GMR element 22 is arranged below thereof. Further, the third X-axis GMR element 23 is arranged above the Y-axis central portion in the vicinity of the X-axis left end portion on the substrate 11, and the fourth X-axis GMR element 24 is arranged below thereof

Further, the Y-axis GMR elements are constituted with a first Y-axis GMR element 31, a second Y-axis GMR element 32, a third Y-axis GMR element 33 and a fourth Y-axis GMR element 34. Then, the first Y-axis GMR element 31 is arranged on the right of approximately an intermediate portion from the X-axis central portion to the X-axis left end portion in the vicinity of the upper end portion of the substrate 11 in the Y-axis direction, and the second Y-axis GMR element 32 is arranged left thereof The third Y-axis GMR element 33 is arranged on the right of approximately an intermediate portion from the X-axis central portion to the X-axis left end portion in the vicinity of the lower end portion of the substrate 11 in the Y-axis direction, and the fourth Y-axis GMR element 34 is arranged left thereof

In addition, the Z-axis GMR elements are constituted with a first Z-axis GMR element 41, a second Z-axis GMR element 42, a third Z-axis GMR element 43 and a fourth Z-axis GMR element 44. Then, the first Z-axis GMR element 41 is arranged at approximately an intermediate portion from the Y-axis central portion of the substrate 11 to the Y-axis lower end portion or left at approximately an intermediate portion from the X-axis central portion to the X-axis right end portion, and the second Z-axis GMR element 42 is arranged right thereof. The third Z-axis GMR element 43 is arranged at approximately an intermediate portion from the Y-axis central portion of the substrate 11 to the Y-axis upper end portion or left at approximately an intermediate portion from the X-axis central portion to the X-axis left end portion, and the fourth Z-axis GMR element 44 is arranged right thereof

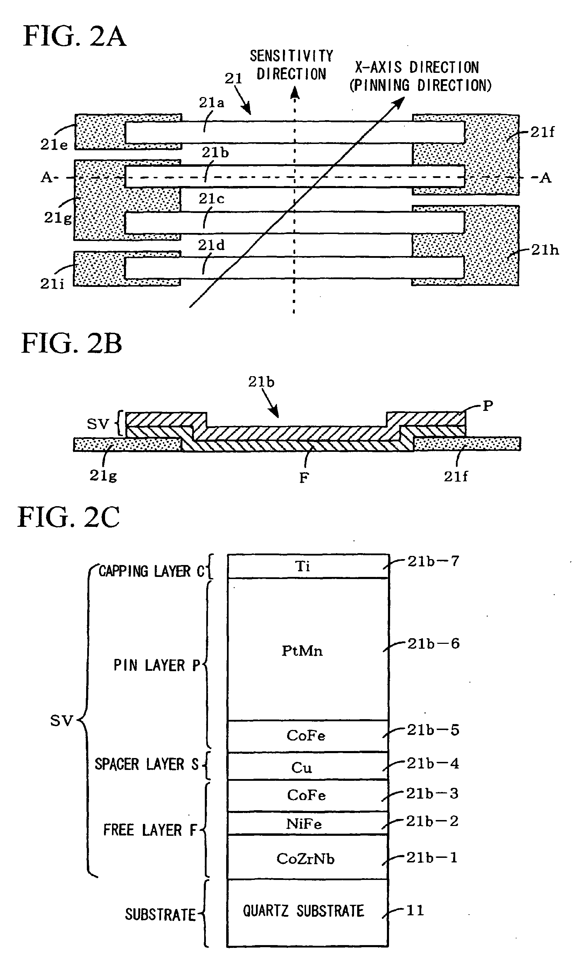

Here, each of the GMR elements 21 to 24, 31 to 34 and 41 to 44 is respectively provided with four GMR bars mutually parallel and arranged adjacently in a band form, these four GMR bars are connected in series by using magnet films (bias magnet films), and magnet films which will act as a terminal are connected to these ends. For example, in Fig. 2A to 2B (it is to be noted that only the first X-axis GMR element 21 is illustrated in Fig. 2A to 2C but other GMR elements are also similar in constitution), four GMR bars 21a, 21b, 21 c and 21 d are connected in series by the magnet films 21f, 21g, and 21h, and the magnet films 21e and 21i which will act as a terminal are connected to these ends.

Here, each of the GMR bars (21a, 21b, 21c, 21d, etc.) of the X-axis GMR elements 21 to 24 is formed on a flat surface parallel to the surface of a substrate 11 and arranged in such a way that the longitudinal direction gives an angle of 45 degrees with respect to the X-axis. Further, each of the GMR bars of the Y-axis GMR elements 31 to 34 is formed on a flat surface parallel to the surface of the substrate 11 and arranged in such a way that the longitudinal direction is orthogonal to the longitudinal direction of each of the GMR bars of the X-axis GMR elements 21 to 24. Further, each of the GMR bars of the Z-axis GMR elements 41 to 44 is arranged in such a way that one GMR bar (for example, 43a, 43b, 43c, 43d, or 44a, 44b, 44c, 44d, and the like (refer to Fig. 1B)) per tilted surface (so as to give a tilted angle of approximately 45 degrees) is formed on each tilted surface of a plurality of projections (ledge portions) 15 formed on the substrate 11 and the cross section of which is in a trapezoidal shape, with the longitudinal direction being vertical to the X-axis and parallel to the Y-axis.

Next, an explanation will be made of the constitution of the GMR bars by exemplifying the GMR bar 21b of the first X-axis GMR element 21 on the basis of Fig. 2A to Fig. 2C. Other GMR bars 21a, 21c and 21d are also similar in constitution and, therefore, only the GMR bar 21b will be explained here. Further, an explanation will also be omitted of other X-axis GMR elements 22, 23 and 24, the Y-axis GMR elements 31, 32, 33 and 34 and the Z-axis GMR elements 41, 42, 43 and 44, which are similar in constitution.

Here, as illustrated in Fig 2B, which is a schematic sectional view cut by a flat surface along line A-A in Fig. 2A, the GMR bar 21b of the first X-axis GMR element 21 which is made of a spin valve film SV is a hard ferromagnetic body such as CoCrPt formed below both ends, and provided with magnet films (bias magnet film: hard ferromagnetic body thin film layer) 21g and 21fmade with a material having a high coercive force.

As the film constitution illustrated in Fig. 2C, the spin valve film SV is constituted with a free layer (free layer and free magnetization layer) F, a conductive spacer layer S made with Cu having the thickness of 2.4nm (24Å), a pin layer (bonded layer and fixed magnetization layer) P and a capping layer C made with titanium (Ti) or tantalum (Ta) having the thickness of 2.5nm (25Å), which are laminated sequentially on the substrate 11.

The free layer F is a layer in which the magnetization direction will change according to the direction of an external magnetic field, and constituted with a CoZrNb amorphous magnetic layer 21b-1 formed immediately on the substrate 11 having the thickness of 8nm (80Å), a NiFe magnetic layer 21 b-2 formed on the CoZrNb amorphous magnetic layer 21b-1 having the thickness of 3.3nm (33A) and a CoFe layer 21b-3 formed on the NiFe magnetic layer 21b-2 having the thickness of 1 to 3nm (10 to 30Å). The CoZrNb amorphous magnetic layer 21b-1 and the NiFe magnetic layer 21b-2 constitute a soft ferromagnetic thin film layer. The CoFe layer 21b-3 is provided for preventing the dispersion ofNi in the NiFe layer 21b-2 and Cu 2 1 b-4 in the spacer layer S.

The pin layer P is prepared by adhering a CoFe magnetic layer 21b-5 having the thickness of 2.2nm (22A) to an antiferromagnet film 21b-6 made with a PtMn alloy (Pt content of 45 to 55mol%) having the thickness of 24nm (240Å). The CoFe magnetic layer 21b-5 constitutes a pinned layer in which the magnetization direction (magnetization vector) is pinned (bonded) in the X-axis direction (here, a negative direction of the X-axis) by being backed in a manner of switched connection to the antiferromagnet film 21b-6 which is magnetized (magnetized).

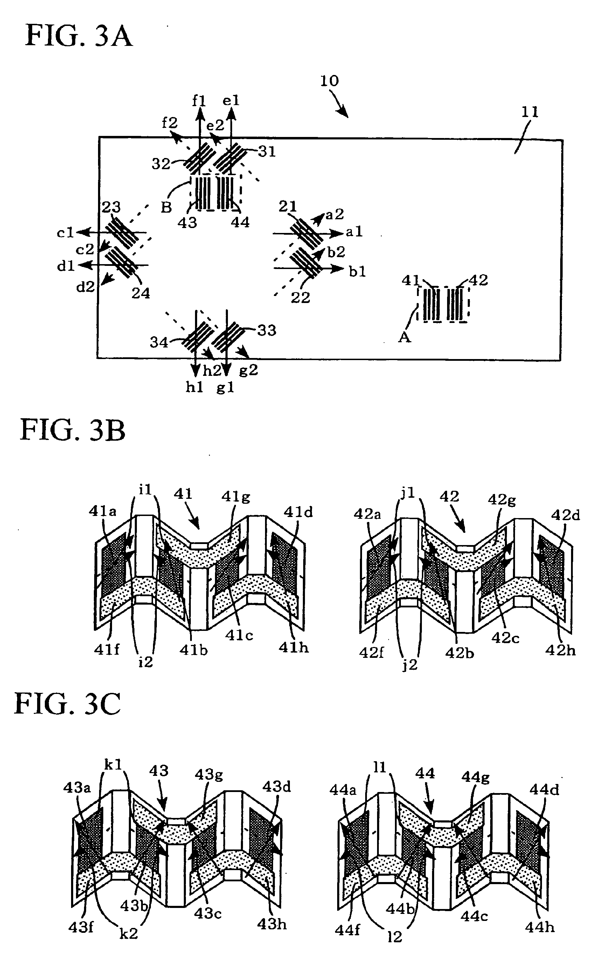

Further, bias magnet films 21e, 21f, 21g, 21h and 21i of the above-described first X-axis GMR element 21 impart a bias magnetic field in a direction parallel to the longitudinal direction of each of the GMR bars with respect to a free layer F (in the direction tilted at -45 degrees with respect to the X-axis) in order to maintain an uniaxial anisotropy of the free layer F. Then, the CoFe magnetic layer 21b-5 (the same will apply to other GMR bars 21a, 21c and 21d) is backed in a manner of switched connection to the antiferromagnet film 21b-6, thereby constituting a pinned layer in such a way that the magnetization direction (magnetization vector) is pinned (bonded) in a positive direction of the X-axis (in the direction given by the solid-line arrow a1 in Fig. 3A). Similarly, the second X-axis GMR element 22 imparts a bias magnetic field in a direction parallel to the longitudinal direction of each of the GMR bars (in the direction tilted at -45 degrees with respect to the X-axis). Then, the pinned layer is formed in such a way that the magnetization direction (magnetization vector) is pinned (bonded) in a positive direction of the X-axis (in the direction given by the solid-line arrow b1 in Fig. 3A).

Thereby, in the first X-axis GMR element 21 and the second X-axis GMR element 22, the sensitivity direction of a magnetic field is a direction vertical to the longitudinal direction of each of the GMR bars, namely, the direction tilted at 45 degrees with respect to a positive direction of the X-axis (in the direction given by the broken-line arrows a2 and b2 in Fig. 3A). Where a magnetic field is applied in the direction given by the broken-line arrows a2 and b2 in Fig. 3A, resistance values of the first X-axis GMR element 21 and the second X-axis GMR element 22 will decrease proportionally with an increase in magnetic field. Where the magnetic field is applied in the direction opposite that given by the broken-line arrows a2 and b2 in Fig. 3A, resistance values of the first X-axis GMR element 21 and the second X-axis GMR element 22 will increase proportionally with an increase in magnetic field.

In contrast, in the third X-axis GMR element 23 and the fourth X-axis GMR element 24, the bias magnet film imparts a bias magnetic field in a direction opposite 180 degrees to the first X-axis GMR element 21 and the second X-axis GMR element 22 or in a direction parallel to the longitudinal direction of each of the GMR bars (in the direction tilted at 45 degrees with respect to a negative direction of the X-axis). Then, a pinned layer is formed in such a way that the magnetization direction (magnetization vector) is pinned (bonded) in a negative direction of the X-axis (in the direction given by the solid-line arrows c1 and d1 in Fig. 3A or the direction opposite 180 degrees to the magnetization direction of the pinned layer of the first X-axis GMR element 21 and the second X-axis GMR element 22).

Thereby, the sensitivity direction of a magnetic field is a direction vertical to the longitudinal direction of each of the GMR bars, namely, the direction given by the broken-line arrows c2 and d2 in Fig. 3A (the direction opposite 180 degrees to the sensitivity direction of the first X-axis GMR element 21 and the second X-axis GMR element 22). Where a magnetic field is applied in the direction given by the broken-line arrows c2 and d2 in Fig. 3A, resistance values of the third X-axis GMR element 23 and the fourth X-axis GMR element 24 will decrease proportionally with an increase in magnetic field. Where the magnetic field is applied in the direction opposite that given by the broken-line arrows c2 and d2 in Fig. 3A, resistance values of the third X-axis GMR element 23 and the fourth X-axis GMR element 24 will increase proportionally with an increase in magnetic field.

Further, in the first Y-axis GMR element 31 and the second Y-axis GMR element 32, a bias magnet film imparts a bias magnetic field in a direction parallel to the longitudinal direction of each of the GMR bars (in the direction tilted at 45 degrees with respect to a positive direction of the X-axis, namely, the direction in which the bias magnetic field of the first X-axis GMR element 21 and the second X-axis GMR element 22 is turned counterclockwise 90 degrees) and a pinned layer is formed in such a way that the magnetization direction (magnetization vector) is pinned (bonded) in a positive direction of the Y-axis (in the direction given by the solid-line arrows e1 and f1 in Fig. 3A).

Thereby, the sensitivity direction of a magnetic field is a direction vertical to the longitudinal direction of each of the GMR bars, namely, the direction tilted at 45 degrees with respect to a negative direction of the X-axis (the direction given by the broken-line arrows e2 and f2 in Fig. 3A). Where a magnetic field is applied in the direction given by the broken-line arrows e2 and f2 in Fig. 3A, resistance values of the first Y-axis GMR element 31 and the second Y-axis GMR element 32 will decrease proportionally with an increase in magnetic field. Where the magnetic field is applied in the direction opposite that given by the broken-line arrows e2 and f2 in Fig. 3A, resistance values of the first Y-axis GMR element 31 and the second Y-axis GMR element 32 will increase proportionally with an increase in magnetic field.

In contrast, in the third Y-axis GMR element 33 and the fourth Y-axis GMR element 34, the bias magnet film imparts a bias magnetic field in a direction opposite 180 degrees to the first Y-axis GMR element 31 and the second Y-axis GMR element 32 or in a direction parallel to the longitudinal direction of each of the GMR bars (in the direction tilted at -45 degrees with respect to a negative direction of the X-axis). Then, a pinned layer is formed in such a way that the magnetization direction (magnetization vector) is pinned (bonded) in a negative direction of the Y-axis (in the direction given by the solid-line arrows g1 and h1 in Fig. 3A)

Thereby, the sensitivity direction of a magnetic field is a direction vertical to the longitudinal direction of each of the GMR bars, namely, the direction tilted at -45 degrees with respect to a positive direction of the X-axis (the direction given by the broken-line arrow g2 and h2 in Fig. 3A, and opposite 180 degrees to the magnetization direction of the first Y-axis GMR element 31 and the second Y-axis GMR element 32). Where a magnetic field is applied in the direction given by the broken-line arrows g2 and h2 in Fig. 3A, resistance values of the third Y-axis GMR element 33 and the fourth Y-axis GMR element 34 will decrease proportionally with an increase in magnetic field. Where the magnetic field is applied in the direction opposite that given by the broken-line arrows g2 and h2 in Fig. 3A, resistance values of the third Y-axis GMR element 33 and the fourth Y-axis GMR element 34 will increase proportionally with an increase in magnetic field.

Further, in the first Z-axis GMR element 41 and the second Z-axis GMR element 42, as illustrated schematically in Fig. 3B, bias magnet films 41f, 41g and 41h (42f, 42g and 42h) impart a bias magnetic field in a direction parallel to the longitudinal direction of each of the GMR bars 41a, 41b, 4 1 c and 4 1 d (42a, 42b, 42c and 42d), namely, on a flat surface of each tilted surface (the tilted angle is approximately 45 degrees) of projections (ledge portions) 15, a direction in which the longitudinal direction is vertical to the X-axis and parallel to the Y-axis. Then, a pinned layer is formed in such a way that the magnetization direction (magnetization vector) is pinned (bonded) in the direction tilted at 45 degrees with respect to a positive direction of the Z-axis (in the direction given by the solid-line arrows i1 (j1) in Fig. 3B).

Then, each of these GMR bars 41a, 41b, 41c and 41d (42a, 42b, 42c and 42d) is connected in series by bias magnet films 41f, 41g and 41h (42f, 42g and 42h). Thereby, the sensitivity direction of a magnetic field is a direction vertical to the longitudinal direction of each of the GMR bars, namely, the direction given by the broken-line arrows i2 (j2) in Fig. 3B having a positive component of the Z-axis (the direction moving from the back to the front on the page space). Where a magnetic field is applied in the direction given by the broken-line arrows i2 (j2) in Fig. 3B, resistance values of the first Z-axis GMR element 41 and the second Z-axis GMR element 42 will decrease proportionally with an increase in magnetic field. Where the magnetic field is applied in the direction opposite that given by the broken-line arrows i2 (j2) in Fig. 3B, resistance values of the first Z-axis GMR element 41 and the second Z-axis GMR element 42 will increase proportionally with an increase in magnetic field.

In contrast, in the third Z-axis GMR element 43 and the fourth Z-axis GMR element 44, as illustrated schematically in Fig. 3C, the bias magnet films 43f, 43g and 43h (44f, 44g and 44h) impart a bias magnetic field in a direction parallel to the longitudinal direction of each of the GMR bars 43a, 43b, 43c and 43d (44a, 44b, 44c and 44d), namely, on a flat surface of each tilted surface (the tilted angle is approximately 45 degrees) of projections (ledge portions) 15, a direction in which the longitudinal direction is vertical to the X-axis and parallel to the Y-axis. Then, a pinned layer is formed in such a way that the magnetization direction (magnetization vector) is pinned (bonded) in the direction tilted at 45 degrees with respect to a negative direction of the Z-axis (in the direction given by the solid-line arrows k1 (11) in Fig. 3C.

Then, each of these GMR bars, 43a, 43b, 43c and 43d (44a, 44b, 44c and 44d) is connected in series by the bias magnet films 43f, 43g and 44h (44f, 44g and 44h). Thereby, the sensitivity direction of a magnetic field is a direction vertical to the longitudinal direction of each of the GMR bars, namely, the direction given by the broken-line arrows k2 (12) in Fig. 3C having a positive component of the Z-axis (the direction moving from the back to the front on the page space). Where a magnetic field is applied in the direction given by the broken-line arrows k2 (12) in Fig. 3C, resistance values of the third Z-axis GMR element 43 and the fourth Z-axis GMR element 44 will decrease proportionally with an increase in magnetic field. Where the magnetic field is applied in the direction opposite that given by the broken-line arrows k2 (12) in Fig. 3C, resistance values of the third Z-axis GMR element 43 and the fourth Z-axis GMR element 44 will increase proportionally with an increase in magnetic field.

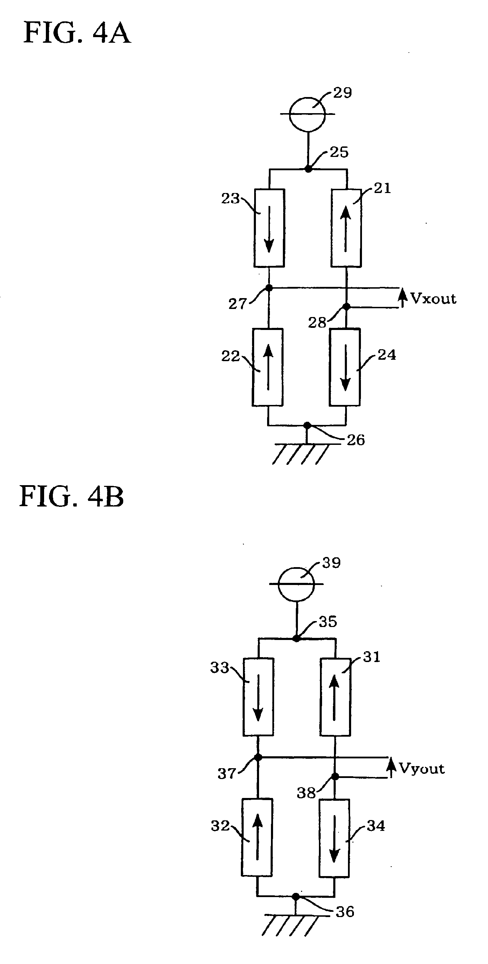

As an equivalent circuit illustrated in Fig. 4A, the X-axis magnetic sensor is constituted with the first X-axis GMR element 21 to the fourth X-axis GMR element 24, which are full-bridge- connected. In Fig. 4A, the arrows indicate the magnetization direction of a bonded layer on which each of the GMR elements 21 to 24 is pinned. In the above constitution, a pad 25 and a pad 26 are connected to a positive electrode and a negative electrode of a constant voltage source 29, thereby imparting a potential Vxin+ (3V in this embodiment) and a potential Vxin- (0(V) in this embodiment). Then, potentials of a pad 27 and a pad 28 are output respectively as a potential Vxout+ and a potential Vxout-, and a potential difference between them (Vxout+ - Vxout-) is output as a sensor output Vxout.

As an equivalent circuit illustrated in Fig. 4B, the Y-axis magnetic sensor is constituted with the first Y-axis GMR element 31 to the fourth Y-axis GMR element 34, which are full-bridge- connected. A pad 35 and a pad 36 are connected to a positive electrode and a negative electrode of a constant voltage source 39, thereby imparting a potential Vyin+ (3V in this embodiment) and a potential Vyin- (0(V) in this embodiment), and a potential difference between a pad 37 and a pad 38 is output as a sensor output Vyout.

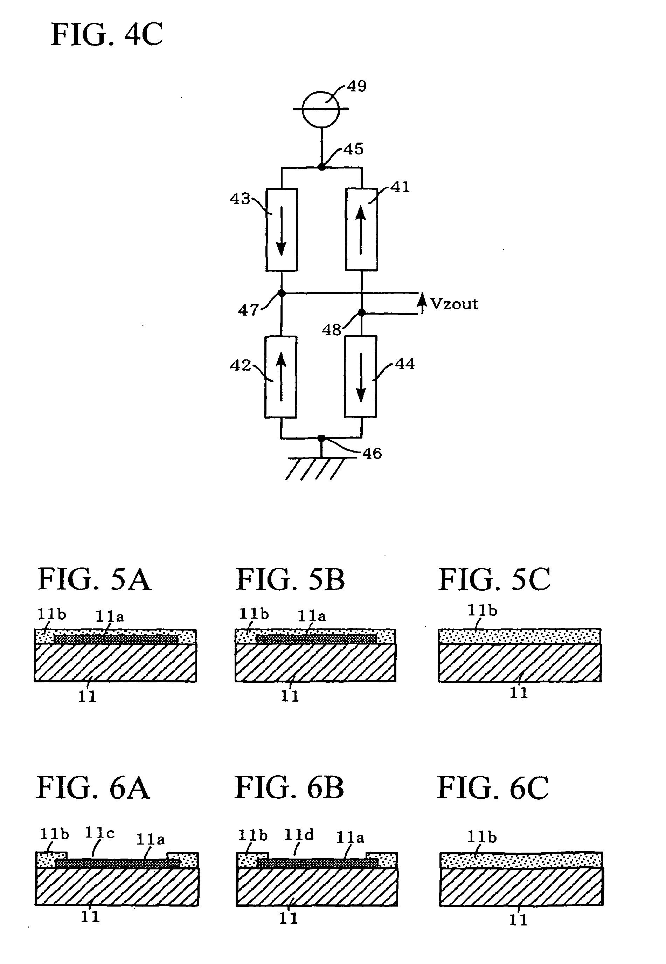

As an equivalent circuit illustrated in Fig. 4C, the Z-axis magnetic sensor is constituted with the first Z-axis GMR element 41 to the fourth Z-axis GMR element 44, which are full-bridge- connected. Then, a pad 45 and a pad 46 are connected to a positive electrode and a negative electrode of a constant voltage source 49, thereby imparting a potential Vzin+ (3V in this embodiment) and a potential Vzin- (0(V) in this embodiment), and a potential difference between a pad 47 and a pad 48 is output as a sensor output Vzout.

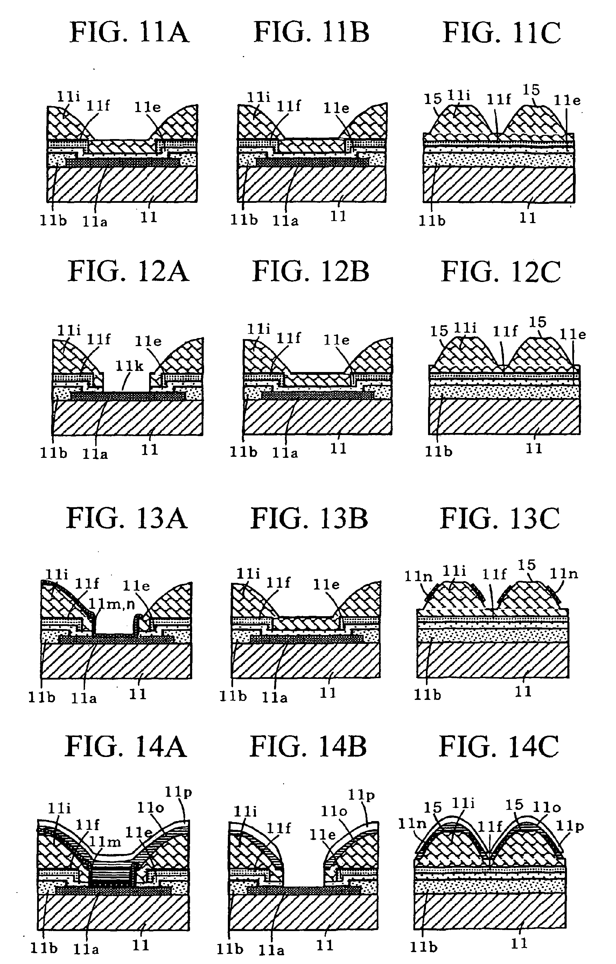

Next, an explanation will be made of a method for manufacturing the above-constituted three-axis magnetic sensor by referring to schematic sectional views, namely, Fig. 5A, Fig. 5B, Fig. 5C through Fig. 14A, Fig. 14B and Fig. 14C. Fig. 5A, Fig. 6A, Fig. 7A, to Fig. 14A illustrate via portions, Fig. 5B, Fig. 6B, Fig. 7B to Fig. 14B illustrate pad portions, Fig. 5C, Fig. 6C, Fig. 7C to Fig. 14C illustrate GMR portions of Z-axis. Here, as described above, it is preferable to use a substrate in which an LSI is fabricated in advance by a CMOS process or one in which only a wiring layer is fabricated in advance as the substrate 11.

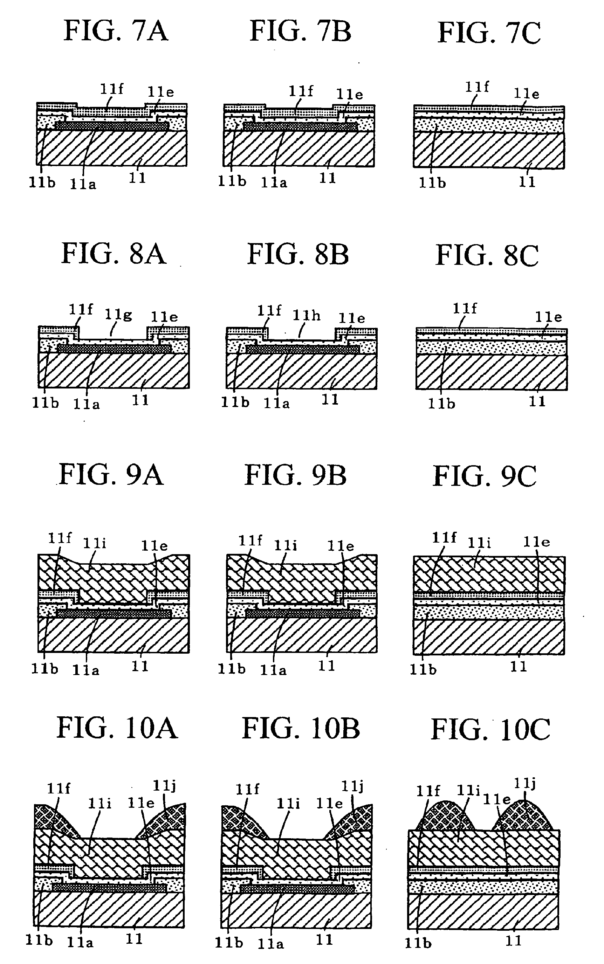

In the method for manufacturing the three-axis magnetic sensor, as illustrated in Fig. 5A to Fig. 5C, first, an interlayer insulation film 11 b made up of, for example, silicon oxide film or silicon nitride film is coated on a substrate (quartz substrate or silicon substrate) 11 having a wiring layer 11 a by using the SOG (spin on glass) method or CMP method, thereby giving a smooth surface. Thereafter, as illustrated in Fig. 6A to Fig. 6C, the interlayer insulation film 11 b at the via portion and the pad portion is removed by etching to create openings 11c and 11d. Then, as illustrated in Fig. 7A to Fig. 7C, a $SiO_2$ film (thickness: 1500Å)11e and a $Si_3N_4$ film (thickness: 5000Å)11f are formed on the surface of each of the openings by plasma CVD.

Next, as illustrated in Fig. 8A to Fig. 8C, a resist is coated thereon and cut in such a pattern to create openings at a via portion and a pad portion. Thereafter, the $Si_3N_4$ film 11f at the via portion and the pad portion is removed by etching to remove the resist. Thereby, openings 11g and 11h are formed at the via portion and the pad portion, but the $SiO_2$ film 11e is treated so as not to be completely etched but to remain thereon. Here, in order to prevent water from permeating into a wiring layer or an LSI due to exposure of an interlayer insulation film 11b at openings 11c and 11d, the openings 11g and 11h are made smaller in dimension than the openings 11c and 11d.

Thereafter, as illustrated in Fig. 9A to 9C, a $SiO_2$ film (thickness: 5μm)11i is formed thereon by using plasma CVD. Next, a resist is coated thereon to form a resist film (thickness: 5μm)11j. The thus formed resist film (thickness: 5μm) 11j is cut in such a pattern to create openings at the via portion and the pad portion and also cut in such a pattern to provide projections (ledge portions) 15 for arranging Z-axis GMR elements 41, 42, 43 and 44. After cutting, the resist film 11j is subjected to heat treatment at 150°C for 10 minutes, and the cut portion of the resist film 11j is formed in a tapered shape (tapering) as illustrated in Fig. 10A to 10C.

Thereafter, dry etching is conducted under the conditions where the $SiO_2$ film (thickness: 5μm) 11i and the resist film (thickness: 5μm) 11j are etched approximately at a similar ratio and the $SiO_2$ film 11i after the etching remains to be about 5000Å at the greatest thickness portion. Here, openings of the $SiO_2$ film 11i at the via portion and the pad should not be greater in dimension than openings on the $Si_3N_4$ film 11 f at the via portion and the pad portion. After the dry etching, any remaining resist is removed. Thereby, as illustrated in Fig. 11 A to 11C, projections (ledge portions) 15 made of the $SiO_2$ film 11i are formed at GMR portions.

Next, a resist is coated thereon, the coated resist is cut in such a pattern as to create openings at the via portion, and etching is conducted. Thereafter, any remaining resist is removed to create an opening 11k at the via portion, as illustrated in Fig. 12A to 12C, thereby exposing a wiring layer 11a, and the uppermost layer of the substrate 11. Then, sputtering is conducted to form a primary film made with Ti or Cr (thickness: 300μm).

Next, a bias magnet film 11m having a high coercive force, which is a hard ferromagnetic body made with a material such as CoCrPt, (later converted to 21e, 21f, 21g, 21h, 21i, etc., as illustrated in Fig. 2A) is formed on the surface of the primary film by sputtering, vacuum evaporation or ion plating. A resist is coated thereon, the thus coated resist is cut in a pattern of the bias magnet film, and then, the bias magnet film 11m and the primary film are etched. Prior to the etching, it is preferable that the resist be reflowed by heat treatment to remove corners of the resist (rounding) for the purpose of conducting an appropriate etching on a tilted surface of each of the projections (ledge portions) 15. Thereafter, any remaining resist is removed. Then, sputtering is conducted to form a GMR multilayer film 11 n that will act as GMR elements (later, converted to 21 to 24, 31 to 34, 41 to 44, etc.) on the surface.

As illustrated in Fig. 2C, the GMR multilayer film 11n is constituted with a free layer (free layer, free magnetization layer) F, a conductive spacer layer S made with Cu having the thickness of 2.4nm (24Å), a pin layer (bonded layer, fixed magnetization layer) P and a capping layer C made with titanium (Ti) or tantalum (Ta) having the thickness of 2.5nm (25Å), which are laminated sequentially on the substrate 11. Then, the film layer F is constituted with a CoZrNb amorphous magnetic layer 21b-1 formed immediately on the substrate 11 having the thickness of 8nm (80Å), a NiFe magnetic layer 21b-2 having the thickness of 3.3nm (33Å) and a CoFe layer 21b-3 having the thickness of 1 to 3nm (10 to 30Å). The CoZrNb amorphous magnetic layer 21b-1 and the NiFe magnetic layer 21b-2 constitute a soft ferromagnetic thin film layer. The pin layer P is prepared by adhering the CoFe magnetic layer 21b-5 having the thickness of 2.2nm (22Å) to the antiferromagnet film 21b-6 having the thickness of 24nm (240Å).

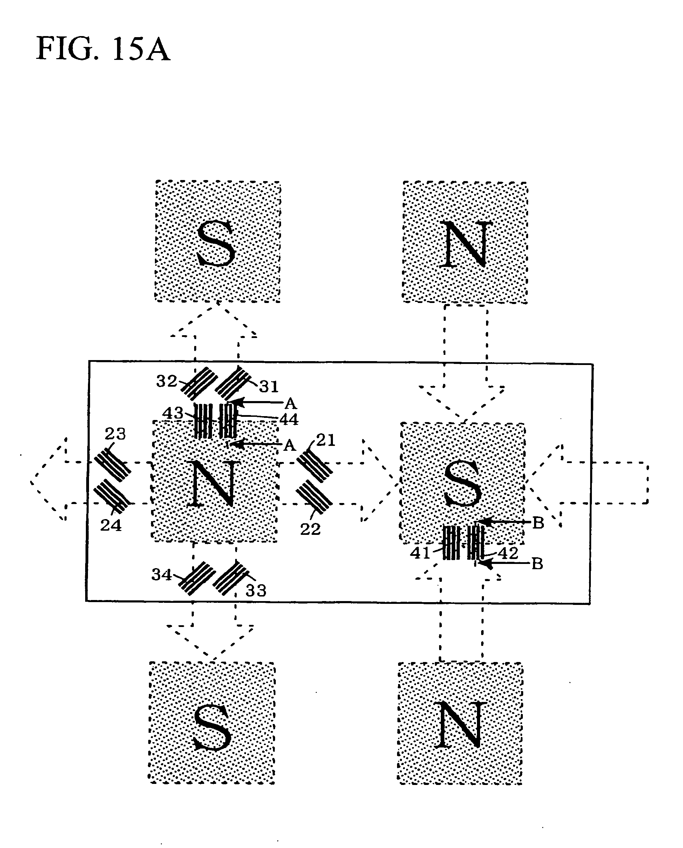

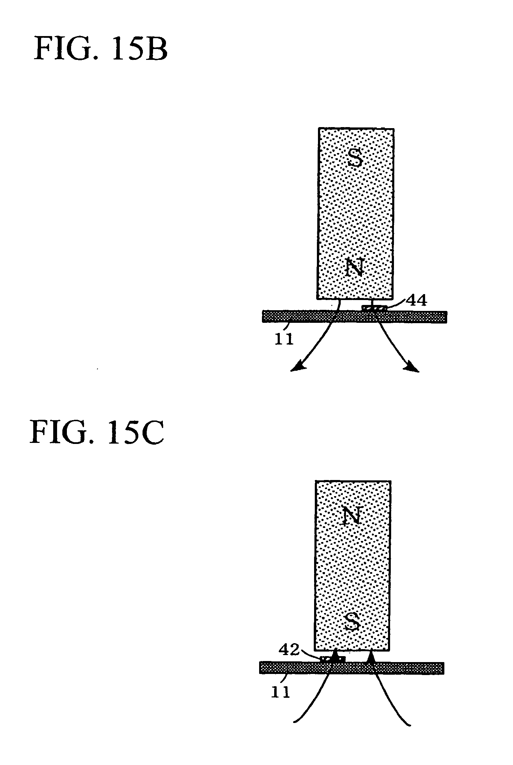

Next, a permanent magnet array is allowed to move close to the thus obtained laminated body to conduct heat treatment for regularization (pinning treatment), thereby fixing the magnetization direction of the pinned layer P. Here, as schematically illustrated in Fig. 15A to 15C, the heat treatment for regularization (pinning treatment) is conducted by arranging a permanent bar magnet array (magnet array) arranged in a lattice form so as to be mutually different in polarity of the upper end (lower end) of adjacent permanent bar magnet pieces in such a way that the N pole is arranged above the center of a region left from the center of a substrate 11 and the S pole is arranged above the center of a region right from the center of the substrate 11.

As is apparent from Fig. 15A to 15C (it is to be noted that Fig. 15A to 15C illustrate a state that only six-permanent magnet pieces are arranged), on the lower surface of a permanent bar magnet piece arranged above the center of a region left from the center of a substrate 11, a magnetic field is formed, which is different in direction at every 90 degrees moving from one N pole toward S poles adjacent to the N pole at the shortest distance. In contrast, on the lower surface of the permanent bar magnet piece arranged above the center of a region right from the center of the substrate 11, a magnetic field is formed, which is different at every 90 degrees moving to one S pole from N poles adjacent to the S pole at the shortest distance. These magnetic fields are utilized to conduct heat treatment for fixing the magnetization direction of the bonded layer P (pinned layer of the bonded layer P). More specifically, in a state given in Fig. 15A to 15C, the substrate 11 and the permanent bar magnet array (magnet array) are fixed, heated in vacuum at temperatures from 260°C to 290°C, and allowed to stand approximately for four hours as they are, thereby conducting the heat treatment for regularization (pinning treatment).

Thereby, as illustrated in Fig. 3A to 3C, in the first X-axis GMR element 21 and the second X-axis GMR element 22, the magnetization direction of a pinned layer is fixed to the direction given by the arrows a1 and b1 in Fig. 3A, while in the third X-axis GMR element 23 and the fourth X-axis GMR element 24, the magnetization direction of the pinned layer is fixed in the direction given by the arrows c1 and d1 in Fig. 3A. Further, in the first Y-axis GMR element 31 and the second Y-axis GMR element 32, the magnetization direction of the pinned layer is fixed to the direction given by the arrows e1 and f1 in Fig. 3A, while in the third Y-axis GMR element 33 and the fourth Y-axis GMR element 34, the magnetization direction of the pinned layer is fixed to the direction given by the arrows g1 and h1 in Fig. 3A. In the first Z-axis GMR element 41 and the second Z-axis GMR element 42, the magnetization direction of the pinned layer is fixed to a direction tilted at 45 degrees from the X-axis to a positive direction of the Z-axis inside a tilted surface of each of the projections (ledge portions) 15. In the third Z-axis GMR element 43 and the fourth Z-axis GMR element 44, the magnetization direction of the pinned layer is fixed to a direction tilted at 45 degrees from the X-axis to a negative direction of the Z-axis inside the tilted surface of each of the projections (ledge portions) 15.

Thereafter, a resist is coated on the surface of a GMR multilayer film 11n so as to give a predetermined thickness, for example, 2μm, at a flat portion, a mask is arranged on the surface of the resist, printing and development are conducted to remove an unnecessary resist, thereby forming a resist film having the same pattern as the GMR multilayer film 11n to be obtained later. Here, in order to give an appropriate etching to projections (ledge portions) 15, it is preferable that prior to the etching, the resist be reflowed by heat treatment to remove corners of the resist (rounding). Thereafter, a portion of the GMR multilayer film 11n not covered with the resist film is removed by ion milling to form a GMR multilayer film 11n in a predetermined shape (for example, a plurality of narrow bands). Here, a via portion is treated so that both the GMR multilayer film 11 n and a bias magnet film 11m are allowed to remain. This is to prevent possible breakage of wiring due to the edge of the via portion.

Next, the resist film is removed. As illustrated in Fig. 14A to Fig. 14C, a $Si_3N_4$ film 11o is formed on the above films at the thickness of 10000Å by using plasma CVD, and a polyimide film 11p is then formed thereon to provide a protective film. Thereafter, the polyimide film 11p on a pad portion is used as a mask, the $Si_3N_4$ film 11o at the pad portion is removed by etching to provide an opening to the pad portion, thereby forming individual pads. A wiring is provided for connecting these pads and the substrate 11 is finally cut. According to the processes described so far, the three-axis magnetic sensor 10 of the first embodiment illustrated in Fig. 1A and 1B is fabricated.

(Exemplified variation of the first embodiment)

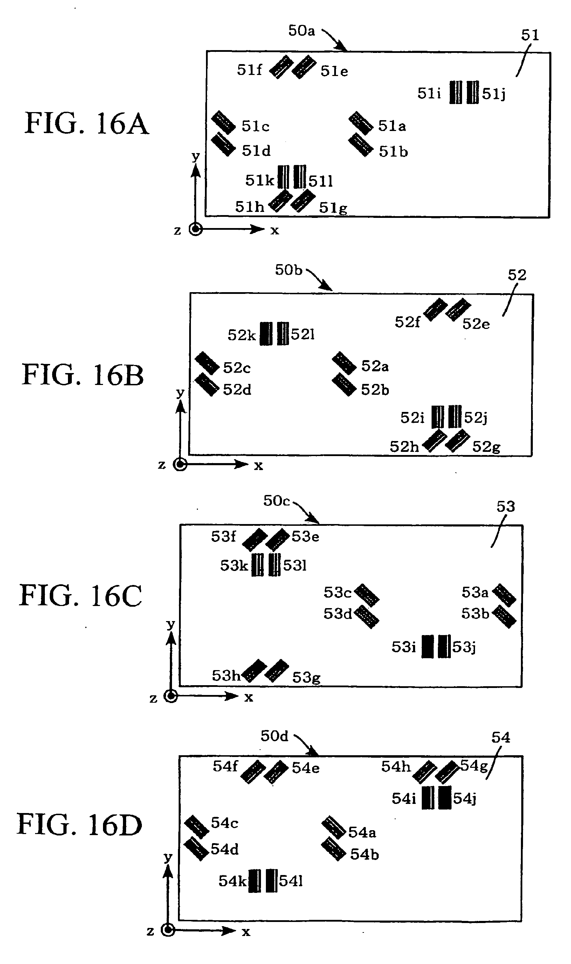

In the above-described three-axis magnetic sensor of the first embodiment, an arrangement relationship of each of the GMR elements can be changed in various ways, thereby providing exemplified variations. Hereinafter, an explanation will be made simply of a representative exemplified variation of the three-axis magnetic sensor in the first embodiment by referring to Fig. 16A to 16D. Whether to select the arrangement relationship of each of the GMR elements in the first embodiment or that of each of the GMR elements in the following exemplified variation may be appropriately decided, depending on an LSI circuit and the like formed on the substrate.

(First exemplified variation)

Fig. 16A is a brief constitution view schematically illustrating a three-axis magnetic sensor 50a of a first exemplified variation. In the first exemplified variation, Z-axis GMR elements are changed in arrangement relationship. More specifically, as illustrated in Fig. 16A, a first Z-axis GMR element 51i is arranged at approximately an intermediate portion from the Y-axis central portion of the substrate 51 to the Y-axis upper end portion or left at approximately an intermediate portion from the X-axis central portion to the X-axis right end portion, and a second Z-axis GMR element 51j is arranged right thereof Further, a third Z-axis GMR element 51k is arranged at approximately an intermediate portion from the Y-axis central portion of the substrate 51 to the Y-axis lower end portion or left at approximately an intermediate portion from the X-axis central portion to the X-axis left end portion, and a fourth Z-axis GMR element 511 is arranged right thereof. Here, the X-axis GMR elements 51a to 51d and the Y-axis GMR elements 51e to 51h are the same as the X-axis GMR elements 21 to 24 and the Y-axis GMR elements 31 to 34 in the above-described first embodiment.

(Second exemplified variation)

Fig. 16B is a brief constitution view schematically illustrating a three-axis magnetic sensor 50b of a second exemplified variation. In the second exemplified variation, Y-axis GMR elements are changed in arrangement relationship. More specifically, as illustrated in Fig. 16B, a first Y-axis GMR element 52e is arranged on the right of approximately an intermediate portion from the X-axis central portion to the X-axis right end portion in the vicinity of the Y-axis upper end portion of the substrate 52, and a second Y-axis GMR element 52f is arranged left thereof. Further, a third Y-axis GMR element 52g is arranged on the right of approximately an intermediate portion from the X-axis central portion to the X-axis right end portion in the vicinity of the Y-axis lower end portion of the substrate 52, and a fourth Y-axis GMR element 52h is arranged left thereof Here, the X-axis GMR elements 52a to 52d and the Z-axis GMR elements 52i to 521 are the same as the X-axis GMR elements 21 to 24 and the Z-axis GMR elements 41 to 44 in the above-described first embodiment.

(Third exemplified variation)

Fig. 16C is a brief constitution view schematically illustrating a three-axis magnetic sensor 50c of a third exemplified variation. In the third exemplified variation, X-axis GMR elements are changed in arrangement relationship. More specifically, as illustrated in Fig. 16C, a first X-axis GMR element 53a is arranged above the Y-axis central portion in the vicinity of the X-axis right end portion of the substrate 53, and a second X-axis GMR element 53b is arranged below thereof Further, a third X-axis GMR element 53c is arranged at the X-axis central portion of the substrate 53 or above the Y-axis central portion, and a fourth X-axis GMR element 53d is arranged below thereof Here, the Y-axis GMR elements 53e to 53h and the Z-axis GMR elements 53i to 531 are the same as the Y-axis GMR elements 31 to 34 and the Z-axis GMR elements 41 to 44 in the above-described first embodiment.

(Fourth exemplified variation)

Fig. 16D is a brief constitution view schematically illustrating a three-axis magnetic sensor 50d of a fourth exemplified variation. In the fourth exemplified variation, Y-axis GMR elements and Z-axis GMR elements are changed in arrangement relationship. More specifically, as illustrated in Fig. 16D, a first Y-axis GMR element 54e is arranged on the right of approximately an intermediate portion from the X-axis central portion to the X-axis left end portion in the vicinity of the Y-axis upper end portion of the substrate 54, and a second Y-axis GMR element 54f is arranged left thereof Further, a third Y-axis GMR element 54g is arranged on the right of approximately an intermediate portion from the X-axis central portion to the X-axis right end portion in the vicinity of the Y-axis upper end portion of the substrate 54, and a fourth Y-axis GMR element 54h is arranged left thereof Still further, a first Z-axis GMR element 54i is arranged at approximately an intermediate portion from the Y-axis central portion of the substrate 54 to the Y-axis upper end portion or left at approximately an intermediate portion from the X-axis central portion to the X-axis right end portion, and the second Z-axis GMR element 54j is arranged right thereof A third Z-axis GMR element 54k is ' arranged at approximately an intermediate portion from the Y-axis central portion of the substrate 54 to the Y-axis lower end portion or left at approximately an intermediate portion from the X-axis central portion to the X-axis left end portion, and a fourth Z-axis GMR element 541 is arranged right thereof. Here, the X-axis GMR elements 54a to 54d are the same as the X-axis GMR elements 21 to 24 in the above-described first embodiment.

(Second embodiment)

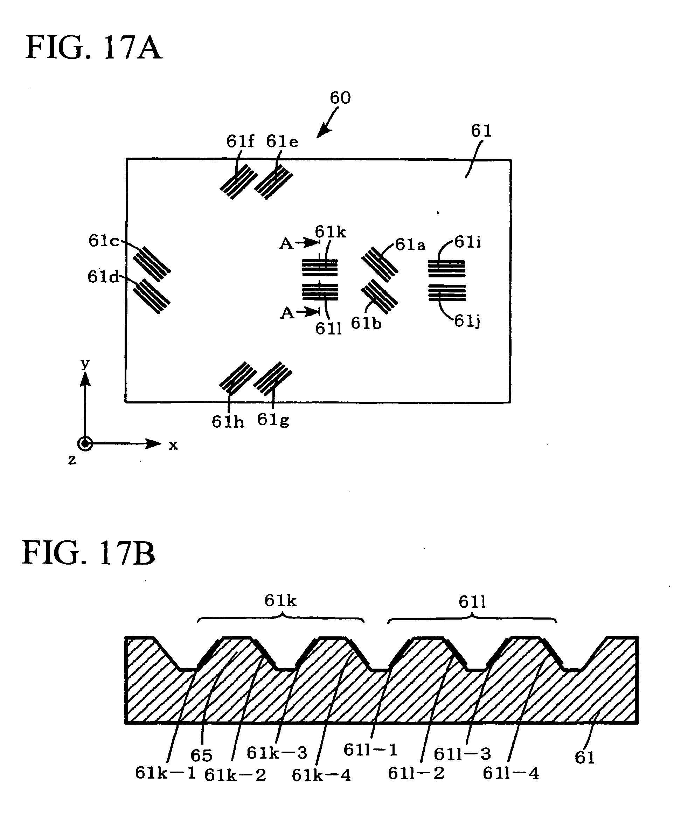

Next, an explanation will be made of a three-axis magnetic sensor of a second embodiment as follows by referring to Fig. 17A to Fig. 20C.

As illustrated in Fig. 17A and 17B, a three-axis magnetic sensor 60 of the second embodiment is provided with a substrate 61 made with quartz or silicon which is in a rectangular shape with the sides along the X-axis and Y-axis orthogonal to each other, when viewed from above (here, it is shaped so that the ratio of the short side (longitudinal), to the long side (transverse) (aspect ratio) is 1 : 1.5 and the side along the X-axis is a long side and the side along the Y-axis is a short side) and has a small thickness in the direction of the Z-axis orthogonal to the X-axis and the Y-axis. It is possible to make the present sensor smaller in dimension than the three-axis magnetic sensor of the first embodiment by using the above-described substrate 61.

Then, a total of 12 GMR elements made up of respectively four elements of X-axis GMR elements 61a to 61d, Y-axis GMR elements 6 1 e to 61 h and Z-axis GMR elements 61i to 611, a total of 12 pads (not illustrated) and connecting wires (not illustrated) connecting each of the pads with each of the elements are fabricated into the substrate 61. An LSI and a wiring layer are also fabricated on the substrate 61 as with the substrate 11 of the first embodiment. A substrate into which the LSI is fabricated is used to provide a magnetic sensor based on a digital output, while a substrate into which only the wiring layer is fabricated is used to provide a magnetic sensor based on an analog output.

Here, the X-axis GMR elements are constituted with a first X-axis GMR element 61a, a second X-axis GMR element 61b, a third X-axis GMR element 61c and a fourth X-axis GMR element 61d. Then, the first X-axis GMR element 61a is arranged at approximately a 2/3 portion from the X-axis left end portion of the substrate 61 to the right end portion or above the Y-axis central portion, and the second X-axis GMR element 61b is arranged below thereof Further, the third X-axis GMR element 61c is arranged above the Y-axis central portion in the vicinity of the X-axis left end portion of the substrate 61, and the fourth X-axis GMR element 61d is arranged below thereof.

Further, the Y-axis GMR elements are constituted with a first Y-axis GMR element 61e, a second Y-axis GMR element 61f, a third Y-axis GMR element 61g and a fourth Y-axis GMR element 61h. Then, the first Y-axis GMR element 61e is arranged on the right at approximately a 1/3 portion from the X-axis left end portion to the right end portion in the vicinity of the Y-axis upper end portion of the substrate 61, and the second Y-axis GMR element 61f is arranged left thereof. Further, the third Y-axis GMR element 61g is arranged on the right of approximately a 1/3 portion from the X-axis left end portion to the right end portion in the vicinity of the Y-axis lower end portion of the substrate 61, and the fourth Y-axis GMR element 61h is arranged left thereof.

In addition, the Z-axis GMR elements are constituted with a first Z-axis GMR element 61i, a second Z-axis GMR element 61j, a third Z-axis GMR element 61k and a fourth Z-axis GMR element 611. Then, the first Z-axis GMR element 61i is arranged at an intermediate portion between approximately a 2/3 portion from the X-axis left end portion of the substrate 61 to the right end portion and the right end portion or above the Y-axis central portion, and the second Z-axis GMR element 61j is arranged below thereof Further, the third Z-axis GMR element 61 k is arranged at an intermediate portion between approximately a 1/3 portion from the X-axis left end portion of the substrate 61 to the right end portion and a 2/3 portion or above the Y-axis central portion, and the fourth Z-axis GMR element 611 is arranged below thereof.

Each of the GMR elements 61a to 61d, 61 e to 61 h and 61i to 611 is provided with four GMR bars mutually parallel and arranged adjacently in a band form, these four GMR bars are connected in series by magnet films (bias magnet films), and magnet films which will act as a terminal are connected to these ends.

Here, each of the GMR bars of the X-axis GMR elements 61a to 61d is formed on a flat surface parallel to the surface of a substrate 61 and arranged in such a way that the longitudinal direction gives an angle of 45 degrees with respect to the X-axis. Further, each of the GMR bars of the Y-axis GMR elements 61e to 61h is formed on a flat surface parallel to the surface of the substrate 61 and arranged in such a way that the longitudinal direction is orthogonal to each of the GMR bars of the X-axis GMR elements 61 a to 61 d.

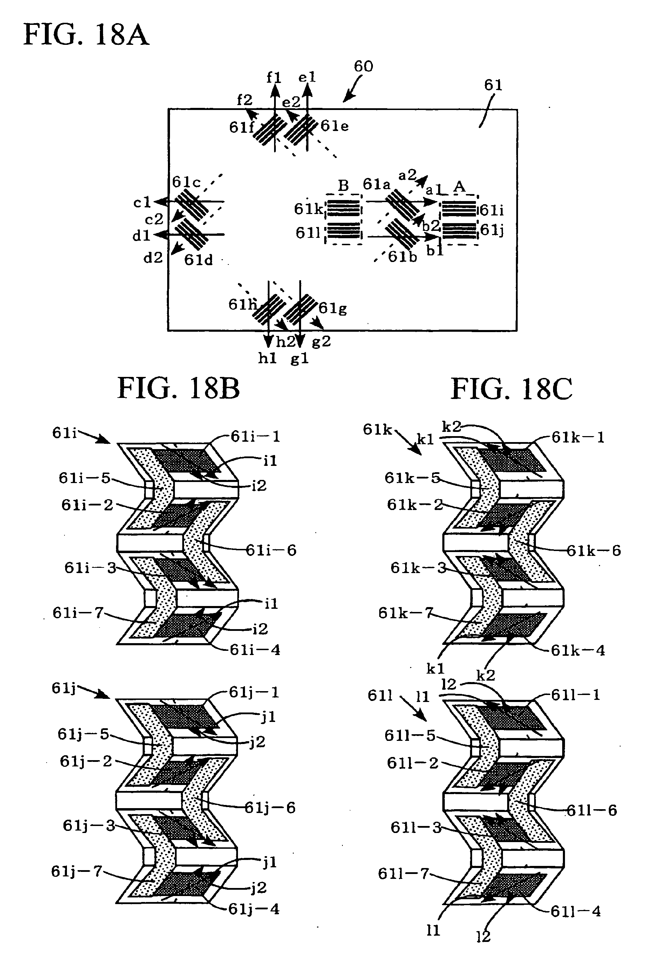

Further, as illustrated in Fig. 17B, Fig. 18B and 18C, each of the GMR bars of the Z-axis GMR elements 61i to 61l is arranged in such a way that one GMR bar (61 i-1, 61 i-2, 61i-3 or 61i-4 (61j-1, 61j-2, 61j-3 and 61j4) or 61k-1, 61k-2, 61k-3 and 61k-4 (61l-1, 61l-2, 61l-3 and 61l-4)) per tilted surface (so as to give a tilted angle of approximately 45 degrees) is formed on each tilted surface of a plurality of projections (ledge portions) 65 formed on the substrate 61 and the cross section of which is in a trapezoidal shape, with the longitudinal direction being parallel to the X-axis and vertical to the Y-axis.

The three-axis magnetic sensor 60 of the second embodiment is different from the three-axis magnetic sensor 10 of the first embodiment in that the substrate 61 is 2/3 in dimension as compared with the substrate 11 of the first embodiment and the Z-axis GMR elements 61 i to 61l are different in arrangement position, but similar in other constitutions to the three-axis magnetic sensor 10 of the first embodiment.

Here, in the X-axis GMR elements 61a and 61b, a bias magnet film imparts a bias magnetic field in a direction parallel to the longitudinal direction of each of the GMR bars (the direction tilted at -45 degrees with respect to a position direction of the X-axis). Then, a pinned layer is formed in such a way that the magnetization direction (magnetization vector) is pinned (bonded) in a positive direction of the X-axis (in the direction given by the solid-line arrows a1 and b1 in Fig. 18A). Further, in the third X-axis GMR element 61c and the fourth X-axis GMR element 61d, the bias magnet film imparts a bias magnetic field in a direction parallel to the longitudinal direction of each of the GMR bars (in the direction tilted at 45 degrees with respect to a negative direction of the X-axis). The pinned layer is formed in such a way that the magnetization direction (magnetization vector) is pinned (bonded) in a negative direction of the X-axis (in the direction given by the solid-line arrows c1 and d1 in Fig. 18A and opposite 180 degrees to the magnetization direction of the first X-axis GMR element 61a and the second X-axis GMR element 61b).

Therefore, in the first X-axis GMR element 61a and the second X-axis GMR element 61b, the sensitivity direction of a magnetic field is a direction vertical to the longitudinal direction of each of the GMR bars, namely, the direction tilted at 45 degrees with respect to a positive direction of the X-axis (the direction given by the broken-line arrows a2 and b2 in Fig. 18A). In contrast, in the third X-axis GMR element 61 c and the fourth X-axis GMR element 61d, the sensitivity direction of a magnetic field is a direction vertical to the longitudinal direction of each of the GMR bars, namely, the direction tilted at 45 degrees with respect to a negative direction of the X-axis (the direction given by the broken-line arrows c2 and d2 in Fig. 18A and opposite 180 degrees to the sensitivity direction of the first X-axis GMR element 61a and the second X-axis GMR element 61b.

Further, in the first Y-axis GMR element 61e and the second Y-axis GMR element 61f, a bias magnet film imparts a bias magnetic field in a direction parallel to the longitudinal direction of each of the GMR bars (the direction tilted at 45 degrees with respect to a positive direction of the X-axis, namely, the direction in which the bias magnetic field of the X-axis GMR elements 61a and 61b is turned counterclockwise 90 degrees). Then, a pinned layer is formed in such a way that the magnetization direction (magnetization vector) is pinned (bonded) in a positive direction of the Y-axis (the direction given by the solid-line arrows e1 and f1 in Fig. 18A). In contrast, in the third Y-axis GMR element 61g and the fourth Y-axis GMR element 61h, the bias magnet film imparts a bias magnetic field in the direction opposite 180 degrees to the first Y-axis GMR element 61e and the second Y-axis GMR element 61f and parallel to the longitudinal direction of each of the GMR bars (the direction tilted at -45 degrees with respect to a negative direction of the X-axis). Then, the pinned layer is formed in such a way that the magnetization direction (magnetization vector) is pinned (bonded) in a negative direction of the Y-axis (the direction given by the solid-line arrows g1 and h1 in Fig. 18A).

Therefore, in the first Y-axis GMR element 61e and the second Y-axis GMR element 61f, the sensitivity direction of a magnetic field is a direction vertical to the longitudinal direction of each of the GMR bars, namely, the direction tilted at -45 degrees with respect to a negative direction of the X-axis (the direction given by the broken-line arrows e2 and f2 in Fig. 18A). In contrast, in the third Y-axis GMR element 61g and the fourth Y-axis GMR element 61h, the sensitivity direction is a direction vertical to the longitudinal direction of each of the GMR bars, namely, the direction tilted at -45 degrees with respect to a positive direction of the X-axis (the direction given by the broken-line arrows g2 and h2 in Fig. 18A and opposite 180 degrees to the magnetization direction of the first Y-axis GMR element 61e and the second Y-axis GMR element 61f).

Further, in the first Z-axis GMR element 61i and the second Z-axis GMR element 61j, as schematically illustrated in Fig. 18B, the bias magnet films 61i-5, 61 i-6 and 6 1 i-7 (61j-5, 61j-6 and 61j-7) impart a bias magnetic field in a direction parallel to the longitudinal direction of each of the GMR bars 61i-1, 61i-2, 61i-3 and 61i-4 (61j-1, 61j-2, 61j-3 and 61j-4), namely, on a flat surface of each tilted surface (the tilted angle is approximately 45 degrees) of projections (ledge portions) 65, a direction in which the longitudinal direction is parallel to the X-axis and vertical to the Y-axis. Then, a pinned layer is formed in such a way that the magnetization direction (magnetization vector) is pinned (bonded) in the direction tilted at 45 degrees from a positive direction of the X-axis to a positive direction of the Z-axis inside each tilted surface of the projections (ledge portions) 65 (the direction given by the solid-line arrows i1 (j1) in Fig. 18B).

Then, these GMR bars, 61i-1, 6 1 i-2, 61 i-3 and 6 1 i-4 (61j-1, 61 j-2, 61j-3 and 61j-4) are connected in series with the bias magnet films 61i-5, 61 i-6 and 61 i-7 (61j-5, 61j-6 and 61j-7). Thereby, the sensitivity direction of a magnetic field is a direction vertical to the longitudinal direction of each of the GMR bars, namely, the direction given by the broken-line arrows i2 (j2) in Fig. 18B having a positive component of the Z-axis (the direction moving from the back to the front on the page space). Where a magnetic field is applied in the direction given by the broken-line arrows i2 (j2) in Fig. 18B, resistance values of the first Z-axis GMR element 61i and the second Z-axis GMR element 61j will decrease proportionally with an increase in magnetic field. Where the magnetic field is applied in the direction opposite that given by the broken-line arrows i2 (j2) in Fig. 18B, resistance values of the first Z-axis GMR element 61i and the second Z-axis GMR element 61j will increase proportionally with an increase in magnetic field.

In contrast, in the third Z-axis GMR element 61 k and the fourth Z-axis GMR element 611, as schematically illustrated in Fig. 18C, the bias magnet films 61k-5, 61k-6 and 61k-7 (611-5, 611-6 and 611-7) impart a bias magnetic field in a direction parallel to the longitudinal direction of each of the GMR bars 61k-1, 61k-2, 61k-3 and 61k-4 (611-1, 6112, 611-3 and 611-4), namely, on a flat surface of each tilted surface (the tilted angle is approximately 45 degrees) of projections (ledge portions) 65, or a direction in which the longitudinal direction is parallel to the X-axis and vertical to the Y-axis. Then, a pinned layer is formed in such a way that the magnetization direction (magnetization vector) is pinned (bonded) in the direction tilted at 45 degrees from a positive direction of the X-axis to a negative direction of the Z-axis inside each tilted surface of the projections (ledge portions) 65 (the direction given by the solid-line arrows k1 (11) in Fig. 18C).

Then, these GMR bars, 61k-1, 61k-2, 61k-3 and 61k-4 (611-1, 611-2, 611-3 and 611-4) are connected in series with the bias magnet films 61k-5, 61k-6 and 61k-7 (611-5, 611-6 and 611-7). Thereby, the sensitivity direction of a magnetic field is a direction vertical to the longitudinal direction of each of the GMR bars, namely, the direction given by the broken-line arrows i2 (j2) in Fig. 18B having a negative component of the Z-axis (the direction moving from the back to the front on the page space). Where a magnetic field is applied in the direction given by the broken-line arrows k2 (12) in Fig. 18C, resistance values of the third Z-axis GMR element 61k and the fourth Z-axis GMR element 611 will decrease proportionally with an increase in magnetic field. Where the magnetic field is applied in the direction opposite that given by the broken-line arrows k2 (12) in Fig. 18C, resistance values of the third Z-axis GMR element 61k and the fourth Z-axis GMR element 611 will increase proportionally with an increase in magnetic field.

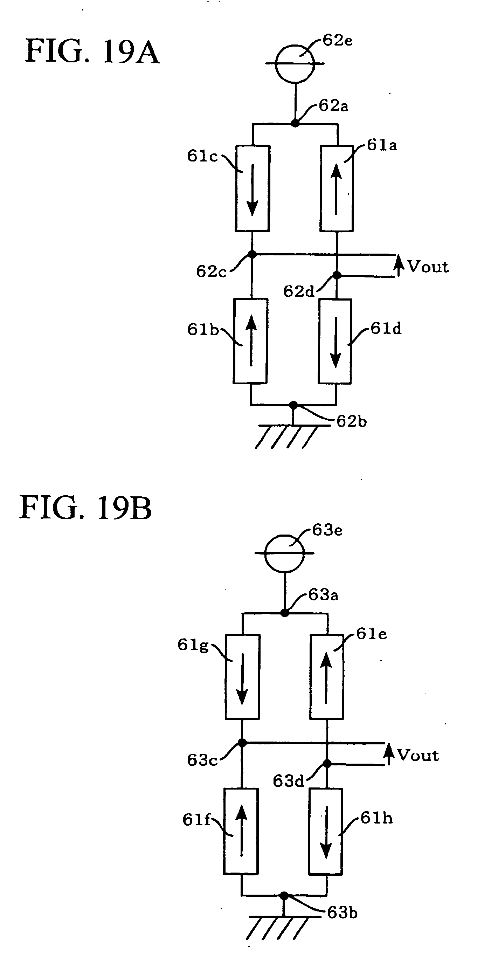

As an equivalent circuit illustrated in Fig. 19A, the X-axis magnetic sensor is constituted with the first X-axis GMR element 61 a to the fourth X-axis GMR element 61d, which are full-bridge-connected. In Fig. 19A, the arrows indicate the magnetization direction of a bonded layer on which each of the GMR elements 61a to 64d is pinned. In the above constitution, a pad 62a and a pad 62b are connected to a positive electrode and a negative electrode of a constant voltage source 62e, thereby imparting a potential Vxin+ (3V in this embodiment) and a potential Vxin- (0(V) in this embodiment). Then, potentials of a pad 62c and a pad 62d are output respectively as a potential Vxout+ and a potential Vxout-, and a potential difference between them (Vxout+ - Vxout-) is output as a sensor output Vxout.

As an equivalent circuit illustrated in Fig. 19B, the Y-axis magnetic sensor is constituted with the first Y-axis GMR element 61e to the fourth Y-axis GMR element 61h, which are full-bridge-connected. Then, a pad 63a and a pad 63b are connected to a positive electrode and a negative electrode of a constant voltage source 63e, thereby imparting a potential Vyin+ (3V in this embodiment) and a potential Vyin- (0(V) in this embodiment), and a potential difference between a pad 63c and a pad 63d is output as a sensor output Vyout.

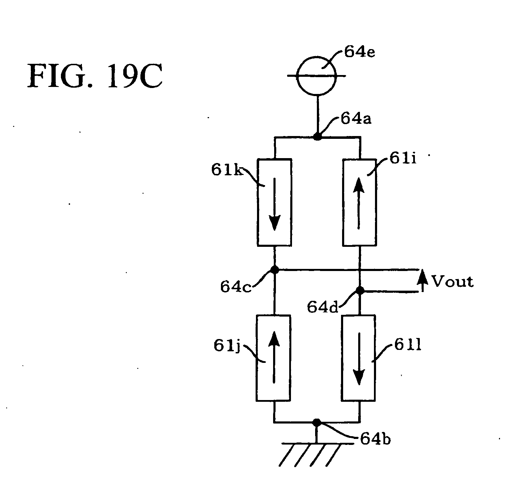

As an equivalent circuit illustrated in Fig. 19c, the Z-axis magnetic sensor is constituted with the first Z-axis GMR element 61i to the fourth Z-axis GMR element 611, which are full-bridge-connected. Then, a pad 64a and a pad 64b are connected to a positive electrode and a negative electrode of a constant voltage source 64e, thereby imparting a potential Vyin+ (3V in this embodiment) and a potential Vyin- (0(V) in this embodiment), and a potential difference between a pad 64c and a pad 64d is output as a sensor output Vyout.

Since the three-axis magnetic sensor 60 of the second embodiment is manufactured by a method similar to that for the three-axis magnetic sensor 10 of the first embodiment, an explanation for the method will be omitted here. However, a brief explanation will be made as follows for heat treatment for regularization (pinning treatment).

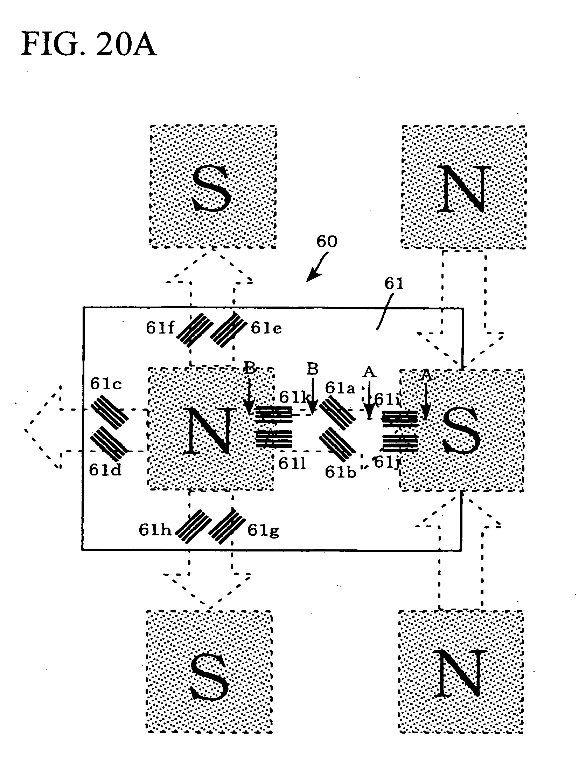

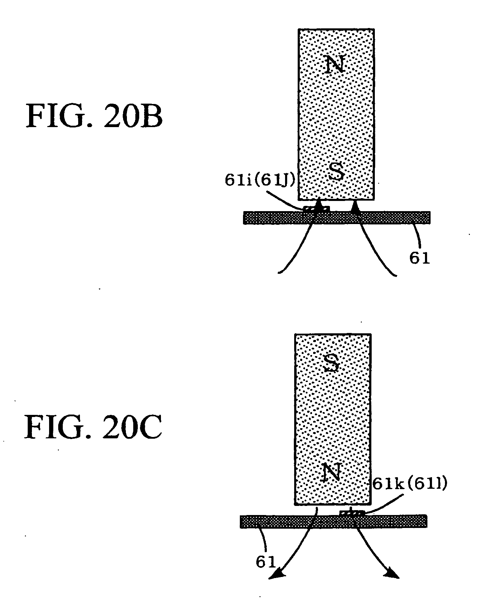

As schematically illustrated in Fig. 20 A to 20C, in the heat treatment for regularization (pinning treatment) for manufacturing the three-axis magnetic sensor 60 of the second embodiment, a permanent bar magnet array (magnet array) is prepared, which is arranged in a lattice form so as to be mutually different in polarity from the upper end (lower end) of adjacent permanent bar magnet pieces.

Thereby, an N pole is arranged, with the center given to a point where a line dividing the long side of a substrate 61 at a 1/3 portion intersects with a line dividing the short side of the substrate 61 at a 1/2 portion, and S poles are arranged at positions symmetrical to the four directions (above, below, right and left), with the center given to the N pole. The S poles above and below and either of the left S pole or the right S pole are arranged outside the substrate 61. The remaining S pole is arranged with the center placed on the short side of the substrate 61. Thereby, as illustrated in Fig. 18A to 18C, a magnetic field in a positive direction of the X-axis is imparted to the first X-axis GMR element 61a and the second X-axis GMR element 61b. A magnetic field in a negative direction of the X-axis is imparted to the third X-axis GMR element 61c and the fourth X-axis GMR element 61d.

Further, a magnetic field in a positive direction of the Y-axis is imparted to the first Y-axis GMR element 61e and the second Y-axis GMR element 61f, while a magnetic field in a negative direction of the Y-axis is imparted to the third Y-axis GMR element 61g and the fourth Y-axis GMR element 61h. In addition, a magnetic field in the direction tilted at 45 degrees from a positive direction of the X-axis to a positive direction of the Z-axis inside a tilted surface of each of the projections (ledge portions) 65 is imparted to the first Z-axis GMR element 61i and the second Z-axis GMR element 61j. A magnetic field in the direction tilted at 45 degrees from a positive direction of the X-axis to a negative direction of the Z-axis inside the tilted surface of each of the projections (ledge portions) 65 is imparted to the fourth Z-axis GMR element 61 k and the fourth Z-axis GMR element 611.

Fig. 20A to 20C illustrate an example where the S pole is on the right short side of the substrate 61. In the present embodiment, in a substrate adjacent to the right, the S pole is arranged on the left short side of the substrate. When this substrate is turned 180 degrees, the output symbols are reverse to those obtained in Fig. 20A to 20C.

Further, in all the embodiments to be described later, the polarity is inevitably reversed in some of the adjacent chips.

(Third embodiment)

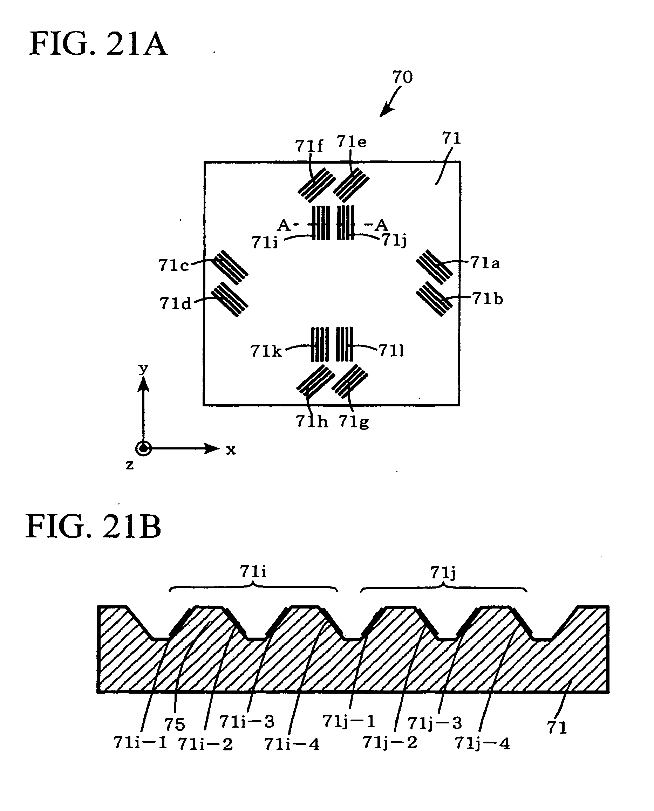

Then, an explanation will be made of the three-axis magnetic sensor of a third embodiment as follows by referring to Fig. 21A to Fig. 24B.

As illustrated in Fig. 21A and 21B, a three-axis magnetic sensor 70 of the third embodiment is provided with a substrate 71 made with quartz or silicon which is in a square shape having the sides along the X-axis and Y-axis orthogonal to each other, when viewed from above, (namely, half in dimension as compared with the substrate 11 of the first embodiment) and has a small thickness in the direction of the Z-axis orthogonal to the X-axis and the Y-axis. It is possible to make the present sensor smaller in dimension than the three-axis magnetic sensor of the first embodiment and that of the second embodiment by using the above-described substrate 71.

Then, a total of ten GMR elements, namely, four each of the X-axis GMR elements 71a to 71d and the Y-axis GMR elements 7 1 e to 71h and two Z-axis GMR elements 71i to 71j formed on a substrate 71, two non-magnetic resistors 7 1 k to 711, a total of 12 pads (not illustrated) formed on the substrate 71 and connecting wires (not illustrated) connecting each of the pads with each of the elements are fabricated. An LSI and a wiring layer are also fabricated into the substrate 71, as with the substrate 11 of the first embodiment. A substrate into which the LSI is fabricated is used to provide a magnetic sensor based on a digital output, while a substrate into which only the wiring layer is fabricated is used to provide a magnetic sensor based on an analog output.

Here, the X-axis GMR elements are constituted with a first X-axis GMR element 71a, a second X-axis GMR element 71b, a third X-axis GMR element 71c and a fourth X-axis GMR element 71d. Then, the first X-axis GMR element 71a is arranged above the Y-axis central portion in the vicinity of the X-axis right end portion, and the second X-axis GMR element 71b is arranged below thereof Further, the third X-axis GMR element 71c is arranged above the Y-axis central portion in the vicinity of the X-axis left end portion, and the fourth X-axis GMR element 71d is arranged below thereof.

Further, the Y-axis GMR elements are constituted with a first Y-axis GMR element 71e, a second Y-axis GMR element 71f, a third Y-axis GMR element 71g and a fourth Y-axis GMR element 71h. Then, the first Y-axis GMR element 71e is arranged on the right of the X-axis central portion in the vicinity of the Y-axis upper end portion, and the second Y-axis GMR element 71f is arranged left thereof Further, the third Y-axis GMR element 71g is arranged on the right of the X-axis central portion in the vicinity of the Y-axis lower end portion, and the fourth Y-axis GMR element 71h is arranged left thereof.

In addition, the Z-axis GMR elements are constituted with a first Z-axis GMR element 71i and a second Z-axis GMR element 71j as well as a first non-magnetic resistor 71k and a second non-magnetic resistor 711 for bridge-connecting them. Then, the first Z-axis GMR element 71i is arranged at an intermediate portion from the Y-axis central portion to the Y-axis upper end portion or left at the X-axis central portion, and the second Z-axis GMR element 71j is arranged right thereof Further, the first non-magnetic resistor 71k is arranged at an intermediate portion from the Y-axis central portion to the Y-axis lower end portion or left at the X-axis central portion, and the second non-magnetic resistor 711 is arranged right thereof.

Each of the GMR elements 71a to 71d, 71e to 71h and 71i and 71j is provided with four GMR bars mutually parallel and arranged adjacently in a band form, these four GMR bars are connected in series by magnet films (bias magnet films), and the magnet films which will act as a terminal are connected to these ends.

Here, each of the GMR bars of the X-axis GMR elements 71 a to 7 1 d is formed on a flat surface parallel to the surface of a substrate 71 and arranged in such a way that the longitudinal direction gives an angle of 45 degrees with respect to the X-axis. Further, each of the GMR bars of the Y-axis GMR elements 71e to 71h is formed on a flat surface parallel to the surface of the substrate 71 and arranged in such a way that the longitudinal direction intersects with each of the GMR bars of the X-axis GMR elements 71 a to 71 d (here, to be orthogonal).

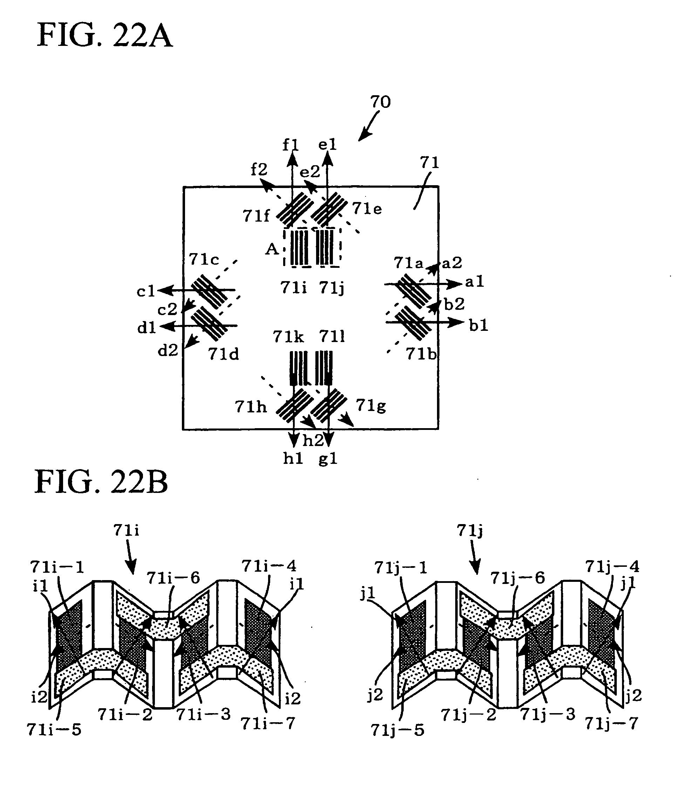

Further, as illustrated in Fig. 21B and Fig. 22B, each of the GMR bars of the Z-axis GMR elements 71i and 71j is arranged in such a way that one GMR bar (71i-1, 71 i-2, 71i-3 or 7 1 i-4 (71j-1, 71j-2, 71j-3 or 71j-4)) per tilted surface (so as to give a tilted angle of approximately 45 degrees) is formed on each tilted surface of a plurality of projections (ledge portions) 75 formed on the substrate 71 and the cross section of which is in a trapezoidal shape, with the longitudinal direction being parallel to the X-axis and vertical to the Y-axis. Further, the non-magnetic resistors 71k to 71l are formed on a flat surface parallel to the surface of the substrate 71 and arranged in such a way that the longitudinal direction is vertical to the X-axis and parallel to the Y-axis.

The three-axis magnetic sensor 70 of the third embodiment is different from the three-axis magnetic sensor 10 of the first embodiment in that the substrate 71 is square in shape and half in dimension as compared with the substrate 11 of the first embodiment and provided with two Z-axis GMR elements 71i to 71j and two non-magnetic resistors 71k to 71l, but similar in other constitutions to the three-axis magnetic sensor 10 of the first embodiment.

Here, in the X-axis GMR elements 71a and 71b, a bias magnet film imparts a bias magnetic field in a direction parallel to the longitudinal direction of each of the GMR bars (the direction tilted at 45 degrees with respect to a positive direction of the X-axis). Then, a pinned layer is formed in such a way that the magnetization direction (magnetization vector) is pinned (bonded) in a positive direction of the X-axis (in the direction given by the solid-line arrows a1 and b1 in Fig. 17A). Further, in the third X-axis GMR element 71c and the fourth X-axis GMR element 71d, the bias magnet film imparts a bias magnetic field in a direction parallel to the longitudinal direction of each of the GMR bars (in the direction tilted at 45 degrees with respect to a negative direction of the X-axis).

The pinned layer is formed in such a way that the magnetization direction (magnetization vector) is pinned (bonded) in a negative direction of the X-axis (in the direction given by the solid-line arrows c1 and d1 in Fig. 17A and opposite 180 degrees to the magnetization direction of the first X-axis GMR element 71a and the second X-axis GMR element 71b).

Therefore, in the first X-axis GMR element 71a and the second X-axis GMR element 71b, the sensitivity direction of a magnetic field is a direction vertical to the longitudinal direction of each of the GMR bars, namely, the direction tilted at -45 degrees with respect to a positive direction of the X-axis (the direction given by the broken-line arrows a2 and b2 in Fig. 22A). In contrast, in the third X-axis GMR element 71c and the fourth X-axis GMR element 71d, the sensitivity direction of a magnetic field is a direction vertical to the longitudinal direction of each of the GMR bars, namely, a direction tilted at -45 degrees with respect to a negative direction of the X-axis (the direction given by the broken-line arrows c2 and, d2 in Fig. 22A and opposite 180 degrees to the sensitivity direction of the first X-axis GMR element 71a and the second X-axis GMR element 71b).

Further, in the first Y-axis GMR element 71e and the second Y-axis GMR element 71f, a bias magnet film imparts a bias magnetic field in a direction parallel to the longitudinal direction of each of the GMR bars (the direction tilted at -45 degrees with respect to a position direction of the X-axis, namely, the direction in which the bias magnetic field of the X-axis GMR elements 71a and 71b is turned counterclockwise 90 degrees). Then, a pinned layer is formed in such a way that the magnetization direction (magnetization vector) is pinned (bonded) in a positive direction of the Y-axis (the direction given by the solid-line arrows e1 and f1 in Fig. 22A). In contrast, in the third Y-axis GMR element 71g and the fourth Y-axis GMR element 71h, the bias magnet film imparts a bias magnetic field in the direction opposite 180 degrees to the first Y-axis GMR element 71e and the second Y-axis GMR element 71f and parallel to the longitudinal direction of each of the GMR bars (the direction tilted at -45 degrees with respect to a negative direction of the X-axis). Then, the pinned layer is formed in such a way that the magnetization direction (magnetization vector) is pinned (bonded) in a negative direction of the Y-axis (the direction given by the solid-line arrows g1 and h1 in Fig. 22A).

Therefore, in the first Y-axis GMR element 71e and the second Y-axis GMR element 71f, the sensitivity direction of a magnetic field is a direction vertical to the longitudinal direction of each of the GMR bars, namely, the direction tilted at -45 degrees with respect to a positive direction of the Y-axis (the direction given by the broken-line arrows e2 and f2 in Fig. 22A). In contrast, in the third Y-axis GMR element 71g and the fourth Y-axis GMR element 71h, the sensitivity direction is a direction vertical to the longitudinal direction of each of the GMR bars, namely, the direction tilted at -45 degrees with respect to a negative direction of the Y-axis (the direction given by the broken-line. arrows g2 and h2 in Fig. 22A and opposite 180 degrees to the magnetization direction of the first Y-axis GMR element 71e and the second Y-axis GMR element 71f).

Further, in the first Z-axis GMR element 71i and the second Z-axis GMR element 71j, as schematically illustrated in Fig. 22B, the bias magnet films 71i-5, 71i-6 and 71i-7 (71j-5, 71j-6 and 71j-7) impart a bias magnetic field in a direction parallel to the longitudinal direction of each of the GMR bars 71i-1, 71i-2, 71i-3 and 71i-4 (71j-1, 71j-2, 71j-3 and 71j-4), namely, on a flat surface of each tilted surface (the tilted angle is approximately 45 degrees) of projections (ledge portions) 75, a direction in which the longitudinal direction is vertical to the X-axis and parallel to the Y-axis. Then, a pinned layer is formed in such a way that the magnetization direction (magnetization vector) is pinned (bonded) in a direction tilted at 45 degrees from a positive direction of the Y-axis to a negative direction of the Z-axis inside each tilted surface of the projections (ledge portions) 75 (the direction given by the solid-line arrow i1 in Fig. 22B).

Then, these GMR bars, 71i-1, 71i-2, 71i-3 and 71i-4 (71j-1, 71j-2, 71j-3 and 71j-4) are connected in series with the bias magnet films 71i-5, 71 i-6 and 71 i-7 (71j-5, 71j-6 and 71j-7). Thereby, the sensitivity direction of a magnetic field is a direction vertical to the longitudinal direction of each of the GMR bars, a negative direction of the Z-axis, namely, the direction given by the broken-line arrow i2 in Fig. 22B (the direction moving from the back to the front on the page space). Where a magnetic field is applied in the direction given by the broken-line arrows i2 in Fig. 22B, resistance values of the first Z-axis GMR element 71i and the second Z-axis GMR element 71j will decrease proportionally with an increase in magnetic field. Where the magnetic field is applied in the direction opposite that given by the broken-line arrows i2 in Fig. 22B, resistance values of the first Z-axis GMR element 71i and the second Z-axis GMR element 71j will increase proportionally with an increase in magnetic field.

In contrast, the first non-magnetic resistor 71 k and the second non-magnetic resistor 71k are made with a non-magnetic body such as polysilicon. Further, in the third embodiment, the first non-magnetic resistor 71k is arranged at approximately a 1/4 portion in a positive direction of the Y-axis or left at approximately the X-axis central portion, and the second non-magnetic resistor 711 is arranged right thereof. However, the first non-magnetic resistor 71k and the second non-magnetic resistor 711 may be arranged at any place on the substrate 71.

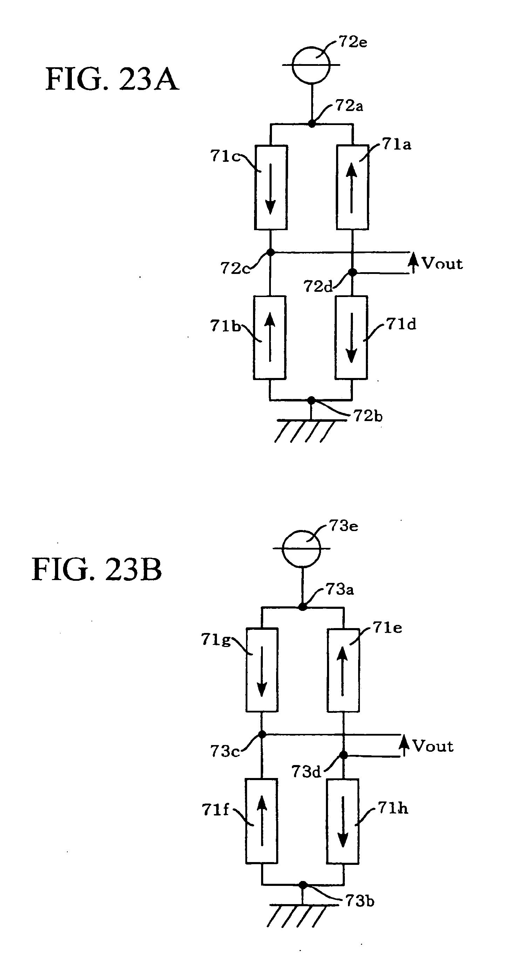

As an equivalent circuit illustrated in Fig. 23A, the X-axis magnetic sensor is constituted with the first X-axis GMR element 71a to the fourth X-axis GMR element 71d, which are full-bridge-connected. In Fig. 23A, the arrows indicate the magnetization direction of a bonded layer on which each of the GMR elements 71a to 74d is pinned. In the above constitution, a pad 72a and a pad 72b are connected to a positive electrode and a negative electrode of a constant voltage source 72e, thereby imparting a potential Vxin+ (3V in this embodiment) and a potential Vxin- (0(V) in this embodiment). Then, potentials of a pad 72c and a pad 72d are output respectively as a potential Vxout+ and a potential Vxout-, and a potential difference between them (Vxout+ - Vxout-) is output as a sensor output Vxout.

As an equivalent circuit illustrated in Fig. 23B, the Y-axis magnetic sensor is constituted with the first Y-axis GMR element 71e to the fourth Y-axis GMR element 71h, which are full-bridge-connected. Then, a pad 73a and a pad 73b are connected to a positive electrode and a negative electrode of a constant voltage source 73e, thereby imparting a potential Vyin+ (3V in this embodiment) and a potential Vyin- (0(V) in this embodiment), and a potential difference between a pad 73c and a pad 73d is output as a sensor output Vyout.

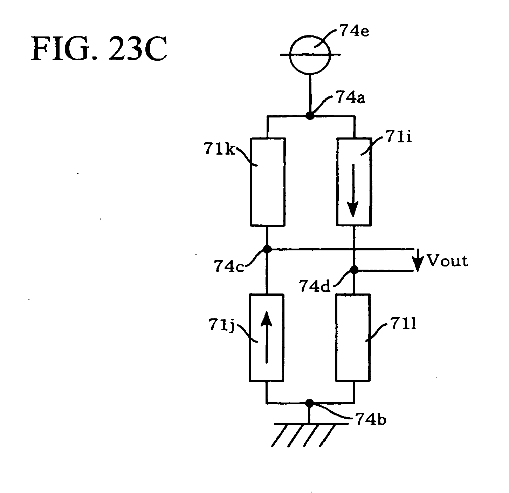

As an equivalent circuit illustrated in Fig. 23C, the Z-axis magnetic sensor is constituted with the first Z-axis GMR element 71i, the second Z-axis GMR element 71j, the first non-magnetic resistor 71k, and the second non-magnetic resistor 711, which are full-bridge-connected. Then, a pad 74a and a pad 74b are connected to a positive electrode and a negative electrode of a constant voltage source 74e, thereby imparting a potential Vyin+ (3V in this embodiment) and a potential Vyin- (0(V) in this embodiment). Further, a potential difference between a pad 74c and a pad 74d is output as a sensor output Vyout.

Since the three-axis magnetic sensor 70 of the third embodiment is manufactured by a method similar to that for the three-axis magnetic sensor 10 of the first embodiment excluding fabrication of the first non-magnetic resistor 71k and the second non-magnetic resistor 711, an explanation for the method will be omitted here. However, a brief explanation will be made as follows for heat treatment for regularization (pinning treatment).

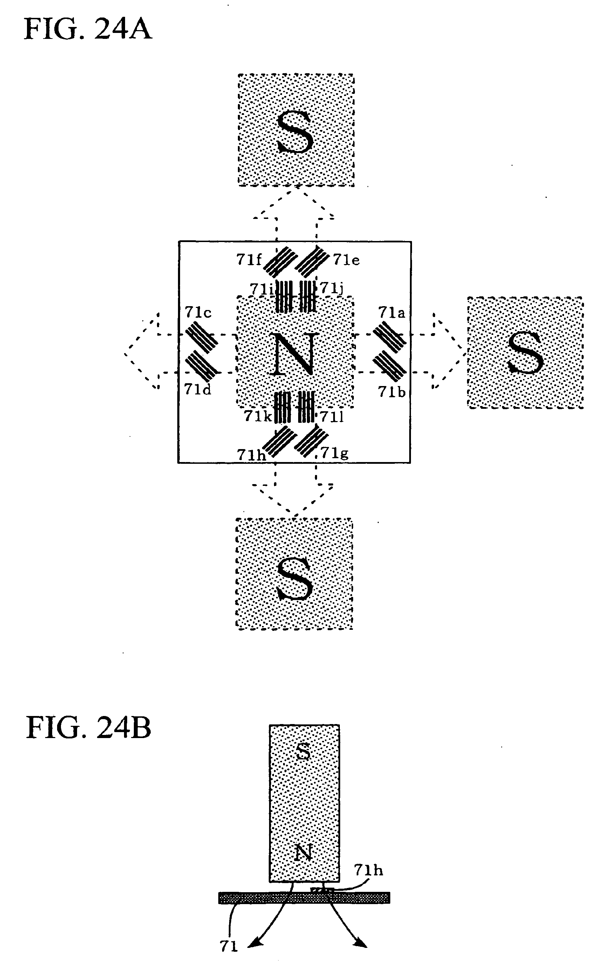

As schematically illustrated in Fig. 24A and Fig. 24B, in the heat treatment for regularization (pinning treatment) for manufacturing the three-axis magnetic sensor 70 of the third embodiment, a permanent bar magnet array (magnet array) is prepared, which is arranged in a lattice form so as to be mutually different in polarity of the upper end (lower end) of adjacent permanent bar magnet pieces. Thereby, an N pole is arranged above the center of the substrate 71, and S poles are arranged above outside a substrate 71 at positions symmetrical to four directions (above, below, right and left), with the center given to the N pole.

Thereby, as illustrated in Fig. 22A and Fig. 22B, a magnetic field in a positive direction of the X-axis is imparted to the first X-axis GMR element 71a and the second X-axis GMR element 71b. A magnetic field in a negative direction of the X-axis is imparted to the third X-axis GMR element 71 c and the fourth X-axis GMR element 71d. Further, a magnetic field in a positive direction of the Y-axis is imparted to the first Y-axis GMR element 71e and the second Y-axis GMR element 71f, and a magnetic field in a negative direction of the Y-axis is imparted to the third Y-axis GMR element 71g and the fourth Y-axis GMR element 71 h. In addition, a magnetic field in the direction tilted at 45 degrees from a positive direction of the Y-axis to a negative direction of the Z-axis inside a tilted surface of each of the projections (ledge portions) 75 (the direction moving from the back to the front in Fig. 22A and Fig. 22B) is imparted to the first Z-axis GMR element 71 and the second Z-axis GMR element 71j.

(Fourth embodiment)

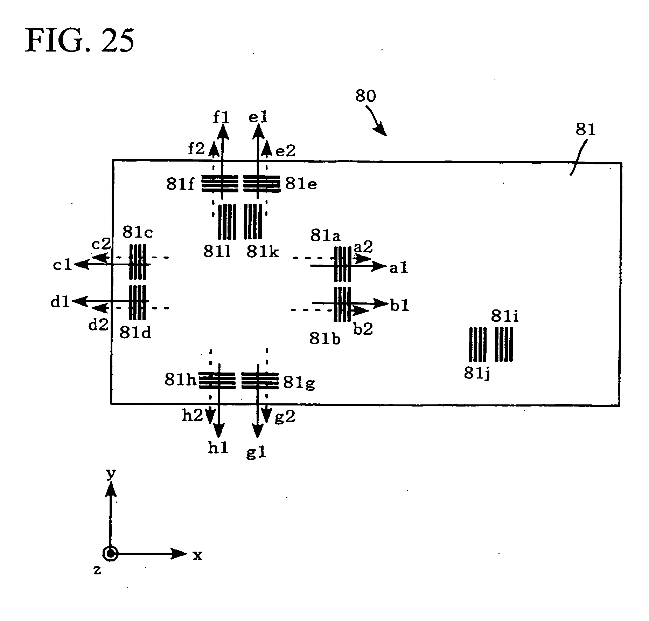

Next, an explanation will be made for the three-axis magnetic sensor of a fourth embodiment as follows by referring to Fig. 25.

As illustrated in Fig. 25, a three-axis magnetic sensor 80 of the fourth embodiment is provided with a substrate 81 made with quartz or silicon which is in a rectangular shape with the sides along the X-axis and Y-axis orthogonal to each other, when viewed from above (here, it is shaped so that the ratio of the short side (longitudinal) to the long side (transverse) (aspect ratio) is 1 : 2 and the side along the X-axis is a long side and the side along the Y-axis is a short side) and has a small thickness in the direction of the Z-axis orthogonal to the X-axis and the Y-axis.

Then, a total of 12 GMR elements made up of respectively four elements of X-axis GMR elements 81a to 81d, Y-axis GMR elements 81e to 81h and Z-axis GMR elements 81i to 811, a total of 12 pads (not illustrated) and connecting wires (not illustrated) connecting each of the pads with each of the elements are fabricated on a substrate 81. An LSI and a wiring layer are also fabricated into the substrate 81, as with the substrate 11 of the first embodiment. A substrate into which the LSI is fabricated is used to provide a magnetic sensor based on a digital output, while a substrate into which only the wiring layer is fabricated is used to provide a magnetic sensor based on an analog output.

Here, the X-axis GMR elements are constituted with a first X-axis GMR element 81a, a second X-axis GMR element 81b, a third X-axis GMR element 81c and a fourth X-axis GMR element 81d. The longitudinal direction of each of the GMR elements is arranged in a direction parallel to the Y-axis. Then, the first X-axis GMR element 81 a is arranged at the X-axis central portion or above the Y-axis central portion, and the second X-axis GMR element 81b is arranged below thereof. Further, the third X-axis GMR element 81c is arranged above the Y-axis central portion in the vicinity of the X-axis left end portion, and the fourth X-axis GMR element 81d is arranged below thereof.

Further, the Y-axis GMR elements are constituted with a first Y-axis GMR element 81e, a second Y-axis GMR element 81f, a third Y-axis GMR element 81g and a fourth Y-axis GMR element 81 h. The longitudinal direction of each of the GMR elements is arranged in a direction parallel to the X-axis. Then, the first Y-axis GMR element 81e is arranged on the right of an intermediate portion from the X-axis central portion to the X-axis left end portion in the vicinity of the Y-axis upper end portion, and the second Y-axis GMR element 81f is arranged left thereof Further, the third Y-axis GMR element 81g is arranged on the right of an intermediate portion from the X-axis central portion to the X-axis left end portion in the vicinity of the Y-axis lower end portion, and the fourth Y-axis GMR element 81h is arranged left thereof

In addition, the Z-axis GMR elements are constituted with a first Z-axis GMR element 81i, a second Z-axis GMR element 81j, a third Z-axis GMR element 81k and a fourth Z-axis GMR element 811. The longitudinal direction of each of the GMR elements is given in a direction parallel to the Y-axis. Then, the first Z-axis GMR element 81i is arranged at an intermediate portion from the Y-axis central portion to the Y-axis lower end portion or right at an intermediate portion from the X-axis central portion to the X-axis right end portion, and the second Z-axis GMR element 81j is arranged left thereof. Further, the third Z-axis GMR element 81k is arranged at an intermediate portion from the Y-axis central portion to the Y-axis upper end portion or right at an intermediate portion from the X-axis central portion to the X-axis left end portion, and the fourth Z-axis GMR element 811 is arranged left thereof.

The above-arranged constitution is also able to provide a three-axis magnetic sensor similar in constitution to the three-axis magnetic sensors described in the first, the second and the third embodiments.

(Fifth embodiment)

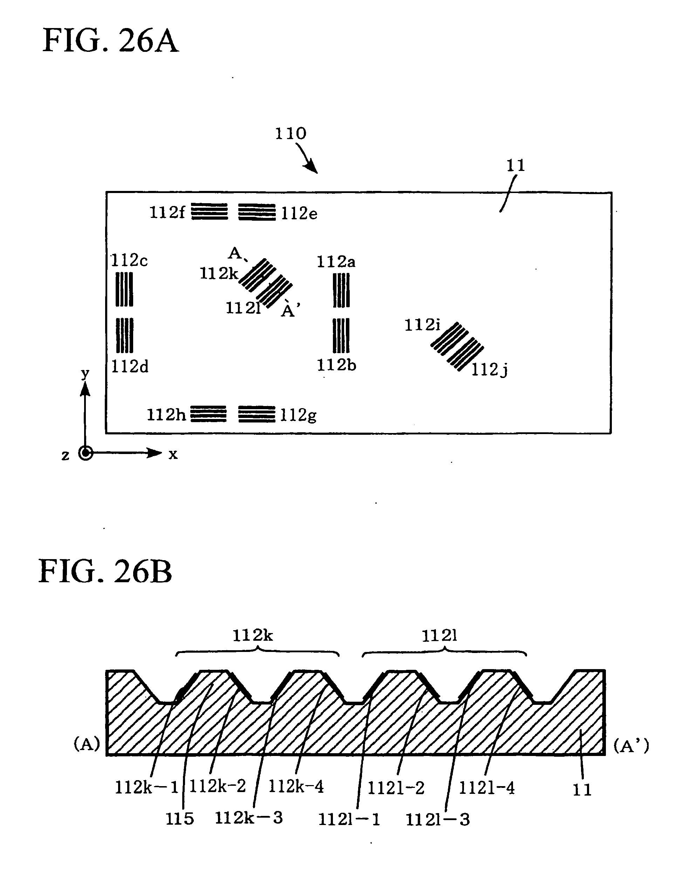

Next, an explanation will be made for the three-axis magnetic sensor of a fifth embodiment as follows by referring to Fig. 26A to Fig. 30B.

As illustrated in Fig. 26A and Fig. 26B, a three-axis magnetic sensor 110 of the fifth embodiment is provided with a substrate 11 made with quartz or silicon which is in a rectangular shape with the sides along the X-axis and Y-axis orthogonal to each other, when viewed from above (here, it is shaped so that the ratio of the short side (longitudinal) to the long side (transverse) (aspect ratio) is 1 : 2 and the side along the X-axis is a long side and the side along the Y-axis is a short side) and has a small thickness in the direction of the Z-axis orthogonal to the X-axis and the Y-axis. Then, a total of 12 GMR elements made up of respectively four elements of X-axis GMR elements 112a to 112d, Y-axis GMR elements 112e to 112h and Z-axis GMR elements 112i to 1121, a pad portion (a portion which takes out an output from a wiring, not illustrated), a via portion (a portion connected to the wiring from GMR elements, but the via portion is not finally exposed, not illustrated) and the wiring (not illustrated) are fabricated on the substrate 11. An LSI and a wiring layer are also fabricated into the substrate 11. A substrate into which the LSI is fabricated is used to provide a magnetic sensor based on a digital output, while a substrate into which only the wiring layer is fabricated is used to provide a magnetic sensor based on an analog output.

Here, the X-axis GMR elements are constituted with a first X-axis GMR element 112a, a second X-axis GMR element 112b, a third X-axis GMR element 112c and a fourth X-axis GMR element 112d. The first X-axis GMR element 112a is arranged at approximately the central portion (hereinafter, referred to as X-axis central portion) between the X-axis left end portion of the substrate 11 (here, the left end portion in Fig. 26A is given as a reference point of the X-axis and a direction moving toward the right in the drawing from the reference point is given as a positive direction of the X-axis, the opposite direction thereof is given as a negative direction of the X-axis, and the same shall apply hereinafter) and the right end portion or above at approximately the central portion (hereinafter, referred to as Y-axis central portion) between the Y-axis lower end portion (here, the lower end portion in Fig. 26A is given as a reference point of the Y-axis, a direction moving from the reference point to above in the drawing is given as a positive direction of the Y-axis, the opposite direction thereof is given as a negative direction of the Y-axis, and the same shall apply hereinafter) and the upper end portion, and the second X-axis GMR element 112b is arranged below thereof Further, the third X-axis GMR element 112c is arranged above at the Y-axis central portion in the vicinity of the X-axis left end portion of the substrate 11, and the fourth X-axis GMR element 112d is arranged below thereof

Further, the Y-axis GMR elements are constituted with a first Y-axis GMR element 112e, a second Y-axis GMR element 112f, a third Y-axis GMR element 112g and a fourth Y-axis GMR element 112h. Then, the first Y-axis GMR element 112e is arranged on the right of approximately an intermediate portion from the X-axis central portion to the left end portion in the vicinity of the Y-axis upper end portion of the substrate 11, and the second Y-axis GMR element 112f is arranged left thereof Further, the third Y-axis GMR element 112g is arranged on the right of approximately an intermediate portion from the X-axis central portion to the left end portion in the vicinity of the Y-axis lower end portion of substrate 11, and the fourth Y-axis GMR element 112h is arranged left thereof.

In addition, the Z-axis GMR elements are constituted with a first Z-axis GMR element 112i, a second Z-axis GMR element 112j, a third Z-axis GMR element 112k and a fourth Z-axis GMR element 1121. Then, the first Z-axis GMR element 112i is arranged at approximately an intermediate portion from the Y-axis central portion of the substrate 11 to the Y-axis lower end portion or left at approximately an intermediate portion from the X-axis central portion to the right end portion, and the second Z-axis GMR element 112j is arranged right below thereof. Further, the third Z-axis GMR element 112k is arranged at approximately an intermediate portion from the Y-axis central portion of the substrate 11 to the Y-axis upper end portion or left at approximately an intermediate portion from the X-axis central portion to the X-axis left end portion, and the fourth Z-axis GMR element 1121 is arranged right below thereof.

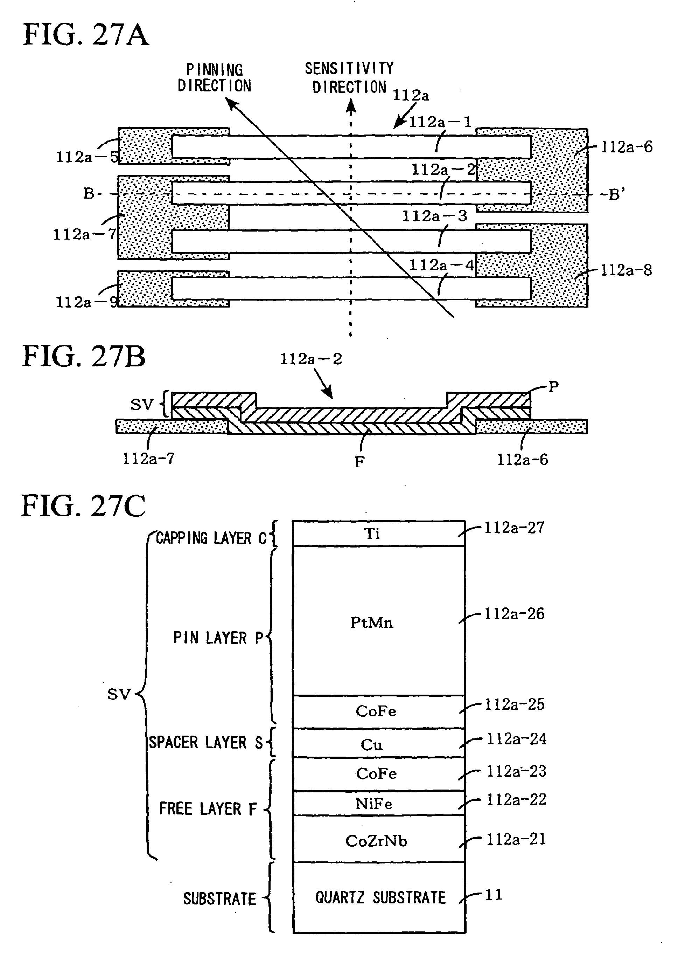

Here, each of the GMR elements 112a to 112d, 112 e to 112h, 112i to 1121 is provided with an even number of GMR bars mutually parallel and arranged adjacently in a band form (here, it is preferable to have an even number of GMR bars, for example, four GMR bars, but any number will do as long as there is more than one). These GMR bars are connected in series with magnet films (bias magnet films), and the magnet films which will act as a terminal are connected to the ends of these bars. For example, as illustrated in Fig. 27A to 27C (in Fig. 27A to 27C, only the first X-axis GMR element 112a is described, but other GMR elements are also similar in constitution), four GMR bars, 112a-1, 112a-2, 112a-3 and 112a-4 are connected in series with the magnet films 112a-6, 112a-7, and 112a-8, and magnet films 112a-5 to 112a-9 which will act as a terminal are connected to their ends.

Here, each of the GMR bars (112a-1, 112a-2, 112a-3, 112a-4, etc.) of the X-axis GMR elements 112a to 112d is formed on a flat surface parallel to the surface of a substrate 11 and arranged in such a way that the longitudinal direction is parallel to the Y-axis (vertical to the X-axis). Further, each of the GMR bars of the Y-axis GMR elements 112e to 112h is formed on a flat surface parallel to the surface of the substrate 11 and arranged in such a way that the longitudinal direction is parallel to the X-axis (vertical to the Y-axis) and also intersected with the longitudinal direction of each of the GMR bars of the X-axis GMR elements 112a to 112d. In addition, each of the GMR bars of the Z-axis GMR elements 112i to 1121 is arranged in such a way that one GMR bar (for example, 112k-1, 112k-2, 112k-3, 112k-4, or 1121-1, 1121-2, 1121-3, 1121-4 and the like in Fig. 26B) per tilted surface (so as to give a tilted angle of approximately 45 degrees) is formed on each tilted surface of a plurality of projections (ledge portions) 115 formed on the substrate 11 and the cross section of which is in a trapezoidal shape, with the longitudinal direction being tilted at 45 degrees with respect to the X-axis (Y-axis).

Then, an explanation will be made of the constitution of the GMR bars by exemplifying the GMR bar 112a-2 of the first X-axis GMR element 112a on the basis of Fig. 27A to Fig. 27C. Other GMR bars 112a-1, 112a-3 and 112a-4 are also similar in constitution and, therefore, only the GMR bar 112a-1 will be explained here. Further, explanations will also be omitted for other X-axis GMR elements 112b, 112c and 112d, Y-axis GMR elements 112e, 112f, 112g and 112h and Z-axis GMR elements 112i, 112j, 112k and 1121, which are similar in constitution.

Here, as illustrated in Fig 27B, which is a schematic sectional view cut on a flat surface along line B-B' in Fig. 27A, the GMR bar 112a-2 of the first X-axis GMR element 112a made of a spin valve film SV arranged so that the longitudinal direction is parallel to the Y-axis is a hard ferromagnetic body such as CoCrPt formed below both ends and provided with magnet films (bias magnet film: hard ferromagnetic body thin film layer) 112-6 and 112a-7, which are made with a material having a high coercive force. As the film constitution illustrated in Fig. 27C, the spin valve film SV is constituted with a free layer (free layer, free magnetization layer) F, a conductive spacer layer S made with Cu having the thickness of 2.4nm (24A), a pin layer (bonded layer, fixed magnetization layer) P and a capping layer C made with titanium (Ti) or tantalum (Ta) having the thickness of 2.5nm (25Å), which are laminated sequentially on the substrate 11.

The free layer F is a layer in which the magnetization direction will change according to the direction of an external magnetic field and constituted with a CoZrNb amorphous magnetic layer 112a-21 formed immediately on the substrate 11 having the thickness of 8nm (80Å), a NiFe magnetic layer 112a-22 formed on the CoZrNb amorphous magnetic layer 112a-21 having the thickness of 3.3nm (33Å) and a CoFe layer 112a-23 formed on the NiFe magnetic layer 112a-22 having the thickness of 1 to 3nm (10 to 30Å). The CoZrNb amorphous magnetic layer 112a-21 and the NiFe magnetic layer 112a-22 constitute a soft ferromagnetic thin film layer. The CoFe layer 112a-23 is provided for preventing the dispersion ofNi in the NiFe layer 112a-22 and Cu 112a-24 in the spacer layer S.

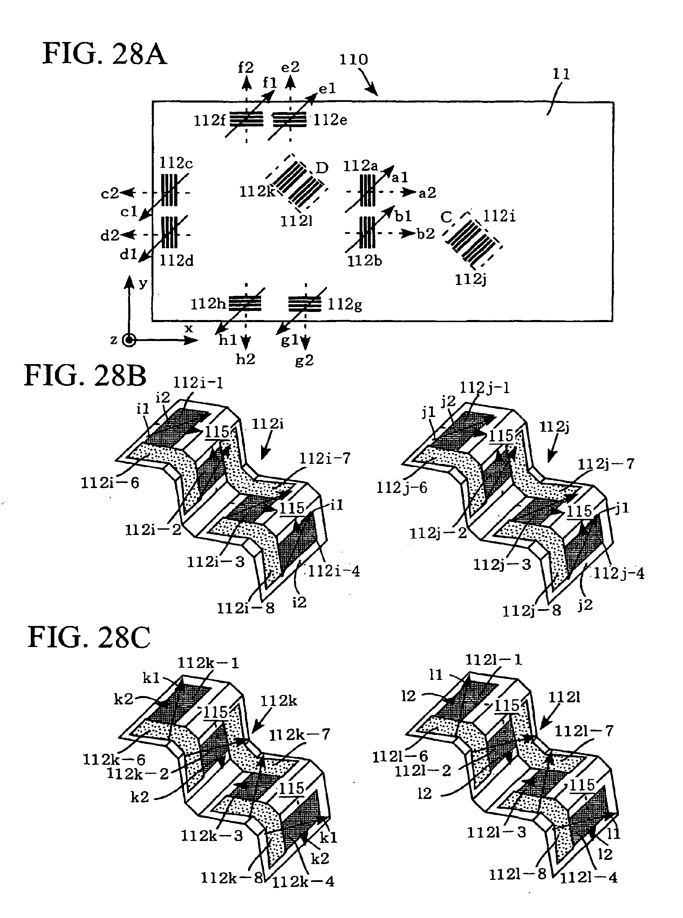

The pin layer P is obtained by adhering a CoFe magnetic layer 112a-25 having the thickness of 2.2nm (22Å) to an antiferromagnetic film 112a-26 made with PtMn alloy containing Pt at 45 to 55mol% having the thickness of 24nm (240Å). The CoFe magnetic layer 112a-25 constitutes a pinned layer in which the magnetization direction (magnetization vector) is pinned (bonded) in the direction tilted at 45 degrees with respect to a positive direction of the X-axis (the direction given by the solid-line arrow a1 in Fig. 28A) by being backed in a manner of switched connection to the antiferromagnetic film 112a-26, which is magnetized.

Bias magnet films 112a-5, 112a-6, 112a-7, 112a-8 and 112a-9 of the above-described first X-axis GMR element 112a impart a bias magnetic field in the longitudinal direction of each of the GMR bars with respect to a free layer F and in a direction tilted at an acute angle with respect to the magnetization direction (magnetization vector) of a pinned layer in order to keep a uniaxial anisotropy of the free layer F. Then, the CoFe magnetic layer 112a-25 (the same will apply to other GMR bars 112a-1, 112a-3 and 112a-4) is backed in a manner of a switched connection to the antiferromagnetic film 112a-26, thereby constituting the pinned layer in such a way that the magnetization direction (magnetization vector) is pinned (bonded) in the direction tilted at 45 degrees with respect to a positive direction of the X-axis (the direction given by the solid-line arrow a1 in Fig. 28A). Similarly, the bias magnet film of the second X-axis GMR element 112b imparts a bias magnetic field in the longitudinal direction of each of the GMR bars with respect to the free layer F of each of the GMR bars and in a direction tilted at an acute angle with respect to the magnetization direction (magnetization vector) of the pinned layer. Then, the pinned layer is formed in such a way that the magnetization direction (magnetization vector) is pinned (bonded) in the direction tilted at 45 degrees with respect to a positive direction of the X-axis (the direction given by the solid-line arrow b1 in Fig. 28A).

Thereby, in the first X-axis GMR element 112a and the second X-axis GMR element 112b, the sensitivity direction (sensitivity direction of a magnetic field) is a direction vertical to the longitudinal direction of each of the GMR bars, namely, a positive direction of the X-axis (the direction given by the broken-line arrows, a2 and b2 in Fig. 28A). Where a magnetic field is applied in the direction given by the broken-line arrows a2 and b2 in Fig. 28A, the resistance values of the first X-axis GMR element 112a and the second X-axis GMR element 112b will decrease proportionally with an increase in magnetic field. Where the magnetic field is applied in the direction opposite that given by the broken-line arrows a2 and b2 in Fig. 28A, the resistance values of the first X-axis GMR element 112a and the second X-axis GMR element 112b will increase proportionally with an increase in magnetic field.

In contrast, in the third X-axis GMR element 112c and the fourth X-axis GMR element 112d, the bias magnet film imparts a bias magnetic field in the longitudinal direction of each of the GMR bars with respect to a free layer F of each of the GMR bars and a direction tilted at an acute angle with respect to the magnetization direction (magnetization vector) of a pinned layer (namely, the direction opposite 180 degrees to the bias magnetic field of the first X-axis GMR element 112a and the second X-axis GMR element 112b). Then, the pinned layer is formed in such a way that the magnetization direction (magnetization vector) is pinned (bonded) in the direction tilted at -45 degrees with respect to a negative direction of the X-axis (the direction given by the solid-line arrows c1 and d1 in Fig. 28A, the direction opposite 180 degrees to the magnetization direction of the pinned layer of the first X-axis GMR element 112a and the second X-axis GMR element 112b).

Thereby, the sensitivity direction of the third X-axis GMR element 112c and the fourth X-axis GMR element 112d is a direction vertical to the longitudinal direction of each of the GMR bars, namely, the direction given by the broken-line arrows c2 and d2 in Fig. 28A (the direction opposite 180 degrees to the sensitivity direction of the first X-axis GMR element 112a and the second X-axis GMR element 112b). Where a magnetic field is applied in the direction given by the broken-line arrows c2 and d2 in Fig. 28A, the resistance values of the third X-axis GMR element 112c and the fourth X-axis GMR element 112d will decrease proportionally with an increase in magnetic field. Where the magnetic field is applied in the direction opposite that given by the broken-line arrows c2 and d2 in Fig. 28A, the resistance values of the third X-axis GMR element 112c and the fourth X-axis GMR element 112d will increase proportionally with an increase in magnetic field.

Further, in the first Y-axis GMR element 112e and the second Y-axis GMR element 112f, the bias magnet film imparts a bias magnetic field in the longitudinal direction of each of the GMR bars with respect to a free layer F of each of the GMR bars or a direction tilted at an acute angle with respect to the magnetization direction (magnetization vector) of a pinned layer (namely, the direction opposite that at which the bias magnetic field of the first X-axis GMR element 112a and the second X-axis GMR element 112b is turned counterclockwise 90 degrees). Then, the pinned layer is formed in such a way that the magnetization direction (magnetization vector) is pinned (bonded) in the direction tilted at 45 degrees to a positive direction of the Y-axis (in the direction given by the solid-line arrows e1 and f1 in Fig. 28A).

Thereby, the sensitivity direction of the first Y-axis GMR element 112e and the Y-axis GMR element 112f is a direction vertical to the longitudinal direction of each of the GMR bars, namely, a positive direction of the Y-axis (the direction given by the broken-line arrows e2 and f2 in Fig. 28A). Where a magnetic field is applied in the direction given by the broken-line arrows e2 and f2 in Fig. 28A, the resistance values of the first Y-axis GMR element 112e and the second Y-axis GMR element 112f will decrease proportionally with an increase in magnetic field. Where the magnetic field is applied in the direction opposite that given by the broken-line arrows e2 and f2 in Fig. 28A, the resistance values of the first Y-axis GMR element 112e and the second Y-axis GMR element 112f will increase proportionally with an increase in magnetic field.

In contrast, in the third Y-axis GMR element 112g and the fourth Y-axis GMR element 112h, a bias magnet film imparts a bias magnetic field in the longitudinal direction of each of the GMR bars with respect to a free layer F of each of the GMR bars or a direction tilted at an acute angle with respect to the magnetization direction (magnetization vector) of a pinned layer (namely, the direction opposite 180 degrees to the bias magnetic field of the first Y-axis GMR element 112e and the second Y-axis GMR element 112f). Then, the pinned layer is formed in such a way that the magnetization direction (magnetization vector) is pinned (bonded) in the direction titled at -45 degrees to a negative direction of the Y-axis (in the direction given by the solid-line arrows g1 and h1 in Fig. 28A).

Thereby, the sensitivity direction of the third Y-axis GMR element 112g and the fourth Y-axis GMR element 112h is a direction vertical to the longitudinal direction of each of the GMR bars, namely, a negative direction of the Y-axis (the direction given by the broken-line arrows g2 and h2 in Fig. 28A and the direction opposite 180 degrees to the sensitivity direction of the first Y-axis GMR element 112e and the second Y-axis GMR element 112f). Where a magnetic field is applied in the direction given by the broken-line arrows g2 and h2 in Fig. 28A, the resistance values of the third Y-axis GMR element 112g and the fourth Y-axis GMR element 112h will decrease proportionally with an increase in magnetic field. Where the magnetic field is applied in the direction opposite that given by the broken-line arrows g2 and h2 in Fig. 28A, the resistance values of the third Y-axis GMR element 112g and the fourth Y-axis GMR element 112h will increase proportionally with an increase in magnetic field.

Further, as schematically illustrated in Fig. 28B, in the first Z-axis GMR element 112i and the second Z-axis GMR element 112j, bias magnet films 112i-6, 112i-7 and 112i-8 (112j-6, 12j-7 and 112j-8) impart a bias magnetic field in a direction parallel to the longitudinal direction of each of the GMR bars 112i-1, 112j-2, 112i-3 and 112i-4 (112j-1, 112j-2, 112j-3 and 112j-4) and a direction tilted at an acute angle with respect to the magnetization direction (magnetization vector) of a pinned layer. Here, the longitudinal direction of the GMR bars is a direction tilted at an angle of 45 degrees with respect to X-axis and Y-axis. The pinned layer is formed in such a way that the magnetization direction (magnetization vector) is pinned (bonded) in the direction tilted at 45 degrees with respect to a positive direction of the Z-axis (the direction given by the solid-line arrows i1 (j1) in Fig. 28B on the basis of the direction tilted at 45 degrees with respect to the X-axis and the Y-axis, which is the traveling direction of a tilted surface).

Then, these GMR bars 112i-1, 112i-2, 112i-3 and 112i-4 (112j-1, 112j-2, 112j-3 and 112j-4) are connected in series with the bias magnet films 112i-6, 112i-7 and 112i-8 (112j-6, 112j-7 and 112j-8). Thereby, an x-axis component and a y-axis component are cancelled, and the sensitivity direction of the first z-axis GMR element 112i and the second z-axis GMR element 112j is in a direction vertical to the longitudinal direction of each of the GMR bars and a positive direction of the Z-axis, namely, the direction given by the broken-line arrow i2 (j2) in Fig. 28B (the direction moving from the back to the front on the page space). Then, where a magnetic field is applied to the direction given by the broken-line arrow i2 (j2) in Fig. 28B, the resistance values of the first Z-axis GMR element 112i and the second Z-axis GMR element 112j will decrease proportionally with an increase in magnetic field. Where the magnetic field is applied in the direction opposite that given by the broken-line arrow i2 (j2) in Fig. 28B, the resistance values of the first Z-axis GMR element 112i and the second Z-axis GMR element 112j will increase proportionally with an increase in magnetic field.

In contrast, as schematically illustrated in Fig. 28C, in the third Z-axis GMR element 112k and the fourth Z-axis GMR element 1121, the bias magnet films 112k-6, 112k-7 and 112k-8 (1121-6, 1121-7 and 1121-8) impart a bias magnetic field in a direction parallel to the longitudinal direction of each of the GMR bars 112k-1, 112k-2, 112k-3 and 112k-4 (1121-1, 1121-2, 1121-3 and 1121-4) and the direction tilted at an acute angle with respect to the magnetization direction (magnetization vector) of a pinned layer. Here, the longitudinal direction of the GMR bars is a direction tilted at 45 degrees with respect to X-axis and Y-axis. Then, the pinned layer is formed in such a way that the magnetization direction (magnetization vector) is pinned (bonded) in the direction tilted at 45 degrees with respect to a negative direction of the Z-axis (the direction given by the solid-line arrows k1 (11) in Fig. 28C based on the direction tilted at 45 degrees with respect to the X-axis and the Y-axis, which is the traveling direction of a tilted surface).

Then, these GMR bars 112k-1, 112k-2, 112k-3 and 112k-4 (1121-1, 1121-2, 1121-3 and 1121-4) are connected in series with the bias magnet films 112k-6, 112k-7 and 112k-8 (1121-6, 1121-7 and 1121-8). Thereby, an x-axis component and a y-axis component are cancelled, and the sensitivity direction of the third Z-axis GMR element 112k and the fourth Z-axis GMR element 1121 is in a direction vertical to the longitudinal direction of each of the GMR bars and a negative direction of the Z-axis, namely, the direction given by the broken-line arrow k2 (12) in Fig. 28C (the direction moving from the back to the front on the page space). Where a magnetic field is applied to the direction given by the broken-line arrow k2 (12) in Fig. 28C, the resistance values of the third Z-axis GMR element 112k and the fourth Z-axis GMR element 1121 will decrease proportionally with an increase in magnetic field. Where the magnetic field is applied in the direction opposite that given by the broken-line arrows k2 (12) in Fig. 28C, the resistance values of the third Z-axis GMR element 112k and the fourth Z-axis GMR element 1121 will increase proportionally with an increase in magnetic field.

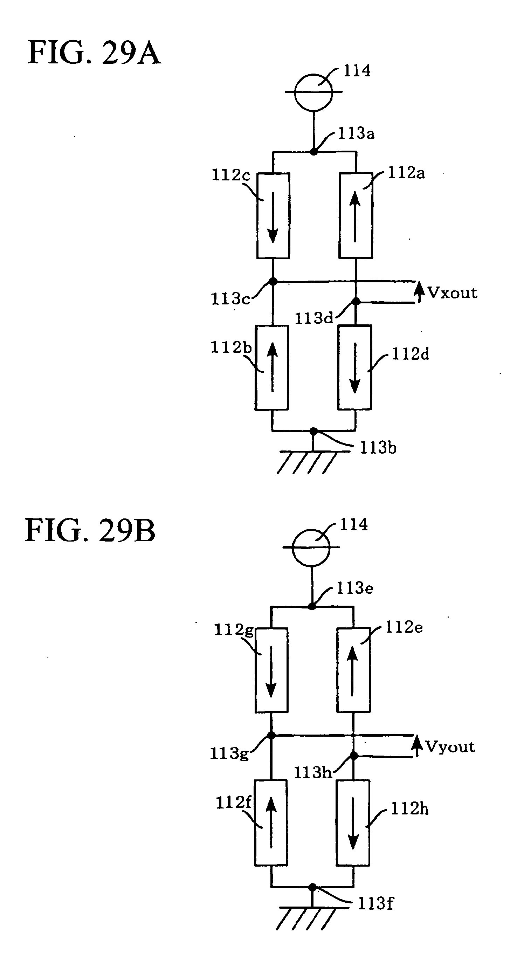

As an equivalent circuit illustrated in Fig. 29A, (it is to be noted that in Fig. 29A to Fig. 29C, individual arrows indicate a case where the magnetization direction is upward when a bonded layer of each of the GMR elements is pinned), the X-axis magnetic sensor is constituted with the first X-axis GMR element 112a to the fourth X-axis GMR element 112d, which are full-bridge connected. In this constitution, a pad 113a and a pad 113b are connected to a positive electrode and a negative electrode of a constant voltage source 114, thereby imparting a potential Vxin+ (3V in this embodiment) and a potential Vxin- (0(V) in this embodiment). Then, the potential of a pad 113c and a pad 113d is output respectively as a potential Vxout+ and a potential Vxout-, and a potential difference (Vxout+ - Vxout-) is output as a sensor output Vxout.

As an equivalent circuit illustrated in Fig. 29B, the Y-axis magnetic sensor is constituted with the first Y-axis GMR element 112e to the fourth Y-axis GMR element 112h, which are full-bridge-connected. Then, a pad 113e and a pad 113f are connected to a positive electrode and a negative electrode of a constant voltage source 114, thereby imparting a potential Vyin+ (3V in this embodiment) and a potential Vyin- (0(V) in this embodiment), and a potential difference between a pad 113g and a pad 113h is output as a sensor output Vyout.

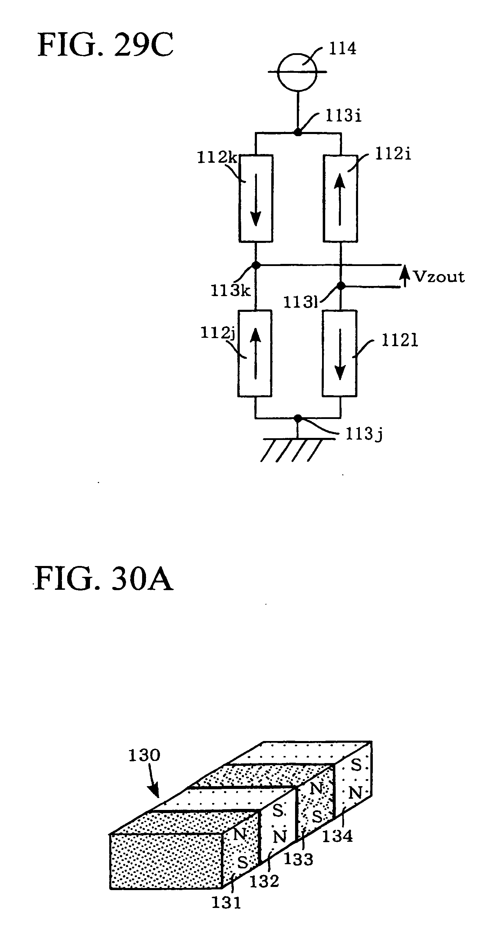

As an equivalent circuit illustrated in Fig. 29c, the Z-axis magnetic sensor is constituted with the first Z-axis GMR element 112i to the fourth Z-axis GMR element 1121, which are full-bridge-connected. Then, a pad 113i and a pad 113j are connected to a positive electrode and a negative electrode of a constant voltage source 114, thereby imparting a potential Vyin+ (3V in this embodiment) and a potential Vyin- (0(V) in this embodiment), and a potential difference between a pad 113k and a pad 1131 is output as a sensor output Vyout.

The above-constituted three-axis magnetic sensor is manufactured by procedures similar to those described in the paragraphs [0068] through [0076] by referring to Fig. 5A, Fig. 5B and Fig. 5C, to Fig. 14A, Fig. 14B and Fig. 14C.

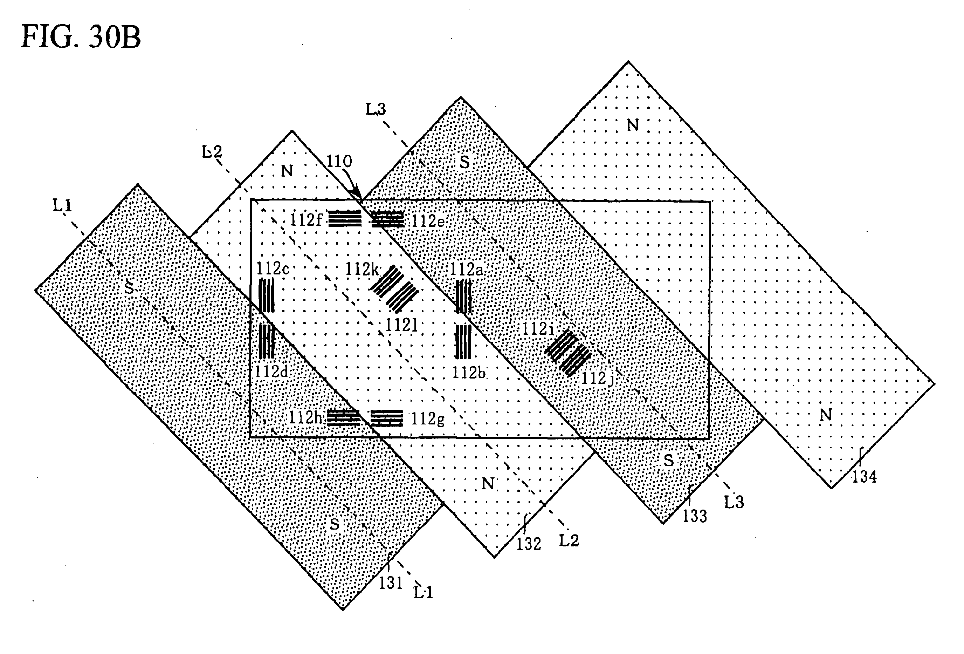

A permanent magnet array is allowed to move close to a laminated body obtained by the above manufacturing procedures to conduct heat treatment for regularization (pinning treatment), thereby fixing the magnetization direction of a pinned layer P. Here, in conducting the heat treatment for regularization (pinning treatment), as schematically illustrated in Fig. 30A, a permanent bar magnet array (magnet array) 130 is prepared, in which adjacent permanent bar magnet pieces 131, 132, 133 and 134 are arranged mutually in parallel so that the upper ends (lower ends) are mutually different in polarity. Then, the permanent bar magnet array 130 is arranged at the upper portion of a substrate 11 so as to give 45 degrees with respect to a flat surface of the substrate 11, and heated to a predetermined temperature to conduct the heat treatment. More specifically, in a state given in Fig. 30B, the permanent bar magnet array (magnet array) 130 and the substrate 11 are fixed and heated in vacuum at temperatures from 260°C to 290°C. Then, the magnet array is allowed to stand for about 4 hours, as it is, thereby conducting the heat treatment for regularization (pinning treatment). Fig. 30B illustrates a state of the magnetic pole on a lower surface of the permanent bar magnet array 130.

Here, as illustrated in Fig. 30B, the first X-axis GMR element 112a is positioned further left from a width-directional center line L3 of the permanent bar magnet piece 133 and the second X-axis GMR element 112b is positioned further right from a width-directional center line L2 of the permanent bar magnet piece 132. Therefore, they become magnetized in the direction of the magnetic field from the permanent bar magnet piece 132 toward the permanent bar magnet piece 133. Thereby, in the first X-axis GMR element 112a and the second X-axis GMR element 112b, the magnetization direction of a pinned layer is fixed in the direction given by the solid-line arrows a1 and b1 in Fig. 28A. Similarly, the third X-axis GMR element 112c is positioned further left from a width-directional center line L2 of the permanent bar magnet piece 132, and the fourth X-axis GMR element 112d is positioned further right from a width-directional center line L1 of the permanent bar magnet piece 131. Therefore, they become magnetized in the direction of the magnetic field from the permanent bar magnet piece 132 toward the permanent bar magnet piece 131. Thereby, in the third X-axis GMR element 112c and the fourth X-axis GMR element 112d, the magnetization direction of the pinned layer is fixed in the direction given by the solid-line arrows c1 and d1 in Fig. 28A.

Further, the first Y-axis GMR element 112e is positioned further left from a width-directional center line L3 of the permanent bar magnet piece 133 and the second Y-axis GMR element 112f is positioned further right from a width-directional center line L2 of the permanent bar magnet piece 132. Therefore, they become magnetized in the direction of the magnetic field from the permanent bar magnet piece 132 toward the permanent bar magnet piece 133. Thereby, in the first Y-axis GMR element 112e and the second Y-axis GMR element 112f, the magnetization direction of a pinned layer is fixed in the direction given by the solid-line arrows e1 and f1 in Fig. 28A. Similarly, the third Y-axis GMR element 112g is positioned further left from a width-directional center line L2 of the permanent bar magnet piece 132, and the fourth Y-axis GMR element 112h is positioned further right from a width-directional center line L1 of the permanent bar magnet piece 131. Therefore, they become magnetized in the direction of the magnetic field from the permanent bar magnet piece 132 toward the permanent bar magnet piece 133. Thereby, in the third Y-axis GMR element 112g and the fourth Y-axis GMR element 112h, the magnetization direction of the pinned layer is fixed in the direction given by the solid-line arrows g1 and h1 in Fig. 28A.

Still further, since the first Z-axis GMR element 112i and the second Z-axis GMR element 112j are positioned further left from a width-directional center line L3 of the permanent bar magnet piece 33, they become magnetized in the direction of the magnetic field from the permanent bar magnet piece 132 toward the permanent bar magnet piece 133. Thereby, in the first Z-axis GMR element 112i and the second Z-axis GMR element 112j, the magnetization direction of a pinned layer is fixed in the direction given by the solid-line arrows i1 and j1 in Fig. 28B, and in the direction tilted at 45 degrees from the X-axis to a positive direction of the Z-axis inside a tilted surface of each of the projections (ledge portions) 115. Similarly, since the third Z-axis GMR element 112k and the fourth Z-axis GMR element 1121 are positioned further right from a width-directional center line L2 of the permanent bar magnet piece 132, they become magnetized in the direction of the magnetic field from the permanent bar magnet piece 132 toward the permanent bar magnet piece 133. Thereby, in the third Z-axis GMR element 112k and the fourth Z-axis GMR element 1121, the magnetization direction of the pinned layer is fixed in the direction given by the solid-line arrows k1 and 11 in Fig. 28C and in the direction tilted at 45 degrees from the X-axis to a negative direction of the Z-axis inside the tilted surface of each of the projections (ledge portion) 115.

A process of forming a GMR multilayer film 11n on the surface of a GMR multilayer film 11n, a process of forming individual pads and wirings connecting these pads and other processes are similar to those described in the paragraphs [0079] and [0080]. As described so far, the three-axis magnetic sensor 110 of the fifth embodiment illustrated in Fig. 26A and Fig. 26B is fabricated.

(Sixth embodiment)

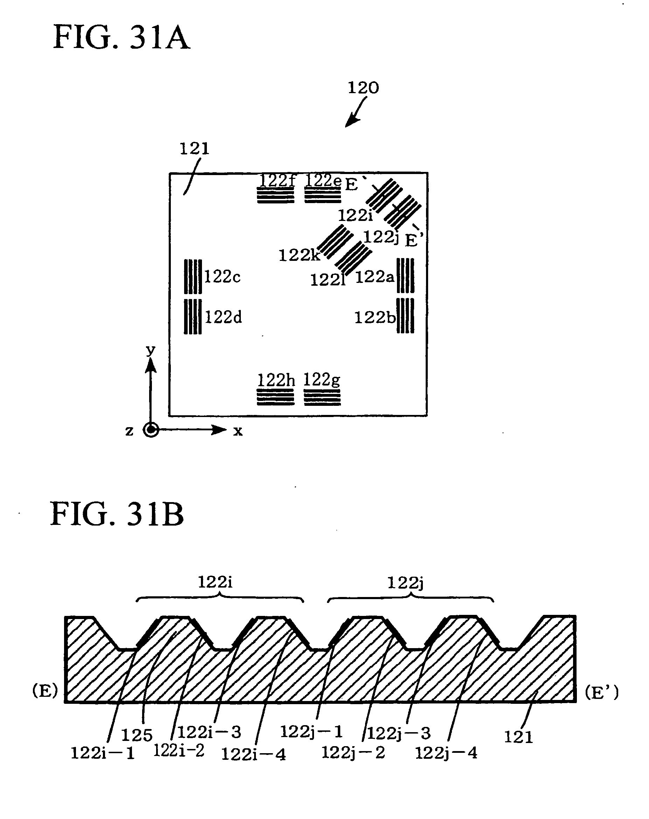

Next, an explanation will be made of a three-axis magnetic sensor of a sixth embodiment by referring to Fig. 31A to Fig. 34B.

As illustrated in Fig. 31A and Fig. 31B, a three-axis magnetic sensor 120 of the sixth embodiment is in a square shape having the sides along the X-axis and the Y-axis orthogonal each other, when viewed from above, (namely, fifth in dimension as compared with the substrate 11 of the first embodiment) and is provided with a substrate 121 made with quartz or silicon, which has a small thickness in the direction of the Z-axis orthogonal to the X-axis and the Y-axis. It is possible to make the present sensor smaller than the three-axis magnetic sensor of the fifth embodiment by using the above-described substrate 121.

Then, a total of 12 GMR elements, namely, four each of the X-axis GMR elements 122a to 122d, the Y-axis GMR elements 122e to 122h and two each of Z-axis GMR elements 122i to 1221, a pad portion (which takes out an output from a wiring, not illustrated), a via portion (connected to the wiring from GMR elements but not finally exposed, not illustrated) and the wiring (not illustrated) are fabricated into the substrate 121. An LSI and a wiring layer are also fabricated into the substrate 121 as with the substrate 11 of the fifth embodiment. A substrate into which the LSI is fabricated is used to provide a magnetic sensor based on a digital output, while a substrate into which only the wiring layer is fabricated is used to provide a magnetic sensor based on an analog output.

Here, the X-axis GMR elements are constituted with a first X-axis GMR element 122a, a second X-axis GMR element 122b, a third X-axis GMR element 122c and a fourth X-axis GMR element 122d. Then, the first X-axis GMR element 122a is arranged above the Y-axis central portion in the vicinity of the X-axis right end portion, and the second X-axis GMR element 122b is arranged below thereof. Further, the third X-axis GMR element 122c is arranged above the Y-axis central portion in the vicinity of the X-axis left end portion, and the fourth X-axis GMR element 122d is arranged below thereof

Further, the Y-axis GMR elements are constituted with a first Y-axis GMR element 122e, a second Y-axis GMR element 122f, a third Y-axis GMR element 122g and a fourth Y-axis GMR element 122h. Then, the first Y-axis GMR element 122e is arranged on the right of the X-axis central portion in the vicinity of the Y-axis upper end portion, and the second Y-axis GMR element 122f is arranged on the left thereof Further, the third Y-axis GMR element 122g is arranged on the right of the X-axis central portion in the vicinity of the Y-axis lower end portion, and the fourth Y-axis GMR element 122h is arranged on the left thereof.

In addition, the Z-axis GMR elements are constituted with a first Z-axis GMR element 122i and a second Z-axis GMR element 122j, a third Z-axis GMR element 122k and a fourth Z-axis GMR element 1221. Then, the first Z-axis GMR element 122i is arranged on the left at the right upper corner of the substrate 122, and the second Z-axis GMR element 122j is arranged on the right below thereof Further, the third Z-axis GMR element 122k is arranged left below at the right upper corner of the substrate 122, and the fourth Z-axis GMR element 1221 is arranged right below thereof.

Each of the GMR elements 122a to 122d, 122e to 122h and 122i to 1221 is provided with an even number of GMR bars mutually parallel and arranged adjacently in a band form (here, it is preferable to have an even number of GMR bars, for example, four GMR bars, but any number will do as long as there is one or more). These GMR bars are connected in series with magnet films (bias magnet films), and the magnet films which will act as a terminal are connected to their ends.

Here, each of the GMR bars of the X-axis GMR elements 122a to 122d is formed on a flat surface parallel to the surface of the substrate 121 and arranged in such a way that the longitudinal direction is parallel to the Y-axis (vertical to the X-axis). Further, each of the GMR bars of the Y-axis GMR elements 122e to 122h is formed on a flat surface parallel to the surface of the substrate 121 and arranged in such a way that the longitudinal direction is parallel to the X-axis (vertical to the Y-axis) and intersected with the longitudinal direction of each GMR bar of the X-axis GMR elements 122a to 122d.

Further, each of the GMR bars of the Z-axis GMR elements 122i to 1221 is arranged in such a way that one GMR bar (for example, 122i-1, 122i-2, 122i-3 or 122i-4 (122j-1, 122j-2, 122j-3 or 122j-4, as illustrated in Fig. 31B) per tilted surface (so as to give a tilted angle of approximately 45 degrees) is formed on each tilted surface of a plurality of projections (ledge portions) 125 formed on the substrate 121 and the cross section of which is in a trapezoidal shape, with the longitudinal direction being tilted at 45 degrees to the X-axis and the Y-axis.

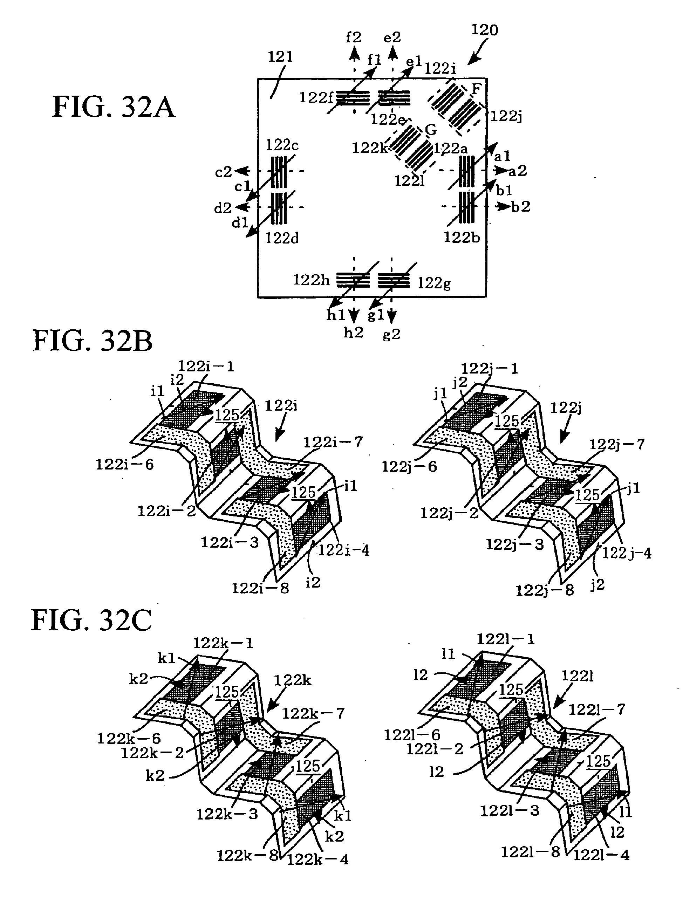

Here, in the X-axis GMR elements 122a and 122b, a bias magnet film imparts a bias magnetic field in the longitudinal direction of each of the GMR bars (the direction vertical to the X-axis) and a direction tilted at an acute angle with respect to the magnetization direction (magnetization vector) of a pinned layer. Then, the pinned layer is formed in such a way that the magnetization direction (magnetization vector) is pinned (bonded) in the direction tilted at -45 degrees to a positive direction of the X-axis (in the direction given by the solid-line arrows a1 and b1 in Fig. 32A).

Therefore, the sensitivity direction of the X-axis GMR elements 122a and 122b is a direction vertical to the longitudinal direction of each of the GMR bars, namely, a positive direction of the X-axis (the direction given by the broken-line arrows e2 and f2 in Fig. 32A). Thereby, where a magnetic field is applied in the direction given by the broken-line arrows a2 and b2 in Fig. 32A, the resistance values of the first X-axis GMR element 122a and the second X-axis GMR element 122b will decrease proportionally with an increase in magnetic field. Where the magnetic field is applied in the direction opposite that given by the broken-line arrows a2 and b2 in Fig. 32A, the resistance values of the first X-axis GMR element 122a and the second X-axis GMR element 122b will increase proportionally with an increase in magnetic field.

In contrast, in the third X-axis GMR element 122c and the fourth X-axis GMR element 122d, a bias magnet film imparts a bias magnetic field in a direction parallel to the longitudinal direction of each of the GMR bars (the direction vertical to the X-axis) and a direction tilted at an acute angle with respect to the magnetization direction (magnetization vector) of a pinned layer (the direction opposite 180 degrees to the bias magnetic field of the first X-axis GMR element 122a and the second X-axis GMR element 122b). Then, the pinned layer is formed in such a way that the magnetization direction (magnetization vector) is pinned (bonded) in the direction titled at -45 degrees to a negative direction of the X-axis (the direction given by the solid-line arrows c1 and d1 in Fig. 32A and the direction opposite 180 degrees to the magnetization direction of the first axis GMR element 122a and the second X-axis GMR element 122b).

Therefore, the sensitivity direction of the third X-axis GMR element 112c and the fourth X-axis GMR element 122d is a direction vertical to the longitudinal direction of each of the GMR bars, namely, a negative direction of the X-axis (the direction given by the broken-line arrows c2 and d2 in Fig. 32A and the direction opposite 180 degrees to the sensitivity direction of the first X-axis GMR element 122a and the second X-axis GMR element 122b). Thereby, where a magnetic field is applied in the direction given by the broken-line arrows c2 and d2 in Fig. 32A, the resistance values of the third X-axis GMR element 122c and the fourth X-axis GMR element 122d will decrease proportionally with an increase in magnetic field. Where the magnetic field is applied in the direction opposite that given by the broken-line arrows c2 and d2 in Fig. 32A, the resistance values of the third X-axis GMR element 122c and the fourth X-axis GMR element 122d will increase proportionally with an increase in magnetic field.

Further, in the first Y-axis GMR element 122e and the second Y-axis GMR element 122f, a bias magnet film imparts a bias magnetic field in the longitudinal direction of each of the GMR bars and a direction tilted at an acute angle with respect to the magnetization direction (magnetization vector) of a pinned layer (namely, the direction opposite that at which the bias magnetic field of the first X-axis GMR element 122a and the second X-axis GMR element 122b is turned counter-clockwise at 90 degrees). Then, the pinned layer is formed in such a way that the magnetization direction (magnetization vector) is pinned (bonded) in to the direction tilted at 45 degrees to a positive direction of the Y-axis (the direction given by the solid-line arrows e1 and f1 in Fig. 32A).

Therefore, the sensitivity direction of the first Y-axis GMR element 112e and the second Y-axis GMR element 122f is a direction vertical to the longitudinal direction of each of the GMR bars, namely, a positive direction of the Y-axis (the direction given by the broken-line arrows e2 and f2 in Fig. 32A). Thereby, where a magnetic field is applied in the direction given by the broken-line arrows e2 and f2 in Fig. 32A, the resistance values of the first Y-axis GMR element 122e and the second Y-axis GMR element 122f will decrease proportionally with an increase in magnetic field. Where the magnetic field is applied in the direction opposite that given by the broken-line arrows e2 and f2 in Fig. 32A, the resistance values of the first Y-axis GMR element 122e and the second Y-axis GMR element 122f will increase proportionally with an increase in magnetic field.

In contrast, in the third Y-axis GMR element 122g and the fourth Y-axis GMR element 122h, a bias magnet film imparts a bias magnetic field in the longitudinal direction of each of the GMR bars (the direction vertical to the Y-axis) and a direction tilted at an acute angle with respect to the magnetization direction (magnetization vector) of a pinned layer (the direction opposite 180 degrees to the bias magnetic field of the first Y-axis GMR element 122e and the second Y-axis GMR element 122f). Then, the pinned layer is formed in such a way that the magnetization direction (magnetization vector) is pinned (bonded) in the direction titled at 45 degrees to a negative direction of the Y-axis (the direction given by the solid-line arrows g1 and h1 in Fig. 32A).

Therefore, the sensitivity direction of the third Y-axis GMR element 122g and the fourth Y-axis GMR element 122h is a direction vertical to the longitudinal direction of each of the GMR bars, namely, a negative direction of the Y-axis (the direction given by the broken-line arrows g2 and h2 in Fig. 32A and the direction opposite 180 degrees to the sensitivity direction of the first Y-axis GMR element 122e and the second Y-axis GMR element 122f). Thereby, where a magnetic field is applied in the direction given by the broken-line arrows g2 and h2 in Fig. 32A, the resistance values of the third Y-axis GMR element 122g and the fourth Y-axis GMR element 122h will decrease proportionally with an increase in magnetic field. Where the magnetic field is applied in the direction opposite that given by the broken-line arrows g2 and h2 in Fig. 32A, the resistance values of the third Y-axis GMR element 122g and the fourth Y-axis GMR element 122h will increase proportionally with an increase in magnetic field.

Further, as schematically illustrated in Fig. 32B, in the first Z-axis GMR element 122i and the second Z-axis GMR element 122j, bias magnet films 122i-5, 122i-6 and 122i-7 (122j-5, 122j-6 and 122j-7) impart a bias magnetic field in the longitudinal direction of each of the GMR bars 122i-1, 122i-2, 122i-3 and 122i-4 (122j-1, 122j-2, 122j-3 and 122j-4) (the direction tilted at 45 degrees with respect to the X-axis and Y-axis) and a direction tilted at an acute angle with respect to the magnetization direction (magnetization vector) of a pinned layer. Here, the longitudinal direction of each of the GMR bars is a direction tilted at 45 degrees with respect to the X-axis and the Y-axis. Then, the pinned layer is formed in such a way that the magnetization direction (magnetization vector) is pinned (bonded) in the direction tilted at 45 degrees with respect to a positive direction of the Z-axis (the direction given by the solid-line arrows i1 (j1) in Fig. 32B) on the basis of the direction tilted at 45 degrees with respect to the X-axis and the Y-axis, which is the traveling direction of a tilted surface inside each tilted surface of projections (ledge portions) 125.

Then, these GMR bars 122i-1, 122i-2, 122i-3 and 122i-4 (122j-1, 122j-2, 122j-3 and 122j-4) are connected in series with the bias magnet films 122i-5, 122i-6 and 122i-7(122j-5, 122j-6 and 122j-7). Thereby, an x-axis component and a y-axis component are cancelled, and the sensitivity direction of the first z-axis GMR element 122i and the second z-axis GMR element 122j is in a direction vertical to the longitudinal direction of each of the GMR bars and a positive direction of the Z-axis, namely, the direction given by the broken-line arrow i2 and j2 in Fig. 32B (the direction moving from the back to the front on the page space). Then, where a magnetic field is applied to the direction given by the broken-line arrow i2 and j2 in Fig. 32B, the resistance values of the first Z-axis GMR element 122i and the second Z-axis GMR element 122j will decrease proportionally with an increase in magnetic field. Where the magnetic field is applied in the direction opposite that given by the broken-line arrow i2 and j2) in Fig. 32B, the resistance values of the first Z-axis GMR element 122i and the second Z-axis GMR element 122j will increase proportionally with an increase in magnetic field.

In contrast, as schematically illustrated in Fig. 32C, in the third Z-axis GMR element 122k and the fourth Z-axis GMR element 122l, the bias magnet films 122k-6, 122k-7 and 122k-8 (122l-6, 1221-7 and 1221-8) impart a bias magnetic field in the longitudinal direction of each of the GMR bars 122k-1, 122k-2, 122k-3 and 122k-4 (122l-1, 122l-2, 1221-3 and 1221-4) (the direction tilted at 45 degrees with respect to the X-axis and Y-axis) and the direction tilted at an acute angle with respect to the magnetization direction (magnetization vector) of a pinned layer. Here, the longitudinal direction of the GMR bars is a direction tilted at 45 degrees with respect to the X-axis and the Y-axis. Then, the pinned layer is formed in such a way that the magnetization direction (magnetization vector) is pinned (bonded) in the direction tilted at 45 degrees with respect to a negative direction of the Z-axis (the direction given by the solid-line arrows k1 (l1) in Fig. 31C based on the direction tilted at 45 degrees with respect to the X-axis and the Y-axis, which is the traveling direction of a tilted surface inside each tilted surface of the projections (ledge portions) 125.

Then, these GMR bars 122k-1, 122k-2, 122k-3 and 122k-4 (1221-1, 1221-2, 1221-3 and 1221-4) are connected in series with the bias magnet films 122k-6, 122k-7 and 122k-8 (1221-6, 1221-7 and 1221-8). Thereby, an x-axis component and a y-axis component are cancelled, and the sensitivity direction of the third z-axis GMR element 122k and the fourth z-axis GMR element 1221 is in a direction vertical to the longitudinal direction of each of the GMR bars and a negative direction of the Z-axis, namely, the direction given by the broken-line arrow k2 and l2 in Fig. 32C (the direction moving from the back to the front on the page space). Then, where a magnetic field is applied in the direction given by the broken-line arrow k2 and l2 in Fig. 32C, the resistance values of the third Z-axis GMR element 122k and the fourth Z-axis GMR element 1221 will decrease proportionally with an increase in magnetic field. Where the magnetic field is applied in the direction opposite that given by the broken-line arrow k2 and l2 in Fig. 32C, the resistance values of the third Z-axis GMR element 122k and the fourth Z-axis GMR element 1221 will increase proportionally with an increase in magnetic field.

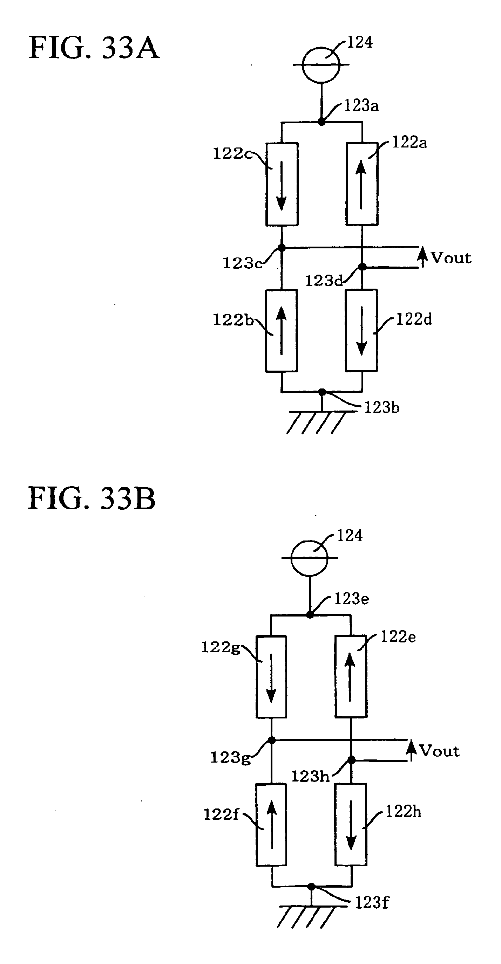

As an equivalent circuit illustrated in Fig. 33A, (it is to be noted that in Fig. 33A to Fig. 33C, individual arrows indicate a case where the magnetization direction is upward when a bonded layer of each of the GMR elements is pinned), the X-axis magnetic sensor is constituted with the first X-axis GMR element 122a to the fourth X-axis GMR element 122d, which are full-bridge-connected. In the above constitution, a pad 123a and a pad 123b are connected to a positive electrode and a negative electrode of a constant voltage source 124, thereby imparting a potential Vxin+ (3V in this embodiment) and a potential Vxin- (0(V) in this embodiment). Then, the potential of a pad 123c and a pad 123d is output respectively as a potential Vxout + and a potential Vxout-, and a potential difference (Vxout+ - Vxout-) is output as a sensor output Vxout.

As an equivalent circuit illustrated in Fig. 33B, the Y-axis magnetic sensor is constituted with the first Y-axis GMR element 122e to the fourth Y-axis GMR element 122h, which are full-bridge-connected. Then, a pad 123e and a pad 123f are connected to a positive electrode and a negative electrode of a constant voltage source 124, thereby imparting a potential Vyin+ (3V in this embodiment) and a potential Vyin- (0(V) in this embodiment), and a potential difference between a pad 123g and a pad 123h is output as a sensor output Vyout.

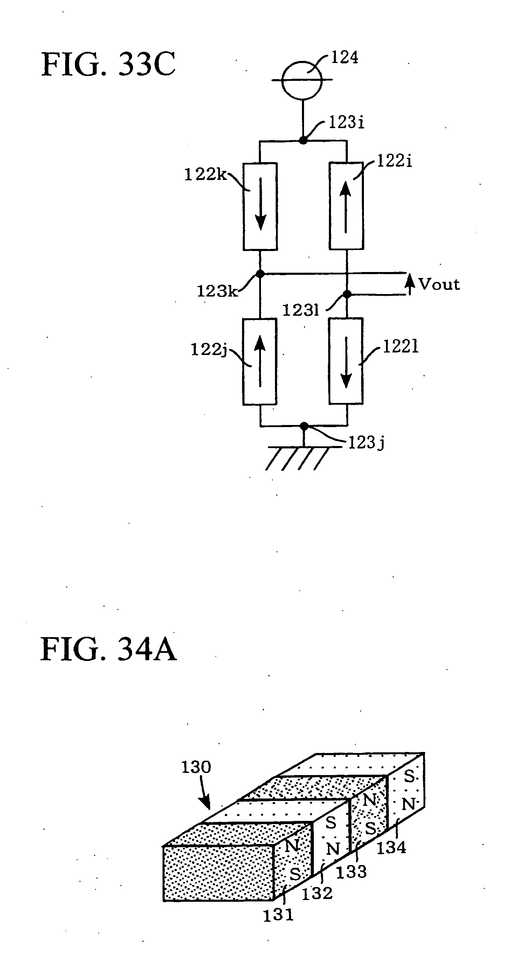

As an equivalent circuit illustrated in Fig. 33C, the Z-axis magnetic sensor is constituted with the first Z-axis GMR element 122i, the second Z-axis GMR element 122j, the first non-magnetic resistor 122k and the second non-magnetic resistor 1221, which are full-bridge-connected. Then, a pad 123i and a pad 123j are connected to a positive electrode and a negative electrode of a constant voltage source 124, thereby imparting a potential Vyin+ (3V in this embodiment) and a potential Vyin- (0(V) in this embodiment). Then, the potential difference between a pad 123k a pad 1231 is output as a sensor output Vyout.

Since the three-axis magnetic sensor 120 of the sixth embodiment is manufactured by a method similar to that for the three-axis magnetic sensor 110 of the fifth embodiment, an explanation for the method will be omitted here. However, a brief explanation will be made as follows for heat treatment for regularization (pinning treatment).

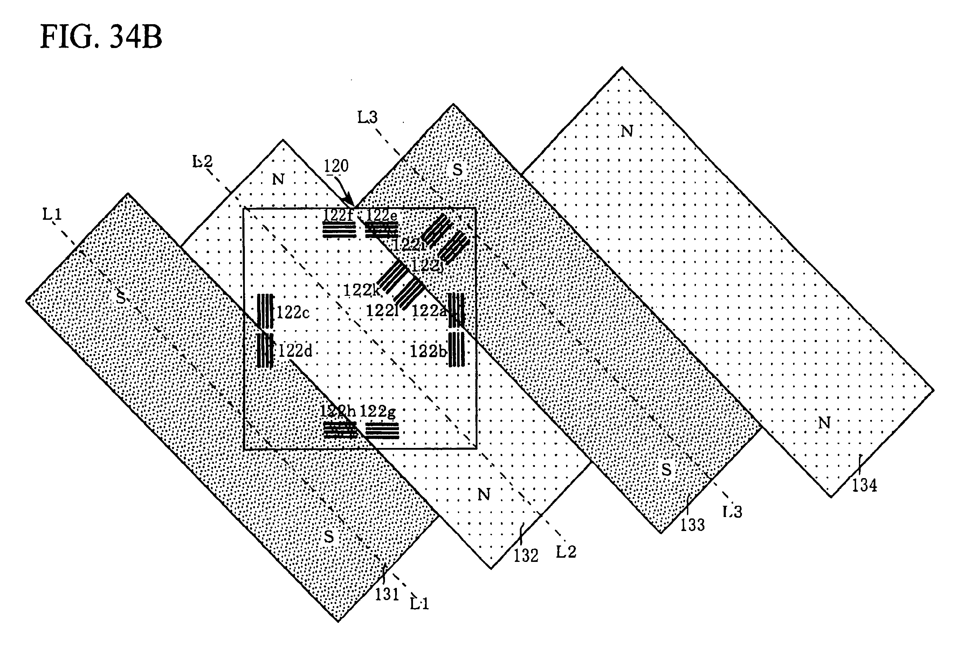

In conducting the heat treatment for regularization (pinning treatment) for manufacture of the three-axis magnetic sensor 120 of the sixth embodiment, as schematically illustrated in Fig. 34A, a permanent bar magnet array (magnet array) 130 is prepared, in which adjacent permanent bar magnet pieces 131, 132, 133 and 134 are arranged mutually in parallel so that the upper ends (lower ends) are mutually different in polarity. Then, the permanent bar magnet array 130 is arranged at the upper portion of a substrate 121 so as to give 45 degrees with respect to the side of the substrate 121, and heated to a predetermined temperature to conduct the heat treatment. More specifically, in a state given in Fig. 34B, the permanent bar magnet array (magnet array) 130 and the substrate 121 are fixed and heated in vacuum at temperatures from 260°C to 290°C. Then, the magnet array is allowed to stand for 4 hours, as it is, thereby conducting the heat treatment for regularization (pinning treatment). Fig. 34B illustrates a state of the magnetic pole on a lower surface of the permanent bar magnet array 130.

Here, as illustrated in Fig. 34B, since the first X-axis GMR element 122a is positioned further left from a width-directional center line L3 of the permanent bar magnet piece 133, and the second X-axis GMR element 122b is positioned further right from a width-directional center line L2 of the permanent bar magnet piece 132, they become magnetized in the direction of the magnetic field from the permanent bar magnet piece 132 toward the permanent bar magnet piece 133. Thereby, in the first X-axis GMR element 122a and the second X-axis GMR element 122b, the magnetization direction of a pinned layer is fixed in the direction given by the solid-line arrows a1 and b1 in Fig. 32A. Similarly, since the third X-axis GMR element 122c is positioned further left from a width-directional center line L2 of the permanent bar magnet piece 132, and the fourth X-axis GMR element 122d is positioned further right from a width-directional center line L1 of the permanent bar magnet piece 131, they become magnetized in the direction of the magnetic field from the permanent bar magnet piece 132 toward the permanent bar magnet piece 131. Thereby, in the third X-axis GMR element 122c and the fourth X-axis GMR element 122d, the magnetization direction of the pinned layer is fixed in the direction given by the solid-line arrows c1 and d1 in Fig. 32A.

Further, since the first Y-axis GMR element 122e is positioned further left from a width-directional center line L3 of the permanent bar magnet piece 133 and the second Y-axis GMR element 122f is positioned further right from a width-directional center line L2 of the permanent bar magnet piece 132, they become magnetized in the direction of the magnetic field from the permanent bar magnet piece 132 to the permanent bar magnet piece 133. Thereby, in the first Y-axis GMR element 122e and the second Y-axis GMR element 122f, the magnetization direction of a pinned layer is fixed in the direction given by the solid-line arrows e1 and f1 in Fig. 32A. Similarly, since the third Y-axis GMR element 122g is positioned further left from a width-directional center line L2 of the permanent bar magnet piece 132, and the fourth Y-axis GMR element 122h is positioned further right from a width-directional center line L1 of the permanent bar magnet piece 131, they become magnetized in the direction of the magnetic field from the permanent bar magnet piece 132 toward the permanent bar magnet piece 133. Thereby, in the third Y-axis GMR element 122g and the fourth Y-axis GMR element 122h, the magnetization direction of the pinned layer is fixed in the direction given by the solid-line arrows g1 and h1 in Fig. 32A.

Still further, since the first Z-axis GMR element 122i and the second Z-axis GMR element 122j are positioned further left from a width-directional center line L3 of the permanent bar magnet piece 133, they become magnetized in the direction of a magnetic field intersecting upwardly the substrate among the magnetic fields from the permanent bar magnet piece 132 to the permanent bar magnet piece 133. Thereby, in the first Z-axis GMR element 122i and the second Z-axis GMR element 122j, the magnetization direction of a pinned layer is fixed in the direction given by the solid-line arrows i1 and j1 in Fig. 32B, and in the direction tilted at 45 degrees from the X-axis to a positive direction of the Z-axis inside a tilted surface of each of the projections (ledge portions) 125. Similarly, since the third Z-axis GMR element 122k and the fourth Z-axis GMR element 122l are positioned further right from a width-directional center line L2 of the permanent bar magnet piece 132, they become magnetized in the direction of a magnetic field intersecting downwardly the substrate among the magnetic fields from the permanent bar magnet piece 132 to the permanent bar magnet piece 133. Thereby, in the third Z-axis GMR element 122k and the fourth Z-axis GMR element 1221, the magnetization direction of a pinned layer is fixed in the direction given by the solid-line arrows k1 and l1 in Fig. 32C and in the direction tilted at 45 degrees from the X-axis to a negative direction of the Z-axis inside a tilted surface of the projection (ledge portion) 125.

(Seventh embodiment)

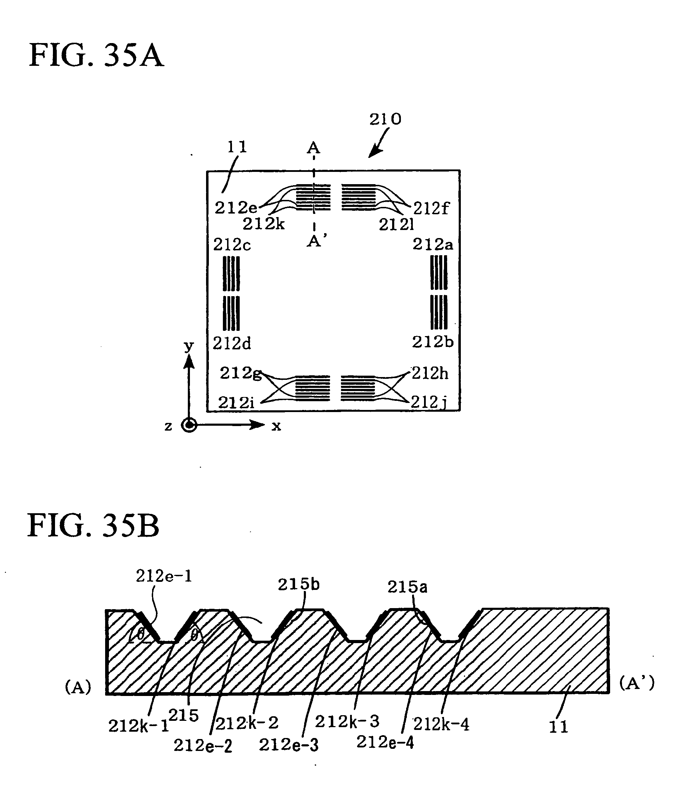

Next, an explanation will be made of a seventh embodiment of the present invention in detail by referring to Fig. 35A to Fig. 45.

As illustrated in Fig. 35A and Fig. 35B, a three-axis magnetic sensor 210 of the seventh embodiment is in a square shape having the sides along the X-axis and the Y-axis orthogonal to each other, when viewed from above, and is provided with a substrate 11 made with quartz or silicon, which has a small thickness in the direction of the Z-axis orthogonal to the X-axis and the Y-axis. Then, a total of 12 GMR elements, namely, four each of the X-axis GMR elements 212a to 212d, the Y-axis GMR elements 212e to 212h and Y2-axis GMR elements 212i to 212l, a pad portion (which takes out an output from a wiring, not illustrated), a via portion (connected to the wiring from GMR elements but not finally exposed, not illustrated) and the wiring (riot illustrated) are fabricated on the substrate 11. An LSI and a wiring layer are also fabricated into the substrate 11. A substrate into which the LSI is fabricated is used to provide a magnetic sensor based on a digital output, while a substrate into which only the wiring layer is fabricated is used to provide a magnetic sensor based on an analog output.

Here, the X-axis GMR elements are constituted with a first X-axis GMR element 212a, a second X-axis GMR element 212b, a third X-axis GMR element 212c and a fourth X-axis GMR element 212d. The first X-axis GMR element 212a is arranged above at approximately the central portion of the Y-axis (hereinafter, referred to as Y-axis central portion) (here, the lower end portion in Fig. 35A is given as a reference point of the Y-axis, a direction moving from the reference point to above in the drawing is given as a positive direction of the Y-axis, the opposite direction thereof is given as a negative direction of the Y-axis, and the same shall apply hereinafter) in the vicinity of the right end portion of the X-axis of a substrate 11 (here, the left end portion in Fig. 35A is given as a reference point of the X-axis and a direction toward the right in the drawing from the reference point is given as a positive direction of the X-axis, the opposite direction thereof is given as a negative direction of the X-axis, and the same shall apply hereinafter), and the second X-axis GMR element 212b is arranged below thereof Further, the third X-axis GMR element 212c is arranged above at the Y-axis central portion in the vicinity of the X-axis left end portion of the substrate 11, and the fourth X-axis GMR element 212d is arranged below thereof

Further, the Y1-axis GMR elements are constituted with a first Y1-axis GMR element 212e, a second Y1-axis GMR element 212f, a third Y1-axis GMR element 212g and a fourth Y1-axis GMR element 212h. Then, the first Y1-axis GMR element 212e is arranged on the left of the X-axis central portion in the vicinity of the Y-axis upper end portion of the substrate 11, and the second Y1-axis GMR element 212f is arranged on the right thereof. Further, the third Y1-axis GMR element 212g is arranged on the left of the X-axis central portion in the vicinity of the Y-axis lower end portion of the substrate 11, and the fourth Y1-axis GMR element 212h is arranged on the right thereof

Still further, the Y2-axis GMR elements are constituted with a first Y2-axis GMR element 212i, a second Y2-axis GMR element 212j, a third Y2-axis GMR element 212k and a fourth Y2-axis GMR element 212l. Then, the first Y2-axis GMR element 212i is arranged on the left of the X-axis central portion in the vicinity of the Y-axis lower end portion of a substrate 11, and the second Y2-axis GMR element 212j is arranged on the right thereof. Further, the third Y2-axis GMR element 212k is arranged on the left of the X-axis central portion in the vicinity of the Y-axis upper end portion of the substrate 11, and the fourth Y2-axis GMR element 212l is arranged on the right thereof.

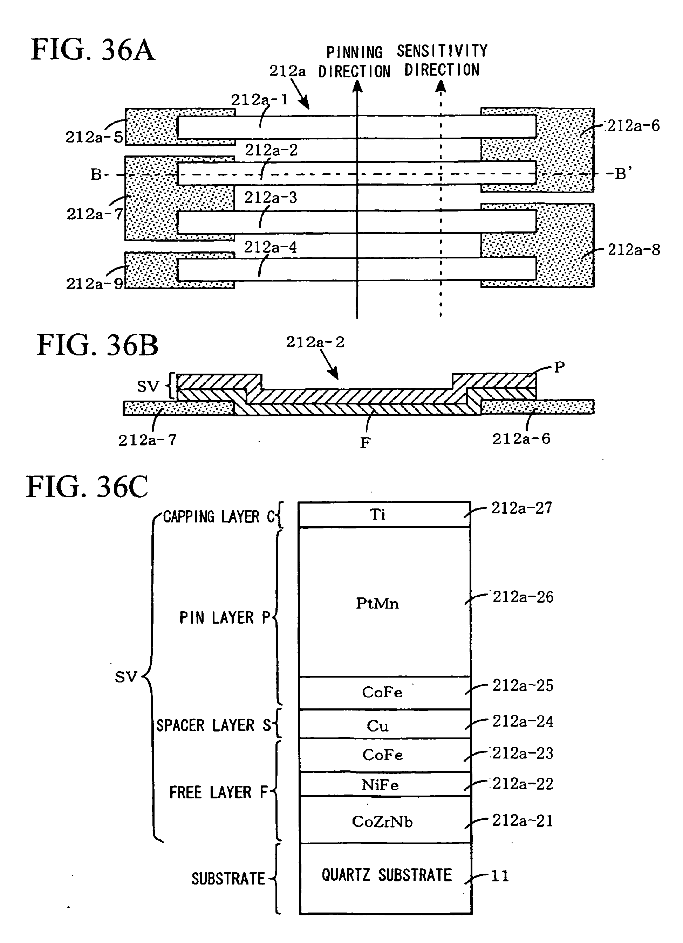

Here, each of the GMR elements 212a to 212d, 212e to 212h and 212i to 212l is respectively provided with four GMR bars mutually parallel and arranged adjacently in a band form. These four GMR bars are connected in series with magnet films (bias magnet films), and the magnet films which will act as a terminal are connected to these ends. For example, as illustrated in Fig. 36A to Fig. 36C (Fig. 36A to Fig. 36C indicate only the first X-axis GMR element 212a because other GMR elements are similar in constitution), the four GMR bars 212a-1, 212a-2, 212a-3 and 212a-4 are connected in series with the magnet films 212a-6, 212a-7, 212a-8, and the magnet films 212a-5 and 212a-9 which will act as a terminal are connected to their ends. Here, each of the GMR bars (212a-1, 212a-2, 212a-3, 212a-4, etc.) of the X-axis GMR elements 212a to 212d is formed on a surface parallel to the surface of the substrate 11 and arranged in such a way that the longitudinal direction is parallel to the Y-axis (orthogonal to the X-axis).

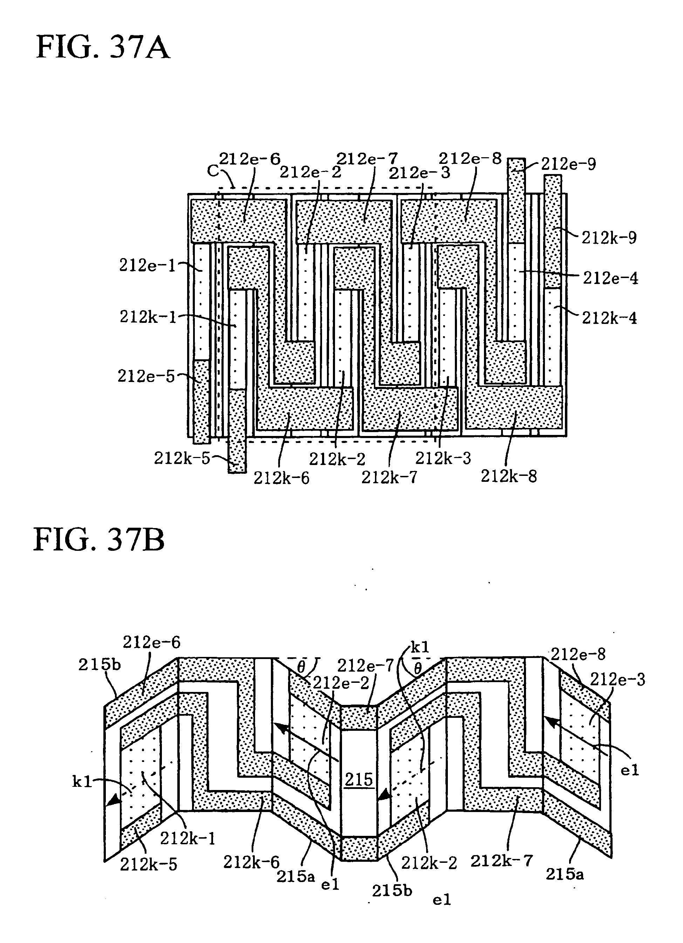

Further, as illustrated in Fig. 35A and Fig. 37B, Y1-axis GMR elements and the Y2-axis GMR elements are formed on each tilted surface of a plurality of grooves (valley portions) 215 formed on a substrate 11 and the cross section of which is trapezoidal shape. The Y1-axis GMR elements are formed on a first tilted surface 215a of the groove (valley portion) 215, and the Y2-axis GMR elements are formed on a second tilted surface 215b of the groove (valley portion) 215. Each of the tilted surfaces 215a and 215b is equal in tilted angle, and formed so as to give θ ($30° < θ < 60°$) on a flat surface of the substrate. Then, as illustrated in Fig. 35B and Fig. 37B, each of the GMR elements (for example, 212e-2) of the Y1-axis GMR elements and each of the GMR elements (for example, 212k-2) of the Y2-axis GMR elements are arranged, back to back on one groove 215. Here, each of the GMR bars of the Y1-axis GMR elements 212e to 212h and each of the GMR bars of the Y2-axis GMR elements 212i to 212l are arranged in such a way that the longitudinal direction is parallel to the X-axis (vertical to the Y-axis).

Next, an explanation will be made of the constitution of GMR bars by referring to the GMR bar 212a-2 of the first X-axis GMR element 212a on the basis of Fig. 36A to Fig. 36C. Since other GMR bars 212a-1, 212a-3, 212a-4 are similar in constitution thereto, an explanation will be made of only the GMR bar 212a-2 here. Further, since GMR bars of other X-axis GMR elements 212b, 212c and 212d, Y1-axis GMR elements 212e, 212f, 212g and 212h and Y2-axis GMR elements 212i, 212j, 212k and 212l are also similar in constitution, they will not be explained here.

Here, as illustrated in Fig. 36B, which is a schematic sectional view cut by a flat surface along line B-B' in Fig. 36A, the GMR bar 212a-2 of the first X-axis GMR element 212a is made of a spin valve film SV arranged in such a way that the longitudinal direction is vertical to the X-axis (parallel to the Y-axis). This bar is a hard ferromagnetic body such as CoCrPt formed below both ends of the film and provided with magnet films (bias magnet film: hard ferromagnetic body thin film layer) 212a-6 and 212a-7 made with a material having a high coercive force. As the film constitution illustrated in Fig. 36C, the spin valve film SV is constituted with a free layer (free layer, free magnetization layer) F, a conductive spacer layer S made with Cu having the thickness of 2.4nm (24Å), a pin layer (bonded layer, fixed magnetization layer) P and a capping layer C made with titanium (Ti) or tantalum (Ta) having the thickness of 2.5nm (25Å), which are laminated sequentially on a substrate 11.

The free layer F is a layer in which the magnetization direction will change according to the direction of an external magnetic field, and constituted with a CoZrNb amorphous magnetic layer 212a-21 formed immediately on the substrate 11 having the thickness of 8nm (80Å), a NiFe magnetic layer 212a-22 formed on the CoZrNb amorphous magnetic layer 212a-21 having the thickness of 3.3nm (33Å) and a CoFe layer 212a-23 formed on the NiFe magnetic layer 212a-22 having the thickness of 1 to 3nm (10 to 30Å). The CoZrNb amorphous magnetic layer 212a-21 and the NiFe magnetic layer 212a-22 constitute a soft ferromagnetic thin film layer. The CoFe layer 212a-23 is provided for preventing the dispersion of Ni in the NiFe layer 212a-22 and Cu 212a-24 in the spacer layer S.

The pin layer P is obtained by adhering a CoFe magnetic layer 212a-25 having the thickness of 2.2nm (22A) to an antiferromagnetic film 212a-26 made with a PtMn alloy containing Pt at 45 to 55mol% having the thickness of 24nm (240Å). The CoFe magnetic layer 212a-25 constitutes a pinned layer in which the magnetization direction (magnetization vector) is pinned (bonded) in a positive direction of the X-axis by being backed in a manner of a switched connection to the antiferromagnetic film 212a-26, which is magnetized.

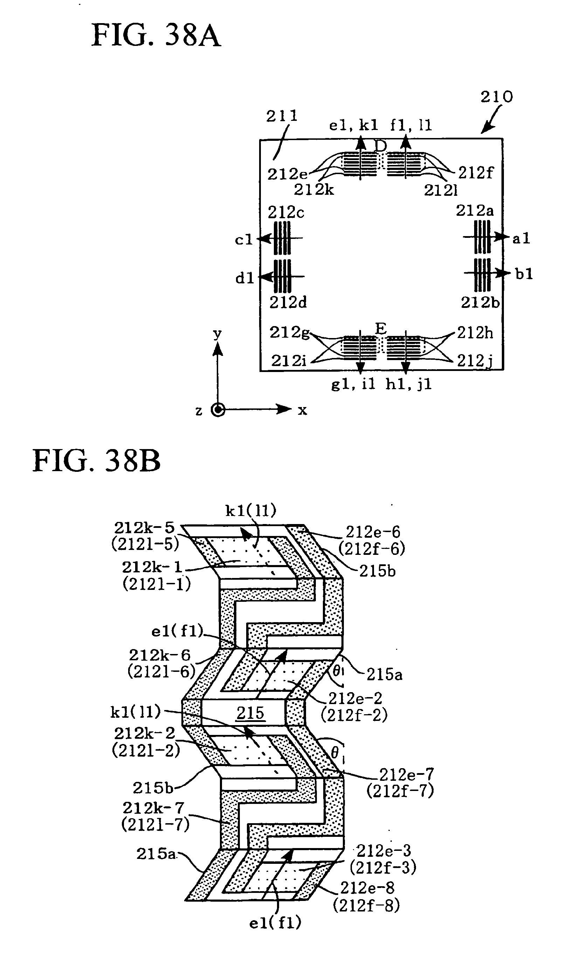

In order to keep uniaxial anisotropy of a free layer F, bias magnet films 221 a-5, 212a-6, 212a-7, 212a-8 and 212a-9 of the above-described first X-axis GMR element 212a impart a bias magnetic field in a direction parallel to the longitudinal direction of each of the GMR bars with respect to the free layer F (the direction vertical to the X-axis). Then, the CoFe magnetic layer 212a-25 (the same shall apply to other GMR bars 212a-1, 212a-3 and 212a-4) constitutes a pinned layer in such a way that the magnetization direction (magnetization vector) is pinned (bonded) in a positive direction of the X-axis (the direction given by the solid-line arrow a1 in Fig. 38A) by being backed in a manner of a switched connection to the antiferromagnetic film 212a-26, which is magnetized. Similarly, the second X-axis GMR element 222 imparts a bias magnetic field in a direction parallel to the longitudinal direction of each of the GMR bars (the direction vertical to the X-axis). Then, the pinned layer is formed in such a way that the magnetization direction (magnetization vector) is pinned (bonded) in a positive direction of the X-axis (the direction given by the arrow b1 in Fig. 38A).

Thereby, in the first X-axis GMR element 212a and the second X-axis GMR element 212b, the sensitivity direction of a magnetic field is a direction vertical to the longitudinal direction of each of the GMR bars, namely, a positive direction of the X-axis (the direction given by the arrows a1 and b1 in Fig. 38A). Where a magnetic field is applied in the direction given by the arrows a1 and b1 in Fig. 38A, the resistance values of the first X-axis GMR element 212a and the second X-axis GMR element 212b will decrease proportionally with an increase in magnetic field. Where the magnetic field is applied in the direction opposite that given by the arrows a1 and b1 in Fig. 38A, the resistance values of the first X-axis GMR element 212a and the second X-axis GMR element 212b will increase proportionally with an increase in magnetic field.

In contrast, in the third X-axis GMR element 212c and the fourth X-axis GMR element 212d, the bias magnet film imparts a bias magnetic field in a direction opposite 180 degrees to the first X-axis GMR element 212a and the second X-axis GMR element 212b and in a direction parallel to the longitudinal direction of each of the GMR bars (the direction vertical to the X-axis). Then, a pinned layer is formed in such a way that the magnetization direction (magnetization vector) is pinned (bonded) in a negative direction of the X-axis (the direction given by the arrows c1 and d1 in Fig. 38A and the direction opposite 180 degrees to the magnetization direction of the pinned layer of the first X-axis GMR element 212a and the second X-axis GMR element 212b).

Thereby, the sensitivity direction of a magnetic field is a direction vertical to the longitudinal direction of each of the GMR bars, namely, the direction given by the arrows c1 and d1 in Fig. 38A (the direction opposite 180 degrees to the sensitivity direction of the first X-axis GMR element 212a and the second X-axis GMR element 212b). Where a magnetic field is applied in the direction given by the arrows c1 and d1 in Fig. 38A, the resistance values of the third X-axis GMR element 212c and the fourth X-axis GMR element 221d will decrease proportionally with an increase in magnetic field. Where the magnetic field is applied in the direction opposite that given by the arrows c1 and d1 in Fig. 38A, the resistance values of the third X-axis GMR element 212c and the fourth X-axis GMR element 212d will increase proportionally with an increase in magnetic field.

Further, as schematically illustrated in Fig. 38B, in the first Y1-axis GMR element 212e and the second Y1-axis GMR element 212f, bias magnet films (for example, 212e-6, 212e-7 and 212e-8, and 212f-6, 212f-7 and 212f-8, etc., as shown in Fig. 38B) impart a bias magnetic field in a direction parallel to the longitudinal direction of each of the GMR bars (for example, 212e-2 and 212e-3, and 212f-2 and 212f-3, etc., as shown in Fig. 38B), namely, on a flat surface of the first tilted surface (tilted angle of θ) 212a of the groove (valley portion) 215 a direction in which the longitudinal direction is parallel to the X-axis (a traveling direction of the ridge of the groove (valley portion) 215). A pinned layer is formed in such a way that the magnetization direction (magnetization vector) is pinned (bonded) in a positive direction of the Y-axis along a first tilted surface 215a of the groove (valley portion) 215 and a positive direction of the Z-axis (the direction given by the solid-line arrows e1 (f1) in Fig. 38B).

Then, these GMR bars (212e-2 and 212e-3, and 212f-2 and 212f-3, etc., as shown in Fig. 38B) are connected in series with bias magnet films (212e-6, 212e-7 and 212e-8, and 212f-6, 212f-7 and 212f-8, etc., as shown in Fig. 38B). Thereby, the sensitivity direction of a magnetic field is a direction vertical to the longitudinal direction of each of the GMR bars, a positive direction of the Y-axis along the first tilted surface 215a of the groove (valley portion)215 and a positive direction of the Z-axis (the direction given by the solid-line arrows e1 (fl) in Fig. 38B). Where a magnetic field having a component in the direction given by the arrows e1 (f1) in Fig. 38A is applied, the resistance values of the first Y1-axis GMR element 212e and the second Y1-axis GMR element 212f will decrease proportionally with an increase in magnetic field. Where a magnetic field having a component in the direction opposite that given by the arrows e1 (fl) in Fig. 38A is applied, the resistance values of the first Y1-axis GMR element 212e and the second Y1-axis GMR element 212f will increase proportionally with an increase in magnetic field.

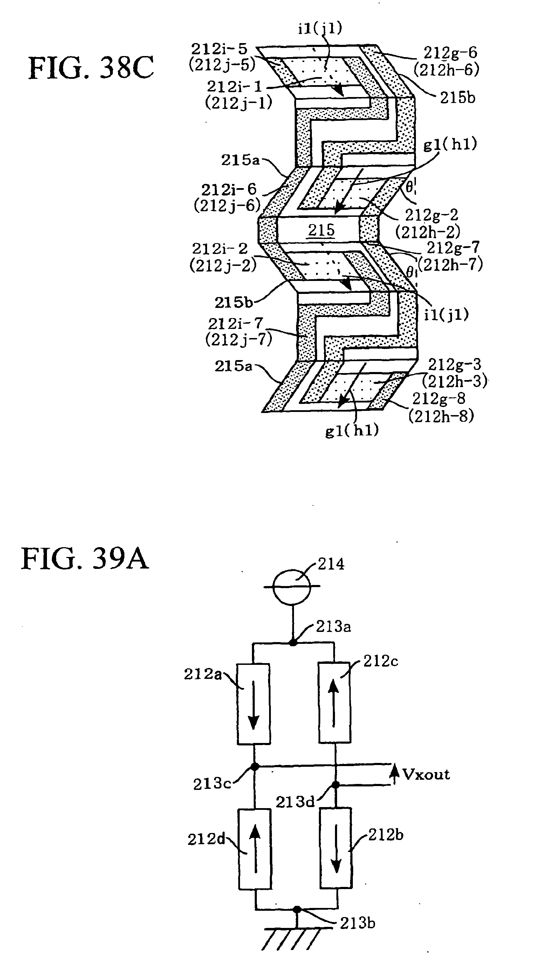

In contrast, as schematically illustrated in Fig. 38C, in the third Y1-axis GMR element 212g and the fourth Y1-axis GMR element 212h, bias magnet films (for example, 212g-6, 212g-7 and 212g-8, and 212h-6, 212h-7 and 212h-8, etc., as shown in Fig. 38C) impart a bias magnetic field in a direction parallel to the longitudinal direction of each of the GMR bars (for example, 212g-2 and 212g-3, and 212h-2 and 212h-3, etc., as shown in Fig. 38C), namely, on a flat surface of a first tilted surface (tilted angle of θ) 215a of the groove (valley portion) 215, a direction in which the longitudinal direction is parallel to the X-axis (a traveling direction of the ridge of the groove (valley portion) 215). A pinned layer is formed in such a way that the magnetization direction (magnetization vector) is pinned (bonded) in a negative direction of the Y-axis along the first tilted surface 215a of the groove (valley portion) 215 and a negative direction of the Z-axis (the direction given by the solid-line arrows g1 (h1) in Fig. 38C).

Then, these GMR bars (212g-2 and 212g-3, and 212h-2 and 212h-3, etc., as shown in Fig. 38C) are connected in series with bias magnet films (212g-6, 212g-7 and 212g-8, and 212h-6, 212h-7 and 212h-8, etc., as shown in Fig. 38C). Thereby, the sensitivity direction of a magnetic field is a direction vertical to the longitudinal direction of each of the GMR bars, a negative direction of the Y-axis along the first tilted surface 215a of the groove (valley portion)215 and a negative direction of the Z-axis (the direction given by the solid-line arrows g1 (h1) in Fig. 38C). Where a magnetic field having a component in the direction given by the arrows g1 (h1) in Fig. 38A is applied, the resistance values of the third Y1-axis GMR element 212g and the fourth Y1-axis GMR element 212h will decrease proportionally with an increase in magnetic field. Where a magnetic field having a component in the direction opposite that given by the arrows g1 (h1) in Fig. 38A is applied, the resistance values of the third Y1-axis GMR element 212g and the fourth Y1-axis GMR element 212h will increase proportionally with an increase in magnetic field.

Further, as schematically illustrated in Fig. 38C, in the first Y2-axis GMR element 212i and the second Y2-axis GMR element 212j, bias magnet films (for example, 212i-5, 212i-6 and 212i-7, and 212j-5, 212j-6 and 212j-7, etc., as shown in Fig. 38C) impart a bias magnetic field in a direction parallel to the longitudinal direction of each of the GMR bars (for example, 212i-1 and 212i-2, and 212j-1 and 212j-2, etc., as shown in Fig. 38C), namely, on a flat surface of a second tilted surface (tilted angle of θ) 215b of the groove (valley portion) 215, a direction in which the longitudinal direction is parallel to the X-axis (a traveling direction of the ridge of the groove (valley portion) 215). Then, a pinned layer is formed in such a way that the magnetization direction (magnetization vector) is pinned (bonded) in a negative direction of the Y-axis along the second tilted surface 215b of the groove (valley portion) 215 and a positive direction of the Z-axis (the direction given by the broken-line arrows i1 (j1) in Fig. 38C).

Then, these GMR bars (212i-1 and 212i-2, and 212j-1 and 212j-2, etc., as shown in Fig. 38C) are connected in series with bias magnet films (212i-5, 212i-6 and 212i-7, and 212j-5, 212j-6 and 212j-7, etc., as shown in Fig. 38C). Thereby, the sensitivity direction of a magnetic field is a direction vertical to the longitudinal direction of each of the GMR bars, a negative direction of the Y-axis along the second tilted surface 215b of the groove (valley portion)215 and a positive direction of the Z-axis (the direction given by the solid-line arrows i1 (j1) in Fig. 38C). Where a magnetic field having a component in the direction given by the arrows i1 (j1) in Fig. 38A is applied, the resistance values of the first Y2-axis GMR element 212i and the second Y2-axis GMR element 212j will decrease proportionally with an increase in magnetic field. Where a magnetic field having a component in the direction opposite that given by the arrows i 1 (j1) in Fig. 38A is applied, the resistance values of the first Y2-axis GMR element 212i and the second Y2-axis GMR element 212j will increase proportionally with an increase in magnetic field.

In contrast, as schematically illustrated in Fig. 38B, in the third Y2-axis GMR element 212k and the fourth Y2-axis GMR element 2121, bias magnet films (for example, 212k-5, 212k-6 and 212k-7, and 2121-5, 2121-6 and 2121-7, etc., as shown in Fig. 38B) impart a bias magnetic field in a direction parallel to the longitudinal direction of each of the GMR bars (for example, 212k-1 and 212k-2, and 2121-1 and 2121-2, etc., as shown in Fig. 38B), namely, on a flat surface of a second tilted surface (tilted angle of θ) 215b of the groove (valley portion) 215, a direction in which the longitudinal direction is parallel to the X-axis (a traveling direction of the ridge of the groove (valley portion) 215). A pinned layer is formed in such a way that the magnetization direction (magnetization vector) is pinned (bonded) in a positive direction of the Y-axis along the second tilted surface 215b of the groove (valley portion) 215 and a negative direction of the Z-axis (the direction given by the broken-line arrows k1 (l1) in Fig. 38B).

Then, these GMR bars (212k-1 and 212k-2, and 2121-1 and 2121-2, etc., as shown in Fig. 38C) are connected in series with bias magnet films (212k-5, 212k-6 and 212k-7, and 2121-5, 2121-6 and 2121-7, etc., as shown in Fig. 38B). Thereby, the sensitivity direction of a magnetic field is a direction vertical to the longitudinal direction of each of the GMR bars, a positive direction of the Y-axis along the second tilted surface 215b of the groove (valley portion)215 and a negative direction of the Z-axis (the direction given by the broken-line arrows k1 (l1) in Fig. 38B). Where a magnetic field having a component in the direction given by the arrows k1 (l1) in Fig. 38A is applied, the resistance values of the third Y2-axis GMR element 212k and the fourth Y2-axis GMR element 2121 will decrease proportionally with an increase in magnetic field. Where a magnetic field having a component in the direction opposite that given by the arrows k1 (l1) in Fig. 38A is applied, the resistance values of the third Y2-axis GMR element 212k and the fourth Y2-axis GMR element 2121 will increase proportionally with an increase in magnetic field.

As an equivalent circuit illustrated in Fig. 39A, (it is to be noted that in Fig. 39A, individual arrows indicate a case where the magnetization direction is upward when a bonded layer of each of the GMR elements is pinned in the direction of the X-axis), the X-axis magnetic sensor is constituted with the first X-axis GMR element 211a to the fourth X-axis GMR element 212d, which are full-bridge-connected. In this constitution, a pad 213a and a pad 213b are connected to a positive electrode and a negative electrode of a constant voltage source 214, thereby imparting a potential Vxin+ (3V in this embodiment) and a potential Vxin- (0(V) in this embodiment). Then, the potentials of a pad 213c and a pad 213d are output respectively as a potential Vxout+ and a potential Vxout-, and the potential difference (Vxout+ - Vxout-) is output as a sensor output Vxout.

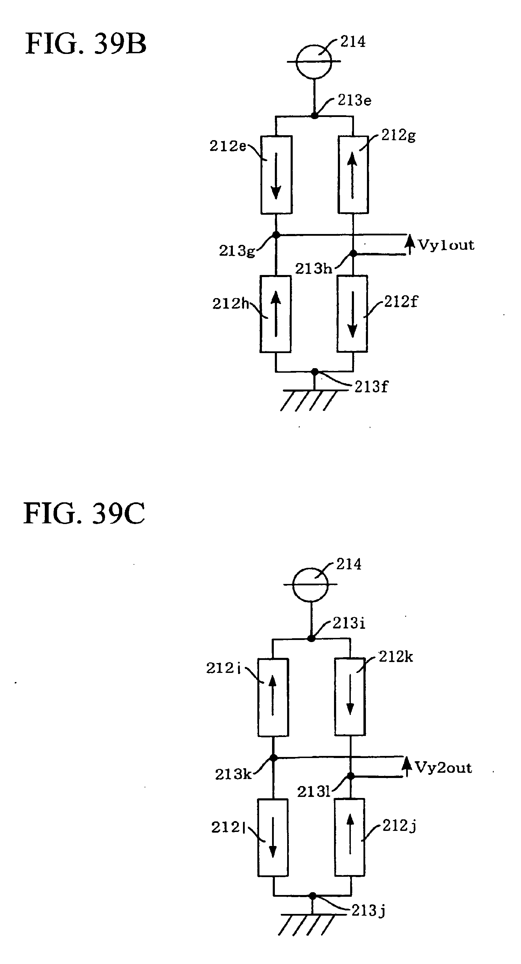

As an equivalent circuit illustrated in Fig. 39B, the Y1-axis magnetic sensor is constituted with the first Y1-axis GMR element 212e to the fourth Y1-axis magnetic sensor 212h, which are full-bridge-connected. It is to be noted that in Fig. 39B and Fig. 39C, individual arrows indicate a case where the magnetization direction is upward when a bonded layer of each of the GMR elements is pinned. Then, a pad 213e and a pad 213f are connected to a positive electrode and a negative electrode of a constant voltage source 214, thereby imparting a potential Vy1in+ (3V in this embodiment) and a potential Vy1in- (0(V) in this embodiment). Then, the potential difference between a pad 213g and a pad 213h is output as a sensor output Vy1out.

As an equivalent circuit illustrated in Fig. 39C, the Y2-axis magnetic sensor is constituted with the first Y2-axis GMR element 212i to the fourth Y2-axis magnetic sensor 2121, which are full-bridge-connected. Then, a pad 213i and a pad 213j are connected to a positive electrode and a negative electrode of a constant voltage source 214, thereby imparting a potential Vy2in+ (3V in this embodiment) and a potential Vy2in- (0(V) in this embodiment). Then, the potential difference between a pad 213k and a pad 2131 is output as a sensor output Vy2out.

Then, on the basis of the thus obtained output Vxout, Vy1out and Vy2out, Hx, a component of a magnetic field in the X-axis direction, can be obtained by the following formula (4). Similarly, Hy, a component of a magnetic field in the Y-axis direction, can be obtained by the following formula (5), and Hz, a component of a magnetic field in the Z-axis direction, can be obtained by the following formula (6). It is to be noted that these calculations are to be made by referring to an LSI which has been previously provided on a substrate 11.

$$Hx = 2kx \times Vxout \ ... \ (4)$$

$$Hy = ky \, (Vy1out - Vy2out) \, /\cos\theta \ ... \ (5)$$

$$Hz = kz \, (Vy1out + Vy2out) \, /\sin\theta \ ... \ (6)$$

Wherein, θ is a tilted angle of each of the tilted surfaces 215a, 215b in the groove (valley portion) 215, and, here, θ satisfies the relationship of 30°<θ<60°. Further, kx, ky and kx are a constant of proportionality and the relationship of kx = ky = kz can be obtained when each of the sensors is equal in sensitivity.

The above-constituted three-axis magnetic sensor is manufactured by processes similar to those described in paragraphs [0068] through [0080] by referring to Fig. 5A, Fig. 5B and Fig. 5C to Fig. 14A, Fig. 14B and Fig. 14C.

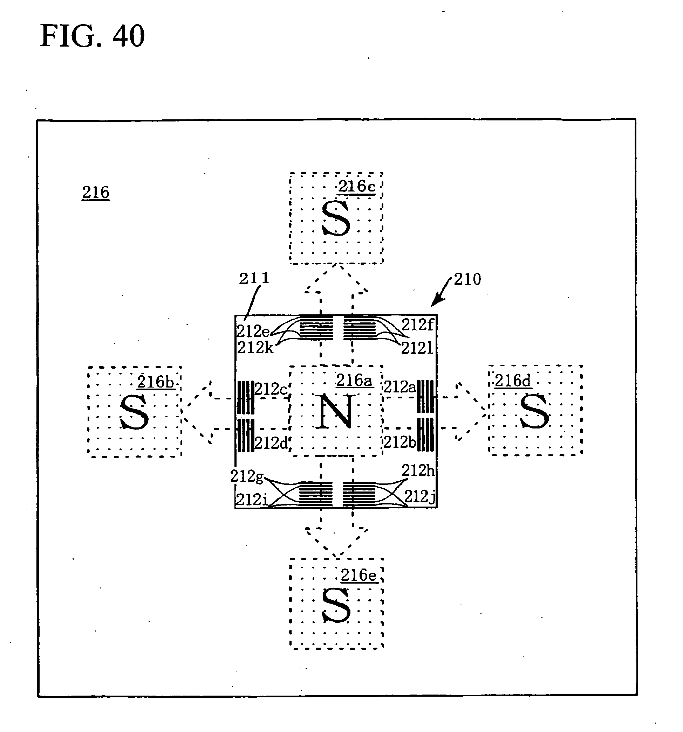

Here, as schematically illustrated in Fig. 40 (in terms of permanent bar magnet pieces, Fig. 40 indicates only five of them), heat treatment for regularization (pinning treatment) is conducted by arranging a permanent bar magnet array (magnet array) 216 on a substrate 11, heating the magnet array in a vacuum at temperatures from 260°C to 290°C and allowing it to stand for approximately four hours. More specifically, first, the permanent bar magnet array (magnet array) 216 is prepared, in which adjacent permanent bar magnet pieces are arranged in a lattice form so that the upper ends (lower ends) are mutually different in polarity. Thereafter, the permanent bar magnet array 216 is arranged in such a way that a permanent bar magnet piece 216a (the lower end is given as an N pole) is arranged above the center of the substrate 11, while permanent bar magnet pieces 216b, 216c and 216e (the lower ends are given as a S pole) are arranged on the right, left, upper and lower regions of the permanent bar magnet piece 216a outside the substrate 11.

Thereby, a magnetic field (indicated by the dotted line arrow in Fig. 40) is formed, which is different in direction at every 90 degrees and from the N pole of the permanent bar magnet piece 216a arranged above the center of the substrate 11 toward S poles of the permanent bar magnet pieces 216b, 216c, 216e adjacent to the N pole. This magnetic field is utilized to heat these pieces in a vacuum at 260°C to 290°C, allowing them to stand for approximately four hours, thereby fixing the magnetization direction of a bonded layer P (a pinned layer of the bonded layer P). Consequently, as illustrated in Fig. 38A to Fig. 38C, in the first X-axis GMR element 212a and the second X-axis GMR element 212b, the magnetization direction of the pinned layer is fixed in the direction given by the arrows a1 and b1 in Fig. 38A. In the third X-axis GMR element 212c and the fourth X-axis GMR element 212d, the magnetization direction of the pinned layer is fixed in the direction given by the arrows c1 and d1 in Fig. 38A.

In contrast, in the first Y-1axis GMR element 212e and the second Y1-axis GMR element 212f, the magnetization direction of the pinned layer is fixed in a positive direction of the Y-axis along a first tilted surface 215a of the groove (valley portion) 215, namely, the direction given by the arrows e1 (f1) in Fig. 38B. Further, in the third Y1-axis GMR element 212g and the fourth Y1-axis GMR element 212h, the magnetization direction of the pinned layer is fixed in a negative direction of the Y-axis along the first tilted surface 215a of the groove (valley portion) 215, namely, the direction given by the arrows g1 (h1) in Fig. 38C. Still further, in the first Y2-axis GMR element 212i and the second Y2-axis GMR element 212j, the magnetization direction of the pinned layer is fixed in a negative direction of the Y-axis along a second tilted surface 215b of the groove (valley portion) 215, namely, the direction given by the arrows i1 (j1) in Fig. 38C. In addition, in the third Y2-axis GMR element 212k and the fourth Y2-axis GMR element 2121, the magnetization direction of the pinned layer is fixed in a positive direction of the Y-axis along the second tilted surface 215b of the groove (valley portion) 215, namely, the direction given by the arrows k1 (11) in Fig. 38B.

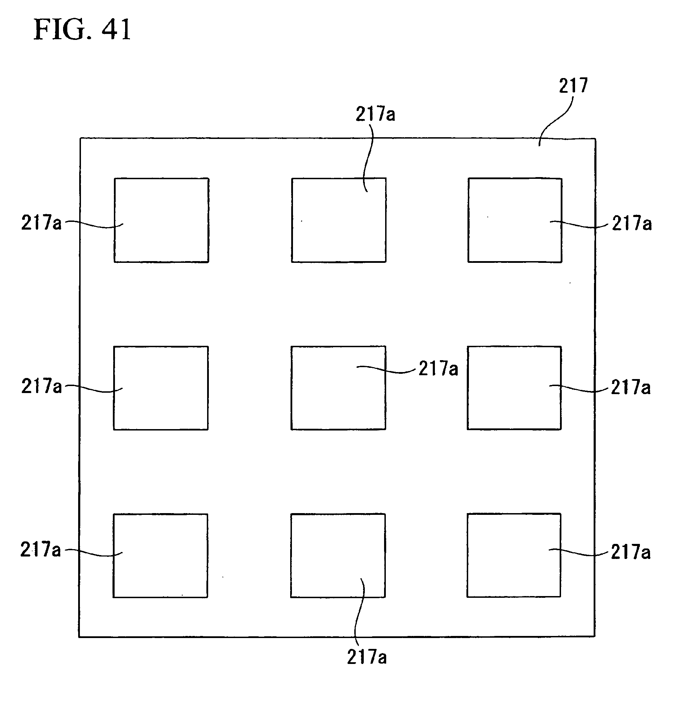

In the above-described heat treatment for regularization (pinning treatment), it is desirable to impart a strong magnetic field in a direction horizontal to each of the tilted surfaces 215a, 215b of the groove (valley portion) 215. Here, as illustrated in Fig. 41, the heat treatment is conducted by arranging the permanent bar magnet array (magnet array) on the substrate 11 having the elements as formed above, heating the magnet array in a vacuum at 260°C to 290°C and allowing it to stand for approximately four hours. Thereby, it is possible to impart a strong magnetic field to each of the tilted surfaces 215a and 215b of the groove (valley portion) 215 in a horizontal direction.

(Exemplified variations of the seventh embodiment)

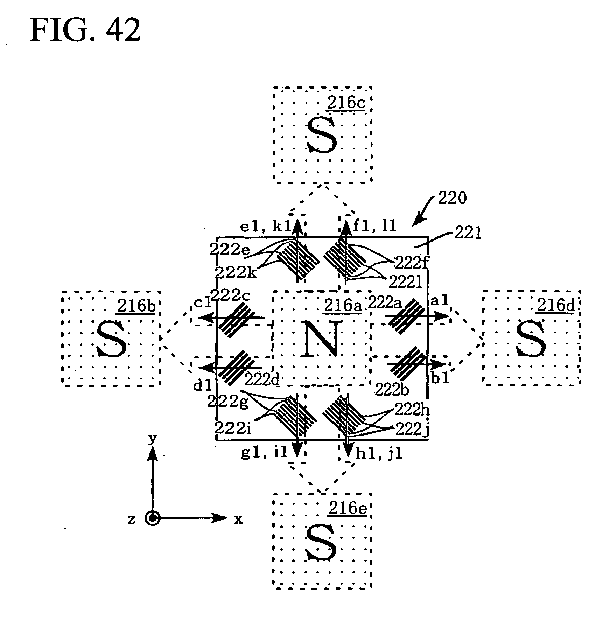

In the above-described three-axis magnetic sensor of the seventh embodiment, the arrangement relationship of each of the GMR elements can be changed in various ways to prove exemplified variations. Hereinafter, a brief explanation will be made of a representative exemplified variation of the three-axis magnetic sensor of the seventh embodiment by referring to Fig. 42 to Fig. 45. As with Fig. 35A, these drawings indicate an arrangement relationship of the permanent bar magnet array (magnet array) in heat treatment for regularization similar to the seventh embodiment, in addition to an arrangement state of each of the GMR elements on each substrate.

(First exemplified variation)

As illustrated in Fig. 42, a three-axis magnetic sensor 220 of a first exemplified variation of the seventh embodiment is similar to that of the seventh embodiment and constituted with X-axis GMR elements formed on a flat surface of a substrate 221, Y1-axis GMR elements formed on a first tilted surface of the projection (not illustrated) formed on the substrate and Y2-axis GMR elements formed on a second tilted surface of the projection. Here, the X-axis GMR elements are made up of a first X-axis GMR element 222a, a second X-axis GMR element 222b, a third X-axis GMR element 222c and a fourth X-axis GMR element 222d. Here, GMR bars constituting these elements are arranged in such a way that the longitudinal direction of each GMR bar is given at 45 degrees with respect to the X-axis (Y-axis).

Further, a ridge (or a valley portion) made up of peaks of projections is formed so as to give 45 degrees with respect to both the X-axis and Y-axis. A first Y1-axis GMR element 222e, a second Y1-axis GMR element 222f, a third Y1-axis GMR element 222g and a fourth Y1-axis GMR element 222h are formed on a first tilted surface of the projection, thereby constituting Y1-axis GMR elements. Here, since the peak (or valley portion) of the projection is formed so as to give 45 degrees with respect to the X-axis (Y-axis), GMR bars constituting these elements are arranged in such a way that the longitudinal direction of each GMR bar is also given at 45 degrees with respect to the X-axis (Y-axis).

Still further, a first Y2-axis GMR element 222i, a second Y2-axis GMR element 222j, a third Y2-axis GMR element 222k and a fourth Y2-axis GMR element 2221 are formed on a second tilted surface of the projections, thereby constituting Y2-axis GMR elements. Here as well, since the peak (or valley portion) of the projection is formed so as to give 45 degrees with respect to the X-axis (Y-axis), GMR bars constituting these elements are arranged in such a way that the longitudinal direction of each GMR bar is also given at 45 degrees with respect to the X-axis (Y-axis)

Then, as illustrated in Fig. 42, after a permanent bar magnet array (magnet array) 216 similar to that of the seventh embodiment is arranged on a substrate 221, the magnet array is heated in vacuum at 260°C to 290°C, allowed to stand for approximately four hours, thereby conducting the heat treatment for regularization. Then, a magnetic field is formed, which is different in direction at every 90 degrees and moving from the N pole of the permanent bar magnet piece 216a arranged above the center of the substrate 221 toward S poles of the permanent bar magnet pieces 216b, 216c and 216e adjacent to the N pole, thereby fixing the magnetization direction of a bonded layer P (a pinned layer of the bonded layer P). As a result, in the first X-axis GMR element 222a and the second X-axis GMR element 222b, the magnetization direction of the pinned layer is fixed to the direction given by the arrows a1 and b1 in Fig. 42. In the third X-axis GMR element 222c and the fourth X-axis GMR element 222d, the magnetization direction of the pinned layer is fixed in the direction given by the arrows c1 and d 1 in Fig. 42.

Further, in the first Y1-axis GMR element 222e and the second Y1-axis GMR element 222f, the magnetization direction of the pinned layer is fixed in a positive direction of the Y-axis along a first tilted surface of the groove (valley portion) tilted at 45 degrees with respect to the X-axis (Y-axis), namely, the direction given by the arrows e1 and f1 in Fig. 38B. Further, in the third Y1-axis GMR element 222g and the fourth Y1-axis GMR element 222h, the magnetization direction of the pinned layer is fixed in a negative direction of the Y-axis along the first tilted surface 215a of the groove (valley portion) 215 and a negative direction of the Z-axis, namely, the direction given by the arrows g1 and h1 in Fig. 42.

Then, in the first Y2-axis GMR element 222i and the second Y2-axis GMR element 222j, the magnetization direction of the pinned layer is fixed in a negative direction of the Y-axis along a second tilted surface of the projection (ledge portion) tilted at 45 degrees with respect to the X-axis (Y-axis), and a positive direction of the Z-axis, namely, the direction given by the arrows i1 and j1 in Fig. 42. Further, in the third Y2-axis GMR element 222k and the fourth Y2-axis GMR element 2221, the magnetization direction of the pinned layer is fixed in a positive direction of the Y-axis along the second tilted surface of the projection (ledge portion) tilted at 45 degrees with respect to the X-axis (Y-axis) and a positive direction of the Z-axis, namely, the direction given by the arrows k1 and l1 in Fig. 42.

When these GMR bars are arranged in such a way that the longitudinal direction of each of the GMR bars is tilted at 45 degrees with respect to the X-axis (Y-axis), they are found to be more stable in a strong magnetic field, although the reason remains unknown.

(Second exemplified variation)

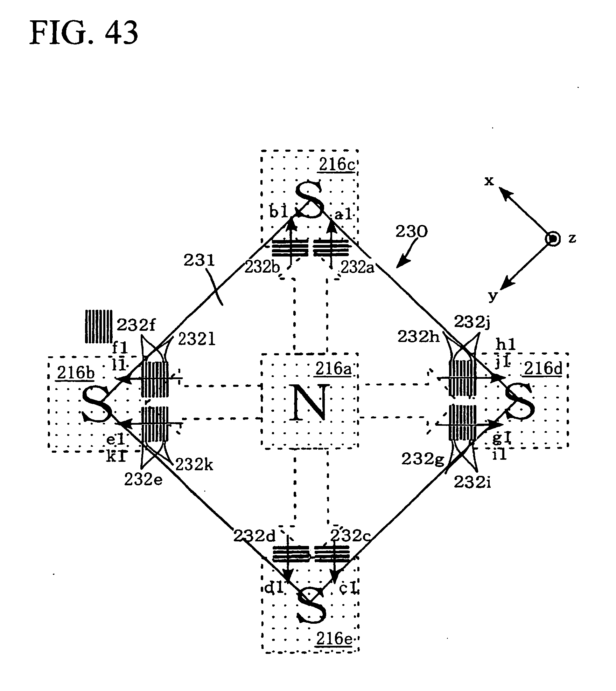

As illustrated in Fig. 43, a three-axis magnetic sensor 230 of a second exemplified variation is constituted with X-axis GMR elements arranged on a pair of corners of a substrate 231 which is in a square shape, when viewed from above, Y1-axis GMR elements formed on a first tilted surface of each of the projections (not illustrated) formed on another pair of corners and Y2-axis GMR elements formed on a second tilted surface. Here, the X-axis GMR elements are made up of a first X-axis GMR element 232a, a second X-axis GMR element 232b, a third X-axis GMR element 232c and a fourth X-axis GMR element 232d. Here, GMR bars constituting these elements are arranged in such a way that the longitudinal direction of each GMR bar is given at 45 degrees with respect to the sides of the substrate 231 (the X-axis or Y-axis).

Further, a peak (or a valley portion) of the projection is formed so as to give 45 degrees to each of the sides of the substrate 231 (the X-axis or Y-axis). A first Y1-axis GMR element 232e, a second Y1-axis GMR element 232f, a third Y1-axis GMR element 232g and a fourth Y1-axis GMR element 232h are formed on a first tilted surface of each of these projections to constitute Y1-axis GMR elements. Here, since the peak (or valley portion) of the projection is formed so as to give 45 degrees with respect to the sides of the substrate 231 (the X-axis or Y-axis), GMR bars constituting these elements are arranged in such a way that the longitudinal direction of each GMR bar is also given at 45 degrees with respect to the sides of the substrate 231 (the X-axis or Y-axis).

Still further, a first Y2-axis GMR element 232i, a second Y2-axis GMR element 232j, a third Y2-axis GMR element 232k and a fourth Y2-axis GMR element 2321 are formed on a second tilted surface of the projection to constitute Y2-axis GMR elements. Here as well, since the peak (or valley portion) of the projection is formed so as to give 45 degrees to the sides of the substrate 231 (the X-axis or Y-axis), GMR bars constituting these elements are arranged in such a way that the longitudinal direction of each GMR bar is also given at 45 degrees with respect to the substrate 231 (the X-axis or Y-axis).

Then, as illustrated in Fig. 43, after a permanent bar magnet array (magnet array) 216 similar to that of the seventh embodiment is arranged on a substrate 231, the magnet array is heated in vacuum at 260°C to 290°C, allowed to stand, as it is, for approximately four hours, thereby conducting the heat treatment for regularization. Then, a magnetic field is formed, which is different in direction at every 90 degrees and moving from the N pole of the permanent bar magnet piece 216a arranged above the center of the substrate 231 toward S poles of the permanent bar magnet pieces 216b, 216c and 216e adjacent to the N pole, thereby fixing the magnetization direction of a bonded layer P (a pinned layer of the bonded layer P). As a result, in the first X-axis GMR element 232a and the second X-axis GMR element 232b, the magnetization direction of the pinned layer is fixed to a positive direction tilted at 45 degrees with respect to the X-axis of the substrate, namely, the direction given by the arrows a1 and b1 in Fig. 43. In the third X-axis GMR element 232c and the fourth X-axis GMR element 232d, the magnetization direction of the pinned layer is fixed to a negative direction tilted at 135 degrees with respect to the X-axis of the substrate, namely, the direction given by the arrows c1 and d1 in Fig. 43.

Further, in the first Y1-axis GMR element 232e and the second Y1-axis GMR element 232f, the magnetization direction of a pinned layer is fixed in a direction along a tilted direction of a first tilted surface of the projection (ledge portion) formed so as to give 45 degrees with respect to the sides of a substrate 231 (the X-axis or Y-axis) and moving toward the corner in a negative direction tilted at 45 degrees with respect to the X-axis of the substrate 231 from the center of the substrate and a negative direction of the Z-axis, namely, the direction given by the arrows e1 and f1 in Fig. 43. In the third Y1-axis GMR element 232g and the fourth Y1-axis GMR element 232h, the magnetization direction of the pinned layer is fixed in a direction along a tilted direction of the first tilted surface of the projection (ledge portion) formed so as to give 45 degrees with respect to the sides of the substrate 231 (the X-axis or Y-axis)(negative direction of the Z-axis) and moving toward the corner in a positive direction tilted at 135 degrees with respect to the X-axis of the substrate 231 from the center of the substrate and a negative direction of the Z-axis, namely, the direction given by the arrows g1 and h1 in Fig. 43.

Still further, in the first Y2-axis GMR element 232i and the second Y2-axis GMR element 232j, the magnetization direction of a pinned layer is fixed in a direction along a tilted direction of a second tilted surface of the projection (ledge portion) formed so as to give 45 degrees with respect to the sides of the substrate 231 (the X-axis or Y-axis)(the direction opposite the tilted direction of the first tilted surface) and moving toward the corner in a positive direction tilted at 135 degrees with respect to the X-axis of the substrate 231 from the center of the substrate and a positive direction of the Z-axis, namely, the direction given by the arrows i1 and j1 in Fig. 43. In the third Y2-axis GMR element 232k and the fourth Y2-axis GMR element 2321, the magnetization direction of the pinned layer is fixed in a direction along a tilted direction of the second tilted surface of the projection (ledge portion) formed so as to give 45 degrees with respect to the sides of the substrate 231 (the X-axis or Y-axis) (the direction opposite the tilted direction of the first tilted surface) and moving toward the corner in a negative direction tilted at 45 degrees with respect to the X-axis of the substrate 231 from the center of the substrate and a positive direction of the Z-axis, namely, the direction given by the arrows k1 and l1 in Fig. 43.

(Third exemplified variation)

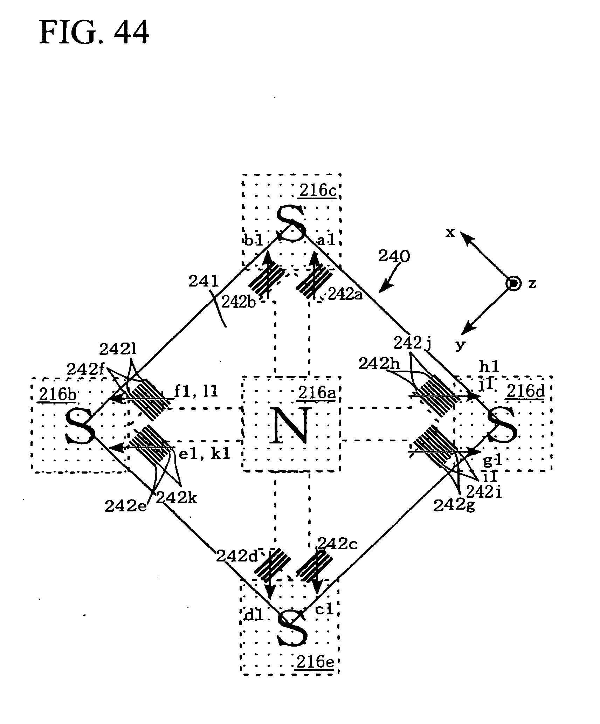

As illustrated in Fig. 44, a three-axis magnetic sensor 240 of a third exemplified variation is constituted with X-axis GMR elements arranged on a pair of corners of a substrate 241 which is in a square shape, when viewed from above, Y1-axis GMR elements formed on the first tilted surface of the projection (not illustrated) formed on another pair of corners and Y2-axis GMR elements formed on the second tilted surface. Here, the X-axis GMR elements are made up of a first X-axis GMR element 242a, a second X-axis GMR element 242b, a third X-axis GMR element 242c and a fourth X-axis GMR element 242d. Here, GMR bars constituting these elements are arranged in such a way that the longitudinal direction of each of the GMR bars is vertical to the X-axis of the substrate 241 (parallel to the Y-axis).

Further, the peak (or valley portion) of the projection is formed so as to be parallel to the X-axis of the substrate 241 (vertical to the Y-axis). A first Y1-axis GMR element 242e, a second Y1-axis GMR element 242f, a third Y1-axis GMR element 242g and a fourth Y1-axis GMR element 242h are formed on the first tilted surface of each of the projections, thereby constituting Y1-axis GMR elements. Here, since the peak (or valley portion) of the projection is formed so as to be parallel to the X-axis of the substrate 241 (vertical to the Y-axis), GMR bars constituting these elements are arranged in such a way that the longitudinal direction of each GMR bar is also parallel to the X-axis of the substrate 241 (vertical to the Y-axis).

Still further, a first Y2-axis GMR element 242i, a second Y2-axis GMR element 242j, a third Y2-axis GMR element 242k and a fourth Y2-axis GMR element 2421 are formed on a second tilted surface of the projection, thereby constituting Y2-axis GMR elements. Here as well, since the peak (or valley portion) of the projection is formed so as to be parallel to the X-axis of the substrate 241 (vertical to the Y-axis), GMR bars constituting these elements are arranged in such a way that the longitudinal direction of each GMR bar is also parallel to the X-axis of the substrate 241 (vertical to the Y-axis).

Then, as illustrated in Fig. 44, after a permanent bar magnet array (magnet array) 216 similar to that of the seventh embodiment is arranged on the substrate 241, the magnet array is heated in a vacuum at 260°C to 290°C, allowed to stand for approximately four hours, thereby conducting the heat treatment for regularization. Then, a magnetic field is formed, which is different in direction at every 90 degrees and moving from the N pole of the permanent bar magnet piece 216a arranged at the center of the substrate 241 toward S poles of the permanent bar magnet pieces 216b, 216c and 216e adjacent to the N pole, thereby fixing the magnetization direction of a bonded layer P (a pinned layer of the bonded layer P). As a result, in the first X-axis GMR element 242a and the second X-axis GMR element 242b, the magnetization direction of the pinned layer is fixed to a positive direction tilted at 45 degrees with respect to the X-axis of the substrate 241, namely, the direction given by the arrows a1 and b1 in Fig. 44. In the third X-axis GMR element 242c and the fourth X-axis GMR element 242d, the magnetization direction of the pinned layer is fixed in a negative direction tilted at 135 degrees with respect to the X-axis of the substrate 241, namely, the direction given by the arrows c1 and d1 in Fig. 44.

Further, in the first Y1-axis GMR element 242e and the second Y1-axis GMR element 242f, the magnetization direction of a pinned layer is fixed in a direction along the first tilted surface of the projection (ledge portion) formed so as to be parallel to the X-axis of a substrate 231 (vertical to the Y-axis) and moving toward the corner in a negative direction tilted at 45 degrees with respect to the X-axis of the substrate 231 from the center of the substrate and a negative direction of the Z-axis, namely, the direction given by the arrows e1 and f1 in Fig. 44. In the third Y1-axis GMR element 242g and the fourth Y1-axis GMR element 242h, the magnetization direction of the pinned layer is fixed in a direction along the first tilted surface of the projection (ledge portion) formed so as to be parallel to the X-axis of the substrate 241 (vertical to the Y-axis) and moving toward the corner in a positive direction tilted at 135 degrees with respect to the X-axis of the substrate 231 from the center of the substrate and a negative direction of the Z-axis, namely, the direction given by the arrows g1 and h1 in Fig. 44.

Still further, in the first Y2-axis GMR element 242i and the second Y2-axis GMR element 242j, the magnetization direction of a pinned layer is fixed in a direction along the second tilted surface of the projection (ledge portion) formed so as to be parallel to the X-axis of the substrate 241 (vertical to the Y-axis) and moving toward the corner in a negative direction tilted at 45 degrees with respect to the X-axis of the substrate 231 from the center of the substrate and a positive direction of the Z-axis, namely, the direction given by the arrows i1 and j1 in Fig. 44. Also, in the third Y2-axis GMR element 242k and the fourth Y2-axis GMR element 2421, the magnetization direction of the pinned layer is fixed in a direction along the second tilted surface of the projection (ledge portion) formed so as to be parallel to the X-axis of the substrate 241 (vertical to the Y-axis) and moving toward the corner in a positive direction tilted at 135 degrees with respect to the X-axis of the substrate 231 from the center of the substrate and a positive direction of the Z-axis, namely, the direction given by the arrows k1 and l1 in Fig. 44.

(Fourth exemplified variation)

In the above-described seventh embodiment, the GMR bars constituting the Y1-axis GMR element and the Y2-axis GMR element formed on a tilted surface of the projection 215 are connected by means of bias magnet films (for example, 212e-5, 212e-6, 212e-7, 212e-8 and 212e-9, and 212k-5, 212k-6, 212k-7 and 212k-8, 212k-9 etc., as shown in Fig. 37A and Fig. 37B). A bias magnet film is also formed at the peak of the projection 215.

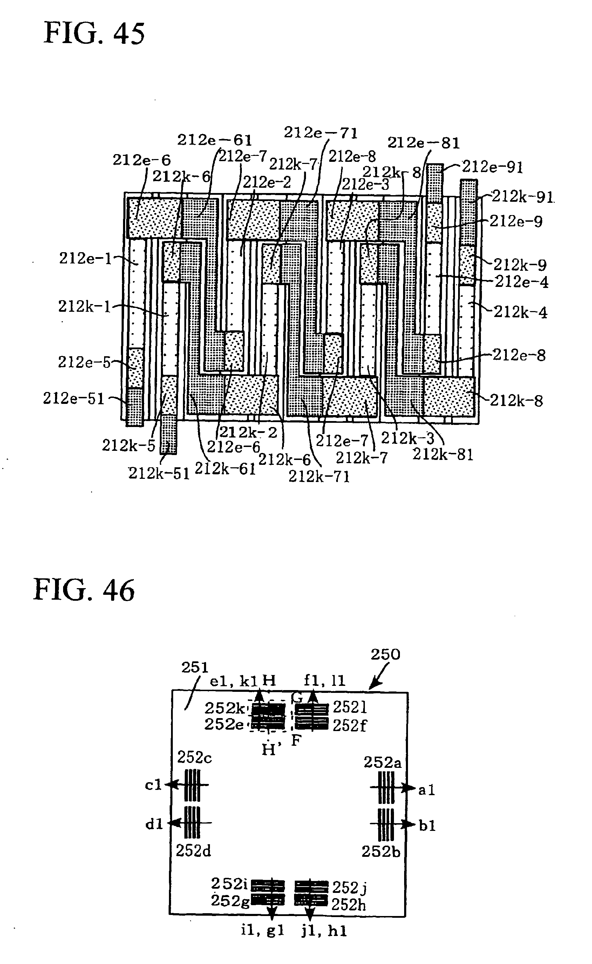

Then, in the fourth exemplified variation, as illustrated in Fig. 45 (in Fig. 45, symbols same as those in Fig. 37A and Fig. 37B represent the same names), a portion (connected portion) located at the peak of the projection 215 of a bias magnet film formed at the peak of the projection 215 (for example, 212e-5, 212e-6, 212e-7, 212e-8 and 212e-9, and 212k-5, 212k-6, 212k-7, 212k-8, or 212k-9, etc.) among bias magnet films is formed with a non-magnetic film (for example, that made of a non-magnetic body such as polysilicon). For example, as illustrated in Fig. 45, the non-magnetic film 212e-61 (212k-61) is formed at a portion (connected portion) located at the peak of the projection 215 of the bias magnet film 212e-6 (212k-6). The non-magnetic film 212e-71 (212k-71) is formed at a portion (connected portion) located at the peak of the projection 215 of the bias magnet film 212e-7 (212k-7). The non-magnetic film 212e-81 (212k-81) is formed at a portion (connected portion) located at the peak of the projection 215 of the bias magnet film 212e-8 (212k-8).

Here, in forming a non-magnetic film (for example, 212e-61 (212k-61), 212e-71 (212k-71), 212e-81(212k-81), etc. as shown in Fig. 45) at the peak of the projection 215, it is necessary to provide a process for forming non-magnetic films (for example, 212e-61 (212k-61), 212e-71 (212k-71), 212e-81 (212k-81), etc.) after the processes given in Fig. 12A to Fig. 12C. Then, a bias magnet film may be formed, as illustrated in Fig. 13A to Fig. 13C, after formation of the non-magnetic film.

(Eighth embodiment)

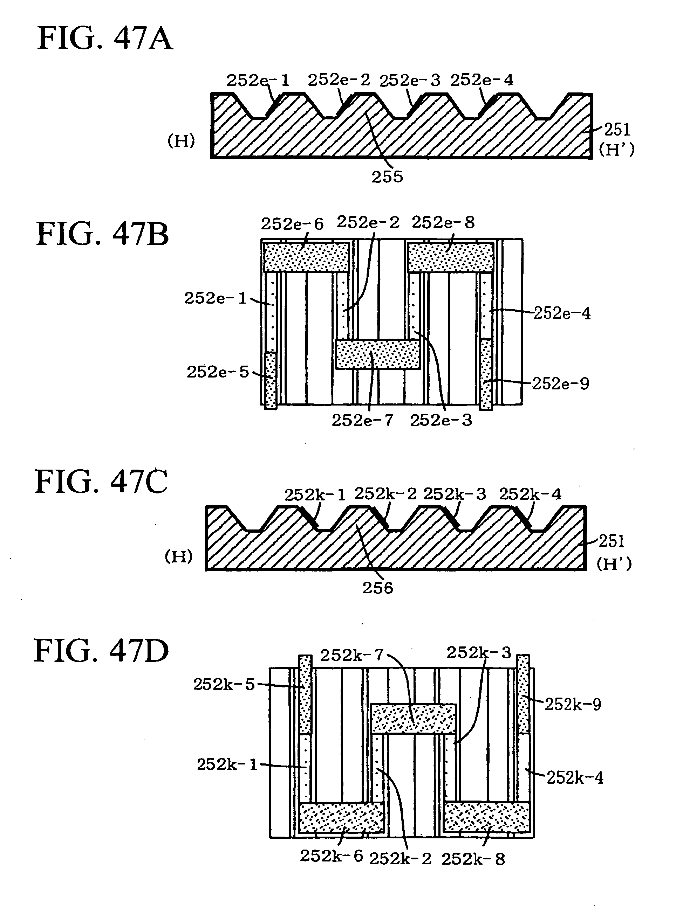

Next, an explanation will be made of a three-axis magnetic sensor of an eighth embodiment by referring to Fig. 46 and Fig. 47A to Fig. 47D.

In the above-described seventh embodiment and its exemplified variations, the Y1-axis GMR elements are arranged on the first tilted surface of the projection 215, and the Y2-axis GMR elements are arranged on the second tilted surface of the projection 215. In the eighth embodiment, however, the Y1-axis GMR elements are arranged only on the first tilted surface of the projection 255 and the Y2-axis GMR elements are arranged only on the second tilted surface of a projection 256, which is different from the projection 255 but of the same shape as the projection 255. Here, as illustrated in Fig. 46, the three-axis magnetic sensor 250 of the eighth embodiment has X-axis GMR elements 252a to 252d, Y1-axis GMR elements 252e to 252h and Y2-axis GMR elements 252i to 2521 formed at a peripheral part of a square-shaped substrate 251 and at a central portion of each of the sides. Here, the X-axis GMR elements 252a to 252d are similar to the X-axis GMR elements 212a to 212d of the above-described seventh embodiment and explanation thereof will be omitted here.

As illustrated in Fig. 47A, in the Y1-axis GMR elements 252e to 252h, GMR bars 252a-1, 252e-2, 252e-3 and 252e-4 (the same shall apply to 252f, 252g and 252h) are formed only on a first tilted surface of the projection 255 formed on the substrate 251. As illustrated in Fig. 47B, these GMR bars are connected in series by means of bias magnet films 252e-5, 252e-6, 252e-7, 252e-8 and 252e-9 (the same shall apply to 252f, 252g, and 252h). In contrast, as illustrated in Fig. 47C, in the Y2-axis GMR elements 252i to 2521, GMR- bars 252k-1, 252k-2, 252k-3 and 252k-4 (the same shall apply to 252i, 252j and 2521) are formed only on a second tilted surface of the projection 256, which is different from the projection 255 of the substrate 251. Then, as illustrated in Fig. 47D, these GMR bars are connected in series by means of bias magnet films 252k-5, 252k-6, 252k-7, 252k-8 and 252k-9 (the same shall apply to 252i, 252j and 2521).

Then, the permanent bar magnet array 216 similar to that of the seventh embodiment is used to conduct heat treatment for regularization. Thereby, in the first X-axis GMR element 252a and the second X-axis GMR element 252b, the magnetization direction of a pinned layer is fixed in the direction given by the arrows a1 and b1 in Fig. 46, while in the third X-axis GMR element 252c and the fourth X-axis GMR element 252d, the magnetization direction of the pinned layer is fixed in the direction given by the arrows c1 and d1 in Fig. 46.

Further, in the first Y1-axis GMR element 252e and the second Y1-axis GMR element 252f, the magnetization direction of a pinned layer is fixed in a positive direction of the Y-axis along the first tilted surface of the projection (ledge portion) 255 and a negative direction of the Z-axis, namely, the direction given by the arrows e1 and f1 in Fig. 46. In the third Y1-axis GMR element 252g and the fourth Y1-axis GMR element 252h, the magnetization direction of the pinned layer is fixed in a negative direction of the Y-axis along the first tilted surface of the projection (ledge portion) 255 and a negative direction of Z-axis and the direction given by the arrows g1 and h1 in Fig. 46.

Still further, in the first Y2-axis GMR element 252i and the second Y2-axis GMR element 252j, the magnetization direction of a pinned layer is fixed in a negative direction of the Y-axis along the second tilted surface of the projection (ledge portion) 256 and a positive direction of the Z-axis, namely, the direction given by the arrows i1 and j1 in Fig. 46. In the third Y2-axis GMR element 252k and the fourth Y2-axis GMR element 252l, the magnetization direction of the pinned layer is fixed in a positive direction of the Y-axis along a tilted surface of the projection (ledge portion) 256 and a positive direction of the Z-axis, namely, the direction given by the arrows k1 and l1 in Fig. 46.

In the eighth embodiment, elements may be arranged so that the magnetic field is optimized only on the tilted surface side where the elements are formed.


(Ninth embodiment)

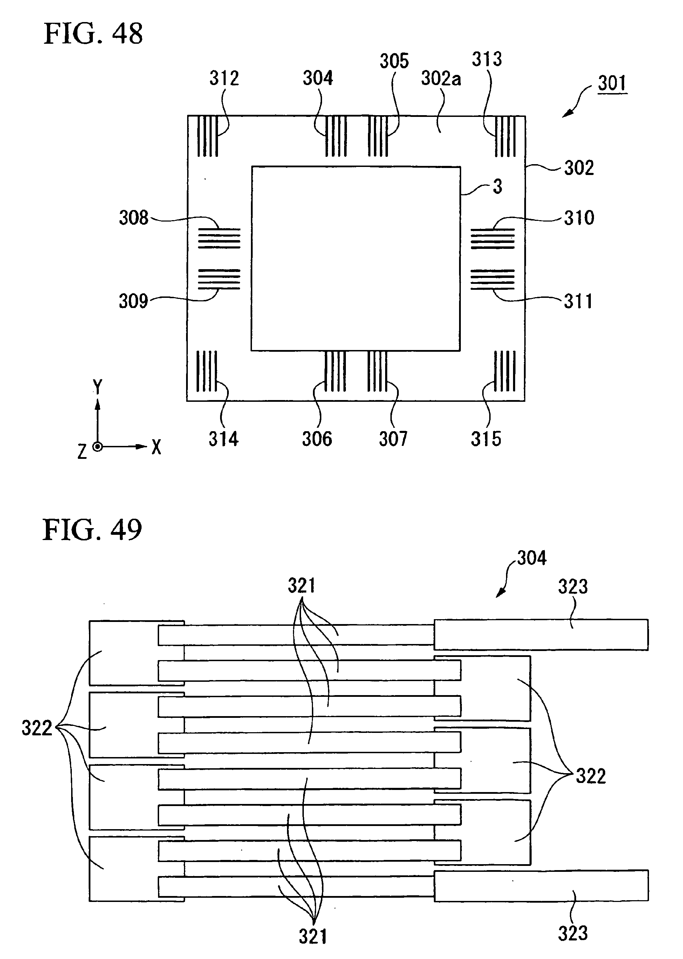

Next, an explanation will be made of a ninth embodiment of the present invention. In Fig. 48, illustrating the three-axis magnetic sensor of the ninth embodiment in the present invention, a three-axis magnetic sensor 301 is provided with a substrate 302 made with quartz, $SiO_2$/Si, etc., having a predetermined thickness, which is in a square shape, when viewed from above, X-axis GMR elements 304 to 307 constituting an X-axis magnetic sensor for detecting the magnetic field in the X-axis direction, which is formed around a cell 303 of a surface 302a of the substrate 302, Y-axis GMR elements 308 to 311 constituting a Y-axis magnetic sensor for detecting the magnetic field in the Y-axis direction, which is formed around the cell 303, and Z-axis GMR elements 312 to 315 constituting a Z-axis magnetic sensor for detecting the magnetic field in the Z-axis direction, which is formed at the corner of the cell 303.

The X-axis GMR elements 304 to 307 are arranged one pair each in the vicinity of the respective intermediate points of two sides parallel to the X-axis among four sides of the cell 303 on the quartz substrate 302, and these elements composed of one pair each are arranged in such a way that the longitudinal direction is vertical to each of the sides and adjacent elements are mutually parallel.

As with the X-axis GMR elements 304 to 307, the Y-axis GMR elements 308 to 311 are also arranged one pair each in the vicinity of the respective intermediate points of two sides parallel to the Y-axis among four sides of the cell 303 on the quartz substrate 302, and these elements composed of one pair each are arranged in such a way that the longitudinal direction is vertical to each of the sides and adjacent elements are mutually parallel.

The Z-axis GMR elements 312 to 315 are arranged one each at the four corners of the cell 303 on the quartz substrate 302, and these elements are arranged in such a way that the longitudinal direction is parallel to the Y-axis direction.

Fig. 49 is a plan view illustrating the X-axis GMR element 304. In this X-axis GMR element 304, a plurality of band-form magnetoresistive effect elements 321 are arranged mutually parallel, and a permanent magnet film 322 made with a hard ferromagnetic body thin-film such as CoCrPt having a high coercive force, which is connected to both longitudinal ends of the magnetoresistive effect element 321 and a long permanent magnet film 323 made with a hard ferromagnetic body thin-film such as CoCrPt having a high coercive force, which is connected to one longitudinal end of the magnetoresistive effect element 321 located at the outermost side are connected in series to give a zigzag form. The permanent magnet films 323 and 323 are connected to a wiring (not illustrated).

The magnetoresistive effect element 321 is constituted with laminated magnet films (not illustrated) including a pinning layer and a pinned layer.

The X-axis GMR elements 305 to 307 are also identical in constitution to the X-axis GMR element 304. Further, in the Y-axis GMR elements 308 to 311, the magnetoresistive effect element 321 of the X-axis GMR element 304 is replaced by a magnetoresistive effect element having the identical constitution to the X-axis GMR element 304. Therefore, an explanation of the constitution of these GMR elements will be omitted here.

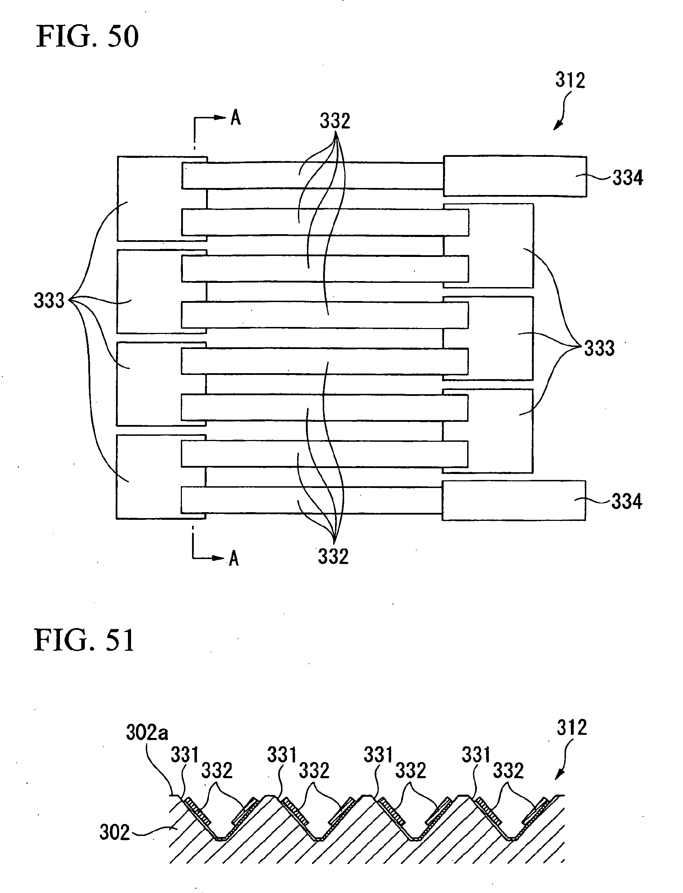

Fig. 50 is a plan view illustrating a Z-axis GMR element 312, and Fig. 51 is a sectional view taken along line A-A in Fig. 50. In the Z-axis GMR element 312, a band-form magnetoresistive effect element 332 arranged on each inner surface of a plurality of grooves 331 having a wedge-shaped cross section parallel to the Y-axis direction of one corner (that left above in the drawing) of a surface 302a of the substrate 302, a permanent magnet film 333 made with a hard ferromagnetic body thin film such as CoCrPt having a high coercive force which is connected to both longitudinal ends of the magnetoresistive effect element 332 and a long permanent magnet film 334 made with a hard ferromagnetic body thin-film such as CoCrPt having a high coercive force, which is connected to one longitudinal end of the magnetoresistive effect element 332 located at the outermost side are connected in series to provide a zigzag form. The permanent magnet films 333 and 334 are connected to a wiring (not illustrated).

As with the above-described magnetoresistive effect element 321, the magnetoresistive effect element 332 is constituted with laminated magnet films (not illustrated) including a pinning layer and a pinned layer.

Further, the inner surface of the groove 331 is preferably tilted at 30 degrees or more with respect to the surface 302a of the substrate 302 and more preferably at 45 degrees or more.

Since the Z-axis GMR elements 313 to 315 are identical in shape with the Z-axis GMR element 312, an explanation of the shape of these GMR elements will be omitted here.

In these X-axis GMR elements 304 to 307, the magnetization direction of a pinned layer is in one direction parallel to the surface 302a of the substrate 302. Further, in the Y-axis GMR elements 308 to 311, the magnetization direction of the pinned layer is also in one direction parallel to the surface 302a of the substrate 302. In the Z-axis GMR elements 312 to 315, the magnetization direction of the pinned layer is in one direction parallel to the tilted surface of the substrate 302. The magnetization directions of pinned layers in the X-axis GMR elements 304 to 307 are mutually orthogonal to those in the Y-axis GMR elements 308 to 311. The magnetization direction of the pinned layer in each of the GMR elements 304 to 315 is vertical to the longitudinal direction of the magnetoresistive effect element.

Then, an angle formed by the magnetization direction of the pinned layer in the X-axis GMR elements 304 to 307 and the longitudinal direction of the magnetoresistive effect element, an angle formed by the magnetization direction of the pinned layer in the Y-axis GMR elements 308 to 311 and the longitudinal direction of the magnetoresistive effect element and an angle formed by the magnetization direction of the pinned layer in the Z-axis GMR elements 312 to 315 and the longitudinal direction of the magnetoresistive effect element are equal to each other. Therefore, the respective sensitivities of these GMR elements are also equal.

In the three-axis magnetic sensor 301, the X-axis GMR elements 304 to 307, the Y-axis GMR elements 308 to 311 and the Z-axis GMR elements 312 to 315 respectively constitute block circuits.

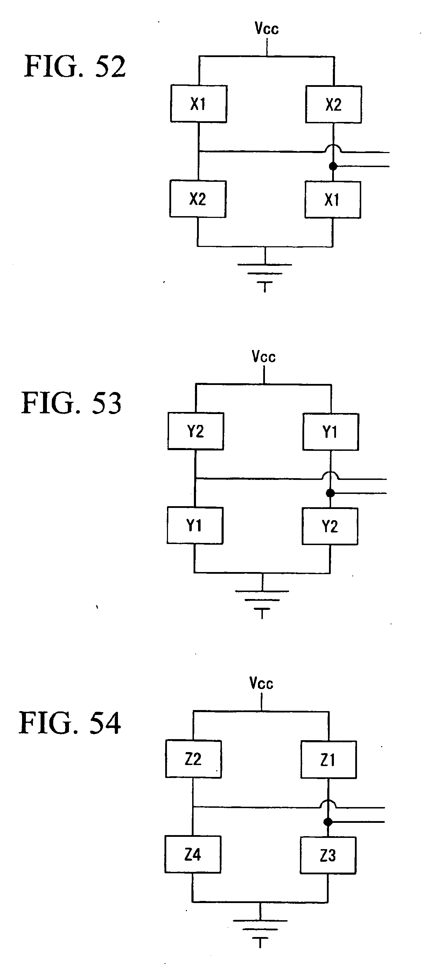

Fig. 52 shows an equivalent circuit which illustrates a block connection of the X-axis magnetic sensor in the three-axis magnetic sensor 301. In the drawing, X1 denotes an element group composed of X-axis GMR elements 304 and 305, X2 denotes an element group composed of X-axis GMR elements 306 and 307 and Vcc denotes bias voltage.

Fig. 53 is a block diagram illustrating a bridge-connection of the Y-axis magnetic sensor in this three-axis magnetic sensor. In the drawing, Y1 denotes an element group composed of Y-axis GMR elements 308 and 309, Y2 denotes an element group composed of Y-axis GMR elements 310 and 311, and Vcc denotes a bias voltage.

Fig. 54 is a block diagram illustrating a block connection of the Z-axis magnetic sensor in this three-axis magnetic sensor. In the drawing, Z1 denotes the Z-axis GMR element 312, Z2 denotes the Z-axis GMR element 313, Z3 denotes the Z-axis GMR element 314; Z4, the Z-axis GMR elements 315, and Vcc denotes bias voltage.

This three-axis magnetic sensor 301 is constituted as described above, thereby making it possible to determine the magnetic field in three-dimensional X-axis, Y-axis and Z-axis directions at high accuracy.

Next, an explanation will be made of a method for magnetizing the three-axis magnetic sensor 301.
First, a film-forming method such as sputtering, vacuum evaporation or ion plating is used to form X-axis GMR elements 304 to 307, Y-axis GMR elements 308 to 311 and Z-axis GMR elements 312 to 315 respectively on the surface 302a of the substrate 302, and heat treatment for regularization is conducted on the pinning layer of the magnetoresistive effect element 321 of the X-axis GMR elements 304 to 307 and the Y-axis GMR elements 308 to 311 to pin the pinned layer.

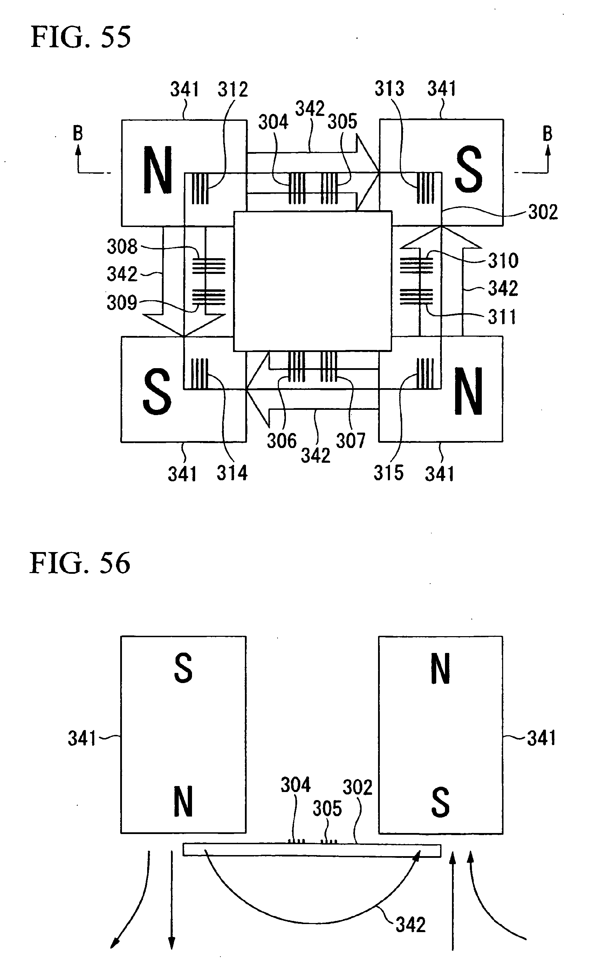

Fig. 55 is a plan view illustrating an array arrangement when the heat treatment for regularization is given to the three-axis magnetic sensor 301. Fig. 56 is a sectional view taken along line B-B in Fig. 55. A permanent magnet piece 341 is arranged above each of the four corners of the substrate 302 which is to be divided into pieces in a subsequent cutting process in such a way that adjacent permanent magnet pieces 341 and 341 are different from each other in polarity. Therefore, a magnetic field 342 is formed, which moves from one permanent magnet piece 341 (N pole) toward two adjacent permanent magnet pieces 341 (S pole).

The direction of the magnetic field 342 is parallel to each side of the substrate 302, approximately parallel to the substrate 302, when positioned at the X-axis GMR elements 304 to 307 and Y-axis GMR elements 308 to 311, and vertical to the substrate 302, when positioned at the Z-axis GMR elements 312 to 315. Further, the magnetic field is applied in a direction orthogonal with respect to the longitudinal direction of the magnetoresistive effect element 321.
Next, the substrate 302 is given a 4-hour heat treatment in a vacuum at 250°C to 280°C.
Thereby, among magnet films of the respective magnetoresistive effect elements 321 of X-axis GMR elements 304 to 307, Y-axis GMR elements 308 to 311 and Z-axis GMR elements 312 to 315, a pinning layer can be subjected to heat treatment for regularization. At the same time, the pinned layer is pinned by a switched connection.

Next, the X-axis GMR elements 304 to 307, the Y-axis GMR elements 308 to 311 and the Z-axis GMR elements 312 to 315 are subjected to patterning so as to provide a predetermined form. The respective magnetoresistive effect elements 321 of the X-axis GMR elements 304 to 307 and the Y-axis GMR elements 308 to 311 are connected to the permanent magnet films 322, 323, thereby providing a zigzag form. Also, the respective magnetoresistive effect elements 332 of the Z-axis GMR elements 312 to 315 are connected to the permanent magnet films 333 and 334, thereby providing a zigzag form.
In the three-axis magnetic sensor 301, the X-axis sensitivity direction of the X-axis GMR elements 304 to 307, the Y-axis sensitivity direction of the Y-axis GMR elements 308 to 311 and the Z-axis sensitivity direction of the Z-axis GMR elements 312 to 315 are in a mutually orthogonal direction.

Next, magnetization is given to permanent magnet films of the Z-axis GMR elements 312 to 315.

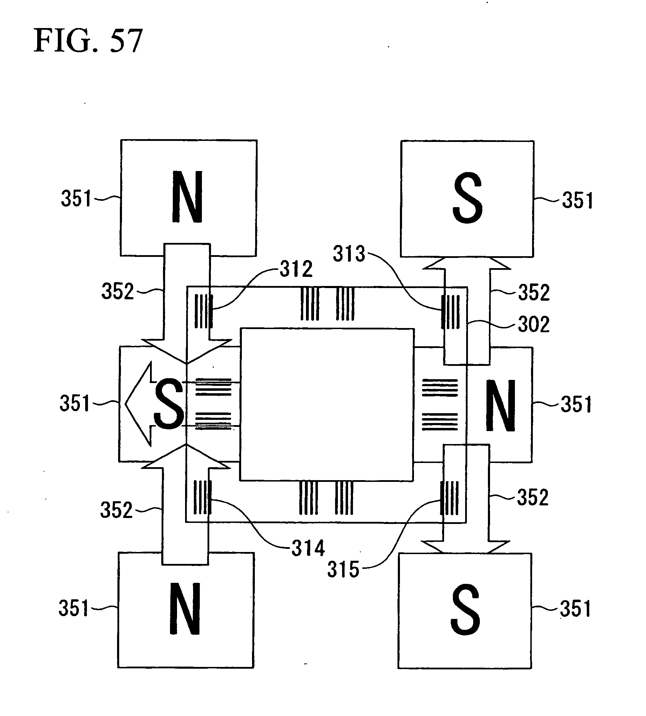

Fig. 57 is a plan view illustrating an array arrangement when the Z-axis GMR elements 312 to 315 are magnetized. In this array, a plurality of permanent magnet pieces 351 are arranged in a matrix form in such a way that adjacent permanent magnet pieces 351 are different from each other in polarity. Below this array, a substrate 302 is arranged in such a way that its four corners are positioned at the midpoint of adjacent permanent magnet pieces 351 and 351.
Therefore, a magnetic field 352 which moves from one permanent magnet piece 351 (N pole) toward one adjacent permanent magnet piece 351 (S pole) is formed at each of the four corners of the substrate 302.

Since the magnetic field 352 is directed parallel to each one side of the substrate 302, a magnetic field is applied in a direction parallel to the longitudinal direction of the magnetoresistive effect element 332 in the Z-axis GMR elements 312 to 315, thereby resulting in magnetization of the Z-axis GMR elements 312 to 315.

Next, magnetization is given to permanent magnet films of the X-axis GMR elements 304 to 307 and the Y-axis GMR elements 308 to 311.

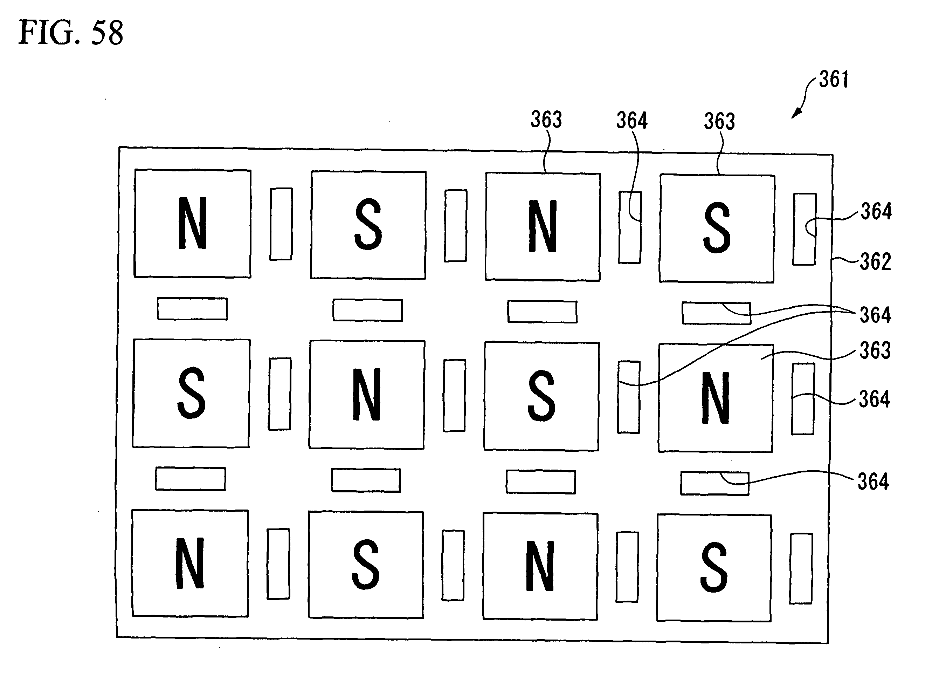

Fig. 58 is a plan view illustrating a state in which a yoke is mounted on a magnet array used in the magnetization process. This yoke 361 is a soft magnetic plate 362 having the thickness of 0.02mm which is made with a soft magnetic body such as 42 alloy (Fe-42 weight% Ni) and provided with through- holes at places corresponding to permanent magnet pieces363 and 363 of the magnet array. Then, a strip-of-paper-shaped slit 364 is formed parallel to the sides of permanent magnet pieces 363 and 363 at a place corresponding to the central portion between the permanent magnet pieces 363 and 363. The width of the slit 364 is approximately twice the longitudinal length of the GMR elements so that the X-axis GMR elements 304 to 307 and the Y-axis GMR elements 308 to 311, which are on mutually adjacent substrates 302 and 302, can be magnetized at the same time.
Further, one surface of the soft magnetic plate 362 is provided flush with one surface of each of the permanent magnet pieces 363.

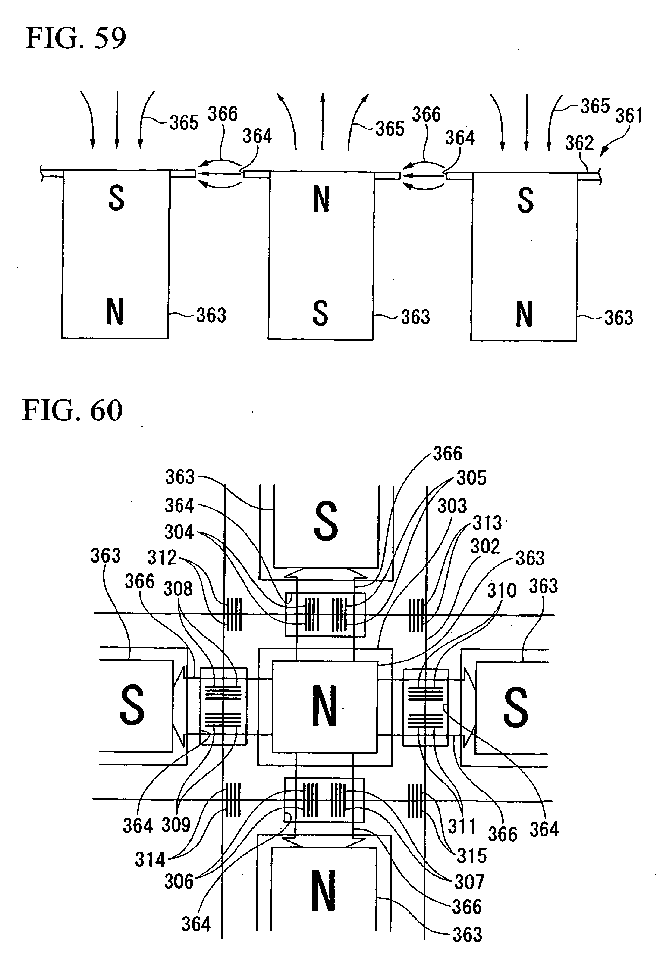

As illustrated in Fig. 59, the yoke 361 is used to provide two magnetic fields moving from one permanent magnet piece 363 (N pole) of the magnet array toward an adjacent permanent magnet piece 363 (S pole), namely, a magnetic field 365 passing above the permanent magnet piece 363 and a magnetic field 366 passing through the slit 364. Since the soft magnetic plate 362 absorbs magnetic fields, magnetic fields will become weak in the vicinity of the soft magnetic plate 362. In contrast, since magnetic fields are concentrated on the slit 364, the magnetic field 366 will be reinforced.

Therefore, when a magnet array in which the yoke 361 is used is used to magnetize X-axis GMR elements 304 to 307 and Y-axis GMR elements 308 to 311, as illustrated in Fig. 60, the X-axis GMR elements 304 to 307 and the Y-axis GMR elements 308 to 311 are positioned on the slit 364 and, therefore, magnetized by the reinforced magnetic field 366. In contrast, the Z-axis GMR elements 312 to 315 are positioned on the soft magnetic plate 362 in a state such that magnetic fields are hardly applied. As a result, the Z-axis GMR elements 312 to 315 are able to retain the magnetization under desirable conditions, with the magnetized state not being affected.

According to the method for manufacturing the three-axis magnetic sensor, after magnetization is given to the Z-axis GMR elements 312 to 315, a yoke 361 having a rectangular slit 364 at a place corresponding to an intermediate portion between permanent magnet pieces 363 and 363 of the soft magnetic plate 362 is used to magnetize the X-axis GMR elements 304 to 307 and the Y-axis GMR elements 308 to 311. Also in magnetizing the X-axis GMR elements 304 to 307 and the Y-axis GMR elements 308 to 311, the Z-axis GMR elements 312 to 315 are able to retain the magnetization under desirable conditions, with the magnetized state not being affected.

It is, therefore, possible to manufacture easily the three-axis magnetic sensor 301 capable of accurately determining the magnetic field in three-dimensional X-axis, Y-axis and Z-axis directions.

(Tenth embodiment)

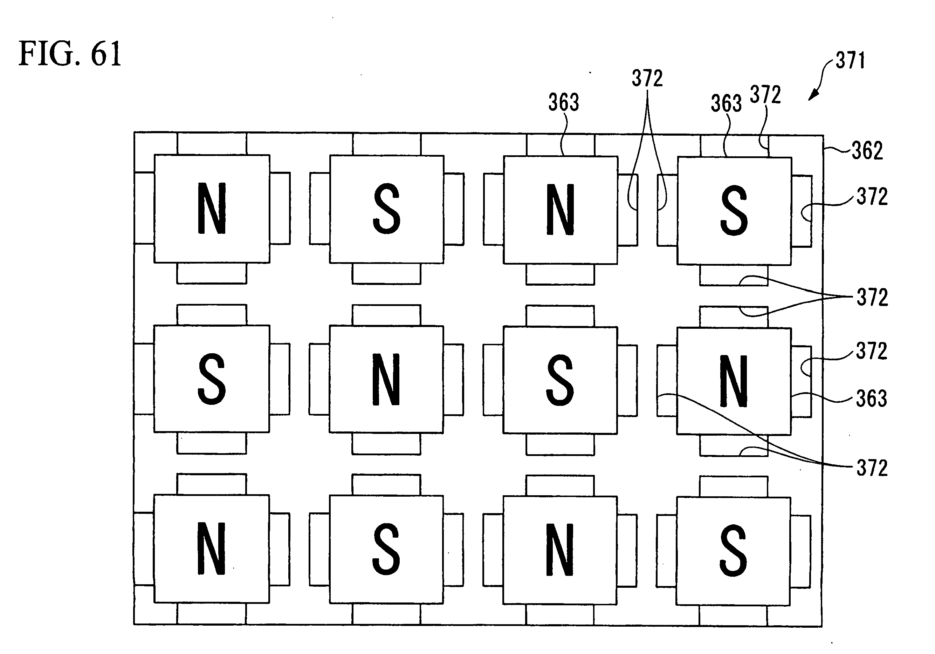

Fig. 61 is a plan view illustrating a yoke used in the magnetization process of a tenth embodiment in the present invention. A yoke 371 of this embodiment is different from a yoke 361 of the ninth embodiment in that the yoke 361 of the ninth embodiment has a slit 364 at a place corresponding to the central portion between permanent magnet pieces 363 and 363 in a soft magnetic plate 362 whereas the yoke 371 of the present embodiment has a slit 372 adjacent to each of the four corners of the permanent magnet piece 363.

The width of the slit 372 is slightly greater than the length of the longitudinal direction of GMR elements so as to magnetize the X-axis GMR elements 304 to 307 and the Y-axis GMR elements 308 to 311 on one substrate 2. Further, the one surface of the soft magnetic plate 362 is provided flush with the one surface of each of the permanent magnet pieces 363.

As illustrated in Fig. 62, in the yoke 371, a magnetic field 373 passing through the slit 373 is concentrated to a greater extent, thereby resulting in a greater reinforcement of the magnetic field 373 than the above-described magnetic field 366.

Further, only X-axis GMR elements 304 to 307 and Y-axis GMR elements 308 to 311 on one substrate 302 are positioned on these slits 372, thereby making it possible to apply a greater magnetic field to the X-axis GMR elements 304 to 307 and the Y-axis GMR elements 308 to 311 and provide a greater magnetization.

Still further, a combination of magnet arrays with a mutually opposite polarity will reverse the direction of heat treatment for regularization or the magnetization direction of a permanent magnet film.

INDUSTRIAL APPLICABILITY

The present invention is applicable to a three-axis magnetic sensor having inside one substrate X-axis, Y-axis and Z-axis sensors in which a plurality of magnetoresistive effect elements are bridge-connected. Further, a magnetic sensor of the present invention is able to determine an accurate magnetic field in three-dimensional X-axis, Y-axis and Z-axis directions.

**Claims**

1.   A three-axis magnetic sensor having inside one substrate (11) an X-axis sensor in which a plurality of giant magnetoresistive effect elements (212a to 212d) are bridge-connected, a Y1-axis sensor in which a plurality of giant magnetoresistive effect elements (212e to 212h) are bridge-connected and a Y2-axis sensor in which a plurality of giant magnetoresistive effect elements (212i to 212l) are bridge-connected, wherein:

the giant magnetoresistive effect element has a plurality of giant magnetoresistive effect element bars connected in series;
the giant magnetoresistive effect elements of the X-axis sensor are formed on a flat surface parallel to a surface of the substrate, and a pinned layer is formed in such a way that the magnetization direction and the sensitivity direction are vertical to the longitudinal direction of each of the giant magnetoresistive effect element bars;
the Y1-axis sensor is formed on a first tilted surface (215a) tilted at a predetermined angle to the surface of the substrate, and the pinned layer is formed in such a way that the magnetization direction and the sensitivity direction are vertical to the longitudinal direction of each of the giant magnetoresistive effect element bars and also in a direction along the first tilted surface;
the Y2-axis sensor is formed on a second tilted surface (215b) which is tilted at the same angle with the first tilted surface but in a direction opposite the first tilted surface, and the pinned layer is formed in such a way that the magnetization direction and the sensitivity direction are vertical to the longitudinal direction of each of the giant magnetoresistive effect element bars and also in a direction along the second tilted surface; and

the first and the second tilted surfaces (215a, 215b) are tilted surfaces formed by a groove formed on a thick film (11i) on the substrate (11);

**characterized in that** the thick film (11i) is coated on a wiring layer (11a) which is fabricated on the substrate (11).

2. The three-axis magnetic sensor as set forth in Claim 1, wherein the giant magnetoresistive effect elements have a plurality of giant magnetoresistive effect element bars arranged in parallel and adjacent giant magnetoresistive effect element bars connected in series by means of bias magnet films (2121-5 to 212a-9).

3. The three-axis magnetic sensor as set forth in Claim 1, wherein the first tilted surface and the second tilted surface are constituted with projections formed on the substrate so as to be back to back, or the first tilted surface and the second tilted surface are constituted with grooves formed on the substrate so as to face each other relatively.

4. The three-axis magnetic sensor as set forth in Claim 1, wherein the first tilted surface is constituted with a first projection or a groove and the second tilted surface is constituted with a second projection or a groove which is different from the first projection or the groove.

5. The three-axis magnetic sensor as set forth in Claim 1, wherein:

each of the longitudinal direction of the giant magnetoresistive effect element bar concerned is made coincident with either the long-side (X-axis) direction of the substrate or that of the short-side (Y-axis); and the giant magnetoresistive effect elements constituted with the giant magnetoresistive effect element bars formed on the first and the second tilted surfaces are arranged to be adjacent and mutually parallel.

6. The three-axis magnetic sensor as set forth in Claim 1, wherein ridges made up of peaks of projections of the first and second tilted surfaces are formed so as to give 45 degrees with respect to an X-axis or Y-axis of the substrate.

7. The three-axis magnetic sensor as set forth in Claim 6, wherein the X-axis sensor, the Y1-axis sensor, and the Y2-axis sensor are formed on four corners of the substrate.

8. The three-axis magnetic sensor as set forth in Claim 1, wherein ridges made up of peaks of projections of the first and second tilted surfaces are formed so as to be parallel to an X-axis or Y-axis of the substrate.

9. The three-axis magnetic sensor as set forth in Claim 8, wherein the X-axis sensor, the Y1-axis sensor, and the Y2-axis sensor are formed on four sides of the substrate.

10. A method for manufacturing a three-axis magnetic sensor having inside one substrate (11) an X-axis sensor in which a plurality of giant magnetoresistive effect elements are bridge-connected, a Y1-axis sensor in which a plurality of giant magnetoresistive effect elements are bridge-connected and a Y2-axis sensor in which a plurality of giant magnetoresistive effect elements are bridge-connected, the method for manufacturing the three-axis magnetic sensor comprising the steps of:

forming on a flat surface parallel to a surface of the substrate a plurality of giant magnetoresistive effect elements which will act as an X-axis sensor, and forming on the substrate a plurality of giant magnetoresistive effect element which will act as a Y1-axis sensor and a plurality of giant magnetoresistive effect elements which will act as a Y2-axis sensor;

heat treating for regularization in which each of the giant magnetoresistive effect elements formed on the substrate is heated by applying magnetic fields thereto to give at the same time the heat treatment for regularization to each of the giant magnetoresistive effect elements;

forming the giant magnetoresistive effect elements which will act as the Y1-axis sensor on a first tilted surface (215a) which is tilted by a predetermined angle with respect to the flat surface of the substrate, the first tilted surface being formed by a groove which is formed on a thick film (11i) on the substrate (11); and

forming the giant magnetoresistive effect elements which will act as the Y2-axis sensor on a second tilted surface (215b) which is tilted at the same angle with respect to the first tilted surface and in a direction opposite the first tilted surface, the second tilted surface being formed by the groove;

**characterized in that** the thick film (11i) is coated on a wiring layer (11a) which is fabricated on the substrate (11).

11. The method for manufacturing the three-axis magnetic sensor as set forth in Claim 10, wherein in the step of heat treating for regularization, the treatment is conducted by heating while a magnetic field is imparted to the direction tilted at 45 degrees from a direction vertical to the first and second tilted surfaces on which magnetoresistive effect element bars constituting the plurality of magnetoresistive effect elements which will act as the Y1-axis and Y2-axis sensors are formed.

12. The method for manufacturing the three-axis magnetic sensor as set forth in Claim 10, wherein:

the X-axis sensor, the Y1-axis sensor, and the Y2-axis sensor are formed on four sides of the substrate; and the heat treating for regulation is conducted by using a magnet array (216) having permanent magnet pieces located at a center of the substrate and centers of the four sides of the substrate, adjacent magnet pieces of the permanent magnet array being mutually different in polarity.

13. The method for manufacturing the three-axis magnetic sensor as set forth in Claim 10, wherein:

the X-axis sensor, the Y1-axis sensor, and the Y2-axis sensor are formed on four corners of the substrate; and the heat treating for regulation is conducted by using a magnet array (216) having permanent magnet pieces located at a center of the substrate and the four corners of the substrate, adjacent magnet pieces of the permanent magnet array being mutually different in polarity.

**Patentansprüche**

1. Dreiachsen-Magnetsensor, der im Inneren eines Substrats (11) einen X-Achsen-Sensor, in dem eine Vielzahl von Riesen-Magnetowiderstandseffektelementen bzw. GMR-Effektelementen (GMR = Giant MagnetoResistive) (212a bis 212d) durch Brücken verbunden sind, einen Y1-Achsen-Sensor, in dem eine Vielzahl von GMR-Effektelementen (212e bis 212h) durch Brücken verbunden sind, und einen Y2-Achsen-Sensor, in dem eine Vielzahl von GMR-Effektelementen (212i bis 2121) durch Brücken verbunden sind, wobei:

das GMR-Effektelement eine Vielzahl von magneto-resistiven Effektelementstegen besitzt, die in Reihe verbunden sind;
die GMR-Effektelemente des X-Achsen-Sensors auf einer flachen Oberfläche parallel zu einer Oberfläche des Substrats gebildet sind, und eine verstiftete Schicht bzw. Pinned Layer in einer solchen Art und Weise gebildet ist, dass die Magnetisierungsrichtung und die Sensitivitätsrichtung vertikal zu der Längsrichtung von jedem der GMR-Effektelementstege ist;
der Y1-Achsen-Sensor auf einer ersten geneigten Oberfläche (215a) gebildet ist, die mit einem vorbestimmten Winkel zu der Oberfläche des Substrats geneigt ist, und die Pinned Layer in einer solchen Art und Weise gebildet ist, dass die Magnetisierungsrichtung und die Sensitivitätsrichtung vertikal zu der Längsrichtung von jedem der GMR-Effektelementstege und ebenfalls in einer Richtung entlang der erste, geneigten Oberfläche sind;
der Y2-Achsen-Sensor auf einer zweiten, geneigten Oberfläche (215b) gebildet ist, die mit dem gleichen Winkel zu der ersten geneigten Oberfläche aber in einer Richtung entgegengesetzt zu der ersten geneigten Oberfläche geneigt ist, und die Pinned Layer in einer solchen Art und Weise gebildet ist, dass die Magnetisierungsrichtung und die Sensitivitätsrichtung vertikal zu der Längsrichtung von jedem der GMR-Effektelementstege und ebenfalls in einer Richtung entlang der zweiten, geneigten Oberfläche sind; und
die ersten und zweiten, geneigten Oberflächen (215a, 215b) sind geneigte Oberflächen, die durch eine Nut gebildet werden, die auf einem dicken Film (11 i) auf dem Substrat (11) gebildet wird;
**dadurch gekennzeichnet, dass** der dicke Film (11 i) auf eine Wiring Layer bzw. Verdrahtungsschicht (11a) gestrichen ist, die auf dem Substrat (11) hergestellt wird.

2. Dreiachsen-Magnetsensor gemäß Anspruch 1, wobei die GMR-Effektelemente eine Vielzahl von GMR-Effektelementstegen besitzen, die parallel angeordnet sind, sowie benachbarte GMR-Effektelementstege, die mittels Vormagnetisierungsfilmen (2121-5 bis 212a-9) in Reihe verbunden sind.

3. Dreiachsen-Magnetsensor gemäß Anspruch 1, wobei die erste geneigte Oberfläche und die zweite geneigte Oberfläche mit Vorsprüngen gebildet sind, die auf dem Substrat so gebildet sind, dass sie sich Rücken an Rücken befinden, oder die erste geneigte Oberfläche und die zweite geneigte Oberfläche mit Nuten gebildet sind, die auf dem Substrat so gebildet sind, so dass sie relativ zueinander weisen.

4. Dreiachsen-Magnetsensor gemäß Anspruch 1, wobei die erste geneigte Oberfläche mit einem ersten Vorsprung oder einer Nut gebildet ist und die zweite geneigte Oberfläche mit einem zweiten Vorsprung oder einer Nut gebildet ist, die sich von dem ersten Vorsprung oder der ersten Nut unterscheidet.

5. Dreiachsen-Magnetsensor gemäß Anspruch 1, wobei jede der Längsrichtungen des GMR-Effektelementsteg, die betroffen ist, übereinstimmend mit entweder der Längsseiten- (X-Achsen-) Richtung des Substrats oder der Querseiten- (Y-Achsen-) Richtung hergestellt wird; und
Die GMR-Effektelemente, die aus den GMR-Effektelementstegen, die auf den ersten und zweiten geneigten Oberflächen gebildet sind, bestehen, so angeordnet sind, dass sie benachbart und zueinander parallel sind.

6. Dreiachsen-Magnetsensor gemäß Anspruch 1, wobei Kanten, die aus Spitzen von Vorsprüngen der ersten und zweiten geneigten Oberflächen bestehen, so gebildet sind, dass sie 45 Grad in Bezug auf die X-Achse oder die Y-Achse des Substrats ergeben.

7. Dreiachsen-Magnetsensor gemäß Anspruch 6, wobei der X-Achsen-Sensor, der Y1-Achsen-Sensor und der Y2-Achsen-Sensor an vier Ecken des Substrats gebildet sind.

8. Dreiachsen-Magnetsensor gemäß Anspruch 1, wobei Kanten, die aus Spitzen von Vorsprüngen der ersten und zweiten geneigten Oberflächen bestehen, so gebildet sind, dass sie parallel zu einer X-Achse oder Y-Achse des Substrats sind.

9. Dreiachsen-Magnetsensor gemäß Anspruch 8, wobei der X-Achsen-Sensor, der Y1-Achsen-Sensor und der Y2-Achsen-Sensor auf vier Seiten des Substrats gebildet sind.

10. Verfahren zur Herstellung eines Dreiachsen-Magnetsensors, der innerhalb eines Substrats (11) einen X-Achsen-Sensor, in dem eine Vielzahl von Riesen-Magnetowiderstandseffektelementen bzw. GMR-Effektelementen über Brücken verbunden sind, einen Y1-Achsen-Sensor, in dem eine Vielzahl von GMR-Effektelementen über Brücken verbunden sind, und einen Y2-Achsen-Sensor, in dem eine Vielzahl von GMR-Effektelementen über Brücken verbunden sind, besitzt, wobei das Verfahren zur Herstellung des Dreiachsen-Magnetsensors die folgenden Schritte aufweist:

Formen auf einer flachen Oberfläche parallel zu einer Oberfläche des Substrats einer Vielzahl von GMR-Effektelementen, die als ein X-Achsen-Sensor wirken, und Formen einer Vielzahl von GMR-Effektelementen auf dem Substrat, die als ein Y1-Achsen-Sensor wirken, sowie einer Vielzahl von GMR-Effektelementen, die als ein Y2-Achsen-Sensor wirken;
Wärmebehandeln zur Regularisation, in der jedes der GMR-Effektelemente, das auf dem Substrat gebildet ist, durch Anlegen von Magnetfeldern darauf erwärmt wird, um die Wärmebehandlung zur Regularisation jedem der GMR-Effektelemente gleichzeitig angedeihen zu lassen;
Formen der GMR-Effektelemente, die als Y1-Achsen-Sensor wirken, auf einer ersten geneigten Oberfläche (215a), die um einen vorbestimmten Winkel in Bezug auf die flache Oberfläche des Substrats geneigt ist, wobei die erste geneigte Oberfläche durch eine Nut gebildet wird, die auf einem dicken Film (11i) auf dem Substrat (11) gebildet ist; und
Formen der GMR-Effektelemente, die als Y2-Achsen-Sensor wirken, auf einer zweiten geneigten Oberfläche (215b), die mit dem gleichen Winkel in Bezug auf die erste, geneigte Oberfläche und in einer Richtung entgegengesetzt zu der ersten geneigten Oberfläche geneigt ist, wobei die zweite geneigte Oberfläche durch die Nut gebildet wird;
**dadurch gekennzeichnet, dass** der dicke Film (11i) auf eine Verdrahtungsschicht (11a) gestrichen ist, die auf dem Substrat (11) hergestellt ist.

11. Verfahren zur Herstellung des Dreiachsen-Magnetsensors gemäß Anspruch 10, wobei in dem Schritt der Wärmebehandlung zur Regelung die Behandlung durch Erwärmen ausgeführt wird, während ein Magnetfeld in der Richtung übermittelt wird, die mit 45 Grad zu der Richtung senkrecht zu den ersten und zweiten geneigten Oberflächen geneigt ist, auf denen magnetoresistive Effektelementstege, die die Vielzahl der magnetoresistiven Effektelemente bilden, die als die Y1-Achsen- und Y2-Achsen-Sensoren wirken, gebildet sind.

12. Verfahren zur Herstellung des Dreiachsen-Magnetsensors gemäß Anspruch 10, wobei:

der X-Achsen-Sensor, der Y1-Achsen-Sensor und der Y2-Achsen-Sensor auf vier Seiten des Substrats gebildet sind; und

die Wärmebehandlung zur Regularisation durch Verwenden der Magnetanordnung (216) ausgeführt wird, bei der Permanentmagnetstücke an einer Mitte des Substrats und Mittelpunkten der vier Seiten des Substrats gelegen sind, wobei benachbarte Magnetstücke der Permanentmagnetanordnung zueinander unterschiedlich in der Polarität sind.

13. Verfahren zur Herstellung des Dreiachsen-Magnetsensors gemäß Anspruch 10, wobei:

der X-Achsen-Sensor, der Y1-Achsen-Sensor und der Y2-Achsen-Sensor auf vier Ecken des Substrats gebildet sind; und

die Wärmebehandlung zur Regularisation durch Verwenden einer Magnetanordnung (216) ausgeführt wird, bei der Permanentmagnetstücke an einer Mitte des Substrats und den vier Ecken des Substrats gelegen sind, wobei benachbarte Magnetstücke der Permanentmagnetanordnung zueinander unterschiedlich in der Polarität sind.

## Revendications

1. Capteur magnétique à trois axes comportant à l'intérieur d'un substrat (11) un capteur d'axe X dans lequel une pluralité d'éléments à effet magnétorésistif géant (212a à 212d) est connectée en pont, un capteur d'axe Y1 dans lequel une pluralité d'éléments à effet magnétorésistif géant (212e à 212h) est connectée en pont et un capteur d'axe Y2 dans lequel une pluralité d'éléments à effet magnétorésistif géant (212i à 2121) est connectée en pont, dans lequel :

l'élément à effet magnétorésistif géant comporte une pluralité de barres d'élément à effet magnétorésistif géant connectées en série ;

les éléments à effet magnétorésistif géant du capteur d'axe X sont formés sur une surface plate parallèle à une surface du substrat, et une couche piégée est formée de telle sorte que la direction d'aimantation et la direction de sensibilité sont verticales par rapport à la direction longitudinale de chacune des barres d'élément à effet magnétorésistif géant ;

le capteur d'axe Y1 est formé sur une première surface inclinée (215a) inclinée avec un angle prédéterminé par rapport à la surface du substrat, et la couche piégée est formée de telle sorte que la direction d'aimantation et la direction de sensibilité sont verticales par rapport à la direction longitudinale de chacune des barres d'élément à effet magnétorésistif géant et aussi dans une direction suivant la première surface inclinée ;

le capteur d'axe Y2 est formé sur une deuxième surface inclinée (215b) qui est inclinée avec le même angle que la première surface inclinée mais dans une direction opposée à la première surface inclinée, et la couche piégée est formée de telle sorte que la direction d'aimantation et la direction de sensibilité sont verticales par rapport à la direction longitudinale de chacune des barres d'élément à effet magnétorésistif géant et aussi dans une direction suivant la deuxième surface inclinée ; et

les première et deuxième surfaces inclinées (215a, 215b) sont des surfaces inclinées formées par une rainure formée sur un film épais (11i) sur le substrat (11) ;

**caractérisé en ce que** le film épais (11i) est déposé sur une couche de câblage (11a) qui est fabriquée sur le substrat (11).

2. Capteur magnétique à trois axes selon la revendication 1, dans lequel les éléments à effet magnétorésistif géant comportent une pluralité de barres d'élément à effet magnétorésistif géant disposées en parallèle et des barres d'élément à effet magnétorésistif géant connectées en série au moyen de films d'aimants de polarisation (2121-5 à 212a-9).

3. Capteur magnétique à trois axes selon la revendication 1, dans lequel la première surface inclinée et la deuxième surface inclinée sont constituées de saillies formées sur le substrat de façon à être dos à dos, ou la première surface inclinée et la deuxième surface inclinée sont constituées de rainures formées sur le substrat de façon à être face à face.

4. Capteur magnétique à trois axes selon la revendication 1, dans lequel la première surface inclinée est constituée d'une première saillie ou d'une rainure et la deuxième surface inclinée est constituée d'une deuxième saillie ou rainure qui est différente de la première saillie ou rainure.

**5.** Capteur magnétique à trois axes selon la revendication 1, dans lequel :

chaque direction longitudinale de la barre d'élément à effet magnétorésistif géant concernée est mise en coïncidence avec soit la direction du grand côté (axe X) du substrat soit celle du petit côté (axe Y) ; et
les éléments à effet magnétorésistif géant constitués par les barres d'élément à effet magnétorésistif géant formées sur les première et deuxième surfaces inclinées sont disposés de façon à être adjacents et parallèles entre eux.

**6.** Capteur magnétique à trois axes selon la revendication 1, dans lequel des arêtes constituées de pics de saillies des première et deuxième surfaces inclinées sont formées de façon à obtenir 45 degrés par rapport à l'axe X ou l'axe Y du substrat.

**7.** Capteur magnétique à trois axes selon la revendication 6, dans lequel le capteur d'axe X, le capteur d'axe Y1 et le capteur d'axe Y2 sont formés sur quatre coins du substrat.

**8.** Capteur magnétique à trois axes selon la revendication 1, dans lequel des arêtes constituées de pics de saillies des première et deuxième surfaces inclinées sont formées de façon à être parallèles à l'axe X ou l'axe Y du substrat.

**9.** Capteur magnétique à trois axes selon la revendication 8, dans lequel le capteur d'axe X, le capteur d'axe Y1 et le capteur d'axe Y2 sont formés sur quatre côtés du substrat.

**10.** Procédé de fabrication d'un capteur magnétique à trois axes comportant à l'intérieur d'un substrat (11) un capteur d'axe X dans lequel une pluralité d'éléments à effet magnétorésistif géant est connectée en pont, un capteur d'axe Y1 dans lequel une pluralité d'éléments à effet magnétorésistif géant est connectée en pont et un capteur d'axe Y2 dans lequel une pluralité d'éléments à effet magnétorésistif géant est connectée en pont, le procédé de fabrication du capteur magnétique à trois axes comprenant les étapes suivantes :

former sur une surface plate parallèle à une surface du substrat une pluralité d'éléments à effet magnétorésistif géant qui vont servir de capteur d'axe X, et former sur le substrat une pluralité d'éléments à effet magnétorésistif géant qui vont servir de capteur d'axe Y1 et une pluralité d'éléments à effet magnétorésistif géant qui vont servir de capteur d'axe Y2 ;
réaliser un traitement thermique de régularisation dans lequel chacun des éléments à effet magnétorésistif géant formés sur le substrat est chauffé en lui appliquant des champs magnétiques pour appliquer en même temps le traitement thermique de régularisation à chacun des éléments à effet magnétorésistif géant ;
former les éléments à effet magnétorésistif géant qui vont servir de capteur d'axe Y1 sur une première surface inclinée (215a) qui est inclinée avec un angle prédéterminé par rapport à la surface plate du substrat, la première surface inclinée étant formée par une rainure qui est formée sur un film épais (11i) sur le substrat (11) ; et
former les éléments à effet magnétorésistif géant qui vont servir de capteur d'axe Y2 sur une deuxième surface inclinée (215b) qui est inclinée avec le même angle par rapport à la première surface inclinée dans une direction opposée à la première surface inclinée, la deuxième surface inclinée étant formée par la rainure ;
**caractérisé en ce que** le film épais (11i) est déposé sur une couche de câblage (11a) qui est fabriquée sur le substrat (11).

**11.** Procédé de fabrication du capteur magnétique à trois axes selon la revendication 10, dans lequel, dans l'étape de traitement thermique de régularisation, le traitement est réalisé en chauffant pendant qu'un champ magnétique est appliqué à la direction inclinée de 45 degrés par rapport à une direction verticale aux première et deuxième surfaces inclinées sur lesquelles sont formées des barres d'élément à effet magnétorésistif constituant la pluralité d'éléments à effet magnétorésistif qui vont servir de capteurs d'axe Y1 et d'axe Y2.

**12.** Procédé de fabrication du capteur magnétique à trois axes selon la revendication 10, dans lequel :

le capteur d'axe X, le capteur d'axe Y1 et le capteur d'axe Y2 sont formés sur quatre côtés du substrat ; et
le traitement thermique de régulation est réalisé en utilisant un réseau d'aimants (216) comportant des morceaux d'aimants permanents situés au centre du substrat et aux centres des quatre côtés du substrat, des morceaux d'aimants adjacents du réseau d'aimants permanents étant de polarités mutuellement différentes.

**13.** Procédé de fabrication du capteur magnétique à trois axes selon la revendication 10, dans lequel :

le capteur d'axe X, le capteur d'axe Y1 et le capteur d'axe Y2 sont formés sur quatre côtés du substrat ; et
le traitement thermique de régulation est réalisé en utilisant un réseau d'aimants (216) comportant des morceaux d'aimants permanents situés au centre du substrat et aux quatre coins du substrat, des morceaux d'aimants adjacents du réseau d'aimants permanents étant de polarités mutuellement différentes.

# FIG. 1A

# FIG. 1B

## FIG. 2A

SENSITIVITY DIRECTION

X-AXIS DIRECTION (PINNING DIRECTION)

21

21a

21b

21c

21d

21e

21f

21g

21h

21i

A - - - - A

## FIG. 2B

21b

SV

P

21g

F

21f

## FIG. 2C

| | | | |
|---|---|---|---|
| CAPPING LAYER C { | | Ti | 21b−7 |
| | PIN LAYER P { | PtMn | 21b−6 |
| SV { | | CoFe | 21b−5 |
| | SPACER LAYER S { | Cu | 21b−4 |
| | FREE LAYER F { | CoFe | 21b−3 |
| | | NiFe | 21b−2 |
| | | CoZrNb | 21b−1 |
| SUBSTRATE { | | QUARTZ SUBSTRATE | 11 |

## FIG. 3A

## FIG. 3B

## FIG. 3C

FIG. 4A

FIG. 4B

## FIG. 4C

## FIG. 5A

## FIG. 5B

## FIG. 5C

## FIG. 6A

## FIG. 6B

## FIG. 6C

FIG. 7A        FIG. 7B        FIG. 7C

11f  11e        11f  11e        11f  11e

11b  11a  11    11b  11a  11    11b  11


FIG. 8A        FIG. 8B        FIG. 8C

11f  11g  11e    11f  11h  11e    11f  11e

11b  11a  11    11b  11a  11    11b  11


FIG. 9A        FIG. 9B        FIG. 9C

11f  11i  11e    11f  11i  11e    11f  11i  11e

11b  11a  11    11b  11a  11    11b  11


FIG. 10A       FIG. 10B       FIG. 10C

11f  11i  11e  11j    11f  11i  11e  11j    11f  11i  11e  11j

11b  11a  11    11b  11a  11    11b  11

FIG. 11A

FIG. 11B

FIG. 11C

FIG. 12A

FIG. 12B

FIG. 12C

FIG. 13A

FIG. 13B

FIG. 13C

FIG. 14A

FIG. 14B

FIG. 14C

## FIG. 15A

# FIG. 15B

# FIG. 15C

FIG. 16A

50a

51

51f 51e

51i ║║ 51j

51c
51d

51a
51b

51k ║║ 51l

51h 51g

y
z → x

FIG. 16B

50b

52

52f 52e

52k ║║ 52l

52c
52d

52a
52b

52i ║║ 52j

52h 52g

y
z → x

FIG. 16C

50c

53

53f 53e

53k ║║ 53l

53c
53d

53a
53b

53i ║║ 53j

53h 53g

y
z → x

FIG. 16D

50d

54

54f 54e

54h 54g

54i ║║ 54j

54c
54d

54a
54b

54k ║║ 54l

y
z → x

## FIG. 17A

## FIG. 17B

# FIG. 18A

# FIG. 18B

# FIG. 18C

## FIG. 19A

## FIG. 19B

FIG. 19C

# FIG. 20A

FIG. 20B

61i(61J)

61

FIG. 20C

61k(61l)

61

## FIG. 21A

## FIG. 21B

## FIG. 22A

## FIG. 22B

FIG. 23A

72e

72a

71c    71a

72c    Vout

72d

71b    71d

72b

FIG. 23B

73e

73a

71g    71e

73c    Vout

73d

71f    71h

73b

FIG. 23C

## FIG. 24A

## FIG. 24B

# FIG. 25

## FIG. 26A

## FIG. 26B

## FIG. 27A

PINNING DIRECTION
SENSITIVITY DIRECTION
112a
112a—1
112a—5
112a—6
112a—2
B—
—B'
112a—3
112a—7
112a—8
112a—4
112a—9

## FIG. 27B

112a—2
P
SV {
112a-7
F
112a-6

## FIG. 27C

| | | |
|---|---|---|
| CAPPING LAYER C { | Ti | 112a-27 |
| PIN LAYER P { | PtMn | 112a-26 |
| | CoFe | 112a-25 |
| SPACER LAYER S { | Cu | 112a-24 |
| FREE LAYER F { | CoFe | 112a-23 |
| | NiFe | 112a-22 |
| | CoZrNb | 112a-21 |
| SUBSTRATE { | QUARTZ SUBSTRATE | 11 |

SV

FIG. 28A

FIG. 28B

FIG. 28C

FIG. 29A

FIG. 29B

# FIG. 29C

# FIG. 30A

FIG. 30B

# FIG. 31A

120

121

122f 122e E`

122i

122j E'

122k

122l 122a

122c

122d

122b

y

z ⊙ ——→ x

122h 122g

# FIG. 31B

122i                    122j

(E)                                                                (E')

125  122i–3        122j–1  122j–3            121
122i–1  122i–2  122i–4    122j–2    122j–4

FIG. 32A

FIG. 32B

FIG. 32C

FIG. 33A

FIG. 33B

# FIG. 33C

# FIG. 34A

FIG. 34B

# FIG. 35A

210

11    A

212e   212f

212k   212l

212c      212a

212d      212b

y

212g    212h

212i     212j

z   x

# FIG. 35B

212e-1    215b    215a

$\theta$   $\theta$

(A)                                      (A')

212k-1   215   212k-2   212k-3   212k-4      11

212e-2   212e-3   212e-4

## FIG. 36A

PINNING SENSITIVITY
DIRECTION DIRECTION

212a-1
212a
212a-5
212a-6
212a-2
B-
-B'
212a-7
212a-3
212a-8
212a-4
212a-9

## FIG. 36B

212a-2
P
SV
212a-7
F
212a-6

## FIG. 36C

| CAPPING LAYER C | Ti | 212a-27 |
| PIN LAYER P | PtMn | 212a-26 |
| | CoFe | 212a-25 |
| SPACER LAYER S | Cu | 212a-24 |
| FREE LAYER F | CoFe | 212a-23 |
| | NiFe | 212a-22 |
| | CoZrNb | 212a-21 |
| SUBSTRATE | QUARTZ SUBSTRATE | 11 |

SV

## FIG. 37A

## FIG. 37B

## FIG. 38A

## FIG. 38B

FIG. 38C

FIG. 39A

FIG. 39B

FIG. 39C

FIG. 40

FIG. 41

217

217a

217a

217a

217a

217a

217a

217a

217a

217a

FIG. 42

# FIG. 43

# FIG. 44

# FIG. 45

# FIG. 46

## FIG. 47A

252e-1  252e-2  252e-3  252e-4

(H)

251
(H')

255

## FIG. 47B

252e-6  252e-2  252e-8

252e-1

252e-4

252e-5

252e-9

252e-7  252e-3

## FIG. 47C

252k-1  252k-2  252k-3  252k-4

(H)

251
(H')

256

## FIG. 47D

252k-7  252k-3

252k-5

252k-9

252k-1

252k-4

252k-6  252k-2  252k-8

## FIG. 48

## FIG. 49

FIG. 50

FIG. 51

FIG. 52

FIG. 53

FIG. 54

## FIG. 55

## FIG. 56

FIG. 57

FIG. 58

EP 1 860 451 B1

## FIG. 59

## FIG. 60

FIG. 61

EP 1 860 451 B1

## FIG. 62

373　372　372　373

S　　　N

N　　　S

~363　　~363

## FIG. 63A

a　b

g　e　k　i

X-AXIS

h　f　l　j

c　d

Y-AXIS

A CHIP　　B CHIP

## FIG. 63B

Z-AXIS

y1-AXIS　　y2-AXIS

θ　θ

Y-AXIS

A CHIP　　B CHIP

# FIG. 64A          FIG. 64B          FIG. 64C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3498737 B
- JP 2002299728 A
- JP 2004006752 A